# EUROPÄISCHE PATENTSCHRIFT

(11) **EP 3 478 698 B1**
(45) Veröffentlichungstag und Bekanntmachung des Hinweises auf die Patenterteilung: **13.01.2021**
(21) Anmeldenummer: 17735063.4
(22) Anmeldetag: 27.06.2017
(51) Int. Cl.: C07F 15/00, C07B 57/00, C09B 57/00, C09B 57/10, H01L 51/00, H01L 51/10, H01L 51/50

(54) **VERFAHREN ZUR AUFTRENNUNG VON ENANTIOMERENMISCHUNGEN VON METALLKOMPLEXEN**
METHOD FOR THE SEPARATION OF ENANTIOMERIC MIXTURES FROM METAL COMPLEXES
PROCÉDÉ POUR SÉPARER DES MÉLANGES D'ÉNANTIOMÈRES DE COMPLEXES MÉTALLIQUES

(30) Priorität: 30.06.2016 EP 16177095
(43) Veröffentlichungstag der Anmeldung: 08.05.2019
(73) Patentinhaber: Merck Patent GmbH, 64293 Darmstadt (DE)
(72) Erfinder: STOESSEL, Philipp, 60389 Frankfurt Am Main (DE); EHRENREICH, Christian, 64285 Darmstadt (DE)
(86) Internationale Anmeldenummer: PCT/EP2017/065763
(87) Internationale Veröffentlichungsnummer: WO 2018/001990

(56) Entgegenhaltungen:
- WO-A1-03/048175
- WO-A1-2016/015815
- WO-A2-2014/023377

## Beschreibung

Die vorliegende Erfindung betrifft Verfahren zur Auftrennung von Mischungen, die Enantiomere von Metallkomplexen mit aromatischen und/oder heteroaromatischen Ligenden enthalten. Ferner beschreibt die vorliegende Erfindung Metallkomplexe, die nach einem erfindungsgemäßen Verfahren erhältlich sind, sowie deren Verwendung.

Die Verwendung von enantiomerenreinen Verbindungen in elektronischen Vorrichtungen ist mit Vorteilen verbunden. In Chemistry - A European Journal (2012), 18(28), 8765-73 wird beispielsweise dargestellt, dass enantiomerenreine Triplettemitter insbesondere in Sensoren Verwendung finden können. Ferner wird deren Anwendung zur Detektion von Nukleinsäuren oder Proteinen diskutiert (vgl. European Journal of Inorganic Chemistry (2013), 4164-4172.

Die Herstellung von enantiomerenreinen Verbindungen ist sehr aufwändig und mit hohen Kosten verbunden. Gemäß dem Stand der Technik werden enantiomerenreine Iridiumkomplexe insbesondere durch die Verwendung von enantiomerenreinen Liganden erhalten, so dass mit den Δ- und Λ-Isomeren ein Diastereomerengemisch gebildet wird, welches über eine übliche Säule getrennt werden kann. Nachteilig ist jedoch, dass die Herstellung von enantiomerenreinen Liganden sehr teuer ist, wobei nicht alle interessanten Liganden ein Chiralitätszentrum aufweisen. Zwar können die Liganden, welche ein Chiralitätszentrum aufweisen, gegen andere Liganden ausgetauscht werden. Allerdings gelingt dies nicht zuverlässig mit sterisch anspruchsvollen Liganden.

Ferner können enantiomerenreine Δ- und/oder Λ-Isomere aus den racemischen Mischungen durch die Verwendung von chiralen Chromatographiesäulen gewonnen werden. Diese Methode ist aufgrund der Kosten für diese Säulen ebenfalls sehr teuer.

Darüber hinaus zeigen bekannte Komplexe vielfach sehr hohe Sublimationstemperaturen oder geringe Löslichkeiten, so dass diese Komplexe nur sehr schwer verarbeitet werden können.

Weiterhin sind auch bei den Komplexen noch Verbesserungen in Bezug auf die Eigenschaften bei Verwendung in einer organischen Elektrolumineszenzvorrichtung, insbesondere in Bezug auf Effizienz, Spannung und/oder Lebensdauer, wünschenswert.

Aufgabe der vorliegenden Erfindung ist daher die Bereitstellung neuer Verfahren zur Auftrennung von Mischungen, die Enantiomere von Metallkomplexen mit aromatischen und/oder heteroaromatischen Liganden enthalten, das mit hoher Ausbeute und niedrigen Kosten durchgeführt werden kann. Weiterhin ist es Aufgabe der vorliegenden Erfindung, ein Verfahren zur Herstellung von optisch aktiven Metallkomplexen bereitzustellen, welche sich als Emitter für die Verwendung in OLEDs eignen. Insbesondere sollte die Enantiomerenreinheit den Bedürfnissen entsprechend einstellbar sein. Ferner soll ein Verfahren zur Herstellung und zur Auftrennung optisch aktiver Metallkomplexe zur Verfügung gestellt werden, das bei milderen Synthesebedingungen, insbesondere in Bezug auf Reaktionsdauer und Reaktionstemperatur, durchgeführt werden kann, jeweils verglichen mit Komplexen, die strukturell vergleichbare Liganden aufweisen. Weiterhin ist es die Aufgabe der vorliegenden Erfindung, Metallkomplexe bereitzustellen, die keine facial-meridional-Isomerisierung zeigen, was bei Komplexen gemäß dem Stand der Technik ein Problem darstellen kann. Darüberhinaus ist die Bereitstellung von Emittern, die besonders einfach und schonend verarbeitet und insbesondere bei vergleichsweise niedrigen Temperaturen sublimiert oder in hohen Konzentrationen gelöst werden können, eine Aufgabe der vorliegenden Erfindung. Weiterhin ist die Aufgabe, Emitter bereitzustellen, welche verbesserte Eigenschaften in Bezug auf Effizienz, Betriebsspannung und/oder Lebensdauer zeigen.

Aus WO 2014/023377 sind Oligomere, Polymere und Dendrimere enthaltend Metallkomplexe bekannt. Es sind jedoch keine Metallkomplexe mit borhaltigen Substituenten mit Chiralitätszentrum offenbart.

Aus WO 2016/015815 sind Iridiumkomplexe mit Phenylpyridinliganden mit Heteroaryl-Substiutenten bekannt, welche aus dem halogenierten Iridiumkomplex durch Borylierung und Suzuki-Kupplung erhalten werden, wobei die Komplexe auch als enantiomerenreine Komplexe eingesetzt werden. Eine Umsetzung mit einer optisch aktiven Borverbindung ist nicht offenbart.

Überraschend wurde gefunden, dass Verfahren zur Auftrennung von Mischungen, die Enantiomere von Metallkomplexen mit aromatischen und/oder heteroaromatischen Ligenden enthalten, mit den nachfolgend beschriebenen Merkmalen, diese Aufgabe lösen, wobei sich die erhältlichen Metallkomplexe sehr gut für die Verwendung in elektronischen Vorrichtungen, insbesondere in organischen Elektrolumineszenzvorrichtungen eignen. Diese Verfahren, sowie die hierdurch erhältlichen Metallkomplexe und elektronische Vorrichtungen, welche diese Komplexe enthalten, sind daher der Gegenstand der vorliegenden Erfindung.

Gegenstand der Erfindung ist somit ein Verfahren zur Auftrennung von Mischungen, die Enantiomere von Metallkomplexen mit aromatischen und/oder heteroaromatischen Liganden enthalten, umfassend die Schritte:
A) Bereitstellen einer Mischung von reaktiven Metallkomplexen, wobei die Mischung mindestens zwei Enantiomere des reaktiven Metallkomplexes umfasst;
B) Umsetzung der gemäß Schritt A) bereitgestellten Mischung mit einer optisch aktiven Borverbindung unter Erhalt einer Diastereomeren-Mischung, wobei die optisch aktive Borverbindung eine Borverbindung gemäß Formel (BE-1) ist, 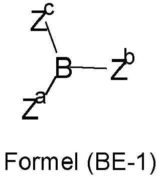 wobei die Symbole die folgende Bedeutung aufweisen:
   - Z^{a}: ist ausgewählt aus H, D, OR, Halogen, B(R)₂;
   - Z^{b}, Z^{c}: ist bei jedem Auftreten gleich oder verschieden OR, N(R)₂, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, wobei die Alkyl-, Alkoxy-, Thioalkoxy-, Alkenyl- oder Alkinylgruppe jeweils mit einem oder mehreren Resten R substituiert sein kann, wobei eine oder mehrere nicht benachbarte CH₂-Gruppen durch RC=CR, C≡C, Si(R)₂, C=O, NR, O, S oder CONR ersetzt sein können, dabei können die Reste R auch miteinander ein Ringsystem bilden;
   wobei mindestens einer der Reste Z^{b}, Z^{c} ein Chiralitätszentrum umfasst;
   - R: ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, C(=O)OR¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann; dabei können zwei Reste R auch miteinander ein Ringsystem bilden;

   - R¹: ist bei jedem Auftreten gleich oder verschieden H, D, F, Cl, Br, I, N(R²)₂, CN, NO₂, Si(R²)₃, B(OR²)₂, C(=O)R², C(=O)OR², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aroma-tisches oder heteroaromatisches Ringsystem mit 5 bis 40 aroma-tischen Ringatomen, das jeweils durch einen oder mehrere Reste R² substituiert sein kann, oder eine Aryloxy- oder Heteroaryloxy-gruppe mit 5 bis 40 aromatischen Ringatomen, die durch einen oder mehrere Reste R² substituiert sein kann, oder eine Aralkyl-oder Heteroaralkylgruppe mit 5 bis 40 aromatischen Ringatomen, die durch einen oder mehrere Reste R² substituiert sein kann, oder eine Diarylaminogruppe, Diheteroarylaminogruppe oder Aryl-heteroarylaminogruppe mit 10 bis 40 aromatischen Ringatomen, welche durch einen oder mehrere Reste R² substituiert sein kann; dabei können zwei oder mehrere Reste R¹ miteinander ein Ring-system bilden;
   - R²: ist bei jedem Auftreten gleich oder verschieden H, D, F oder ein aliphatischer, aromatischer und/oder heteroaromatischer orga-nischer Rest, insbesondere ein Kohlenwasserstoffrest, mit 1 bis 20 C-Atomen, in dem auch ein oder mehrere H-Atome durch F ersetzt sein können, dabei können zwei oder mehrere Substitu-enten R² auch miteinander ein mono- oder polycyclisches Ring-system bilden;
   und
C) Auftrennung der gemäß Schritt B) erhaltenen Diastereomeren-Mischung;
   wobei eine Mischung von Metallkomplexen eingesetzt wird, deren reaktive Metallkomplexe der allgemeinen Formel (1) entsprechen, und wobei die Metallkomplexe eine funktionelle Gruppe enthalten, welche ausgewählt ist aus der Gruppe bestehend aus Halogenen, Triflat, Mesylat und Tosylat,

   Ir(L)ₙ(L')ₘ Formel (1)

   wobei für die verwendeten Symbole und Indizes gilt:
   - L: ist gleich oder verschieden bei jedem Auftreten ein bidentaler Ligand
   - L': ist gleich oder verschieden bei jedem Auftreten ein Ligand;
   - n: ist 1, 2 oder 3, vorzugsweise 2 oder 3, besonders bevorzugt 3;
   - m: ist 0, 1, 2, 3 oder 4, vorzugsweise 0, 1 oder 2, besonders bevorzugt 0;
   dabei können auch mehrere Liganden L miteinander oder L mit L' über eine Einfachbindung oder eine bivalente oder trivalente Brücke verknüpft sein und so ein tridentates, tetradentates, pentadentates oder hexadentates Ligandensystem aufspannen.

In Schritt A) wird eine Mischung von reaktiven Metallkomplexen bereitgestellt, wobei die Mischung mindestens zwei Enantiomere der Komplexe umfasst. Dabei bedeutet "reaktiv", dass der Komplex mindestens eine funktionelle Gruppe aufweist, die in der Lage ist, in Schritt B) mit der optisch aktiven Borverbindung zu reagieren, und ausgewählt ist aus der Gruppe bestehend aus Halogenen, insbesondere Cl, Br, I, Triflat, Mesylat oder Tosylat, besonders bevorzugt Cl, Br oder I, insbesondere Br.

In einer bevorzugten Ausgestaltung des Verfahrens kann vorgesehen sein, dass die beiden Enantiomere genau eines Metallkomplexes getrennt werden.

Die Reinheit der eingesetzten Metallkomplexe kann in einem weiten Bereich liegen, so dass grundsätzlich jede Mischung mit den genannten Merkmalen eingesetzt werden kann und die Mischung weitere Komponenten enthalten kann, beispielsweise Metallkomplexe, die sich von den Enantiomeren unterscheiden, die durch das Verfahren aufgetrennt werden sollten. Ferner kann die Mischung Liganden enthalten, die kein Metallatom komplexieren. In einer vorteilhaften Ausgestaltung der vorliegenden Erfindung wird jedoch eine relativ reine Metallkomplexmischung eingesetzt, so dass die in Schritt A) eingesetzte Mischung von reaktiven Metallkomplexen mindestens 80 Gew.-%, vorzugsweise mindestens 90 Gew.-%, besonders bevorzugt mindestens 95 Gew.-% und speziell bevorzugt mindestens 99 Gew.-% an Metallkomplex zweier Enantiomere aufweist, jeweils bezogen auf das Gewicht an Metallkomplex. Der Anteil an freien Liganden ist vorzugsweise auf höchstens 50 Gew.-%, besonders bevorzugt höchstens 40 Gew.-%, insbesondere bevorzugt höchstens 20 Gew.-%, speziell bevorzugt höchstens 10 Gew.-% und ganz besonders bevorzugt höchstens 5 Gew.-% begrenzt, bezogen auf das Gewicht an Metallkomplex. In einer bevorzugten Ausführungsform besteht die in Schritt A) eingesetzte Mischung von reaktiven Metallkomplexen vorzugsweise im Wesentlichen aus einem Racemat des aufzutrennenden Metallkomplexes, bezogen auf die reaktiven, ligandhaltigen Komponenten. Reaktive, ligandhaltige Komponenten sind Bestandteile, die bei den Reaktionsbedingen mit der eingesetzten Borverbindung reagieren können, so dass weder die eingesetzten Borverbindungen noch unter Umständen verwendete Katalysatoren hiervon umfasst sind.

In einer bevorzugten Ausführungsform wird ein monometallischer Metallkomplex eingesetzt. Monometallisch im Sinne der vorliegenden Erfindung bedeutet, dass der Metallkomplex nur ein einziges Metallatom enthält.

Die Bindung des Liganden an das Metall kann sowohl eine Koordinationsbindung als auch eine kovalente Bindung sein bzw. der kovalente Anteil an der Bindung kann je nach Ligand und Metall variieren. Wenn in der vorliegenden Anmeldung die Rede davon ist, dass der Ligand bzw. der Teilligand an das Metall koordiniert oder bindet, so bezeichnet dies im Sinne der vorliegenden Anmeldung jede Art der Bindung von dem Liganden bzw. Teilliganden an das Metall, unabhängig vom kovalenten Anteil der Bindung.

Bevorzugt sind die erfindungsgemäß einzusetzen Metallkomplexe und die erhältlichen Metallkomplexe dadurch gekennzeichnet, dass diese nicht geladen, d. h. elektrisch neutral, sind. Dies wird auf einfache Weise dadurch erreicht, dass die Ladungen der Liganden so gewählt werden, dass sie die Ladung des komplexierten Metallatoms kompensieren.

Es kann vorgesehen sein, dass der reaktive Metallkomplex drei bidentate Liganden aufweist, wobei alle drei Liganden gleich gewählt sind oder zwei der bidentaten Liganden gleich gewählt sind und der dritte bidentate Ligand unterschiedlich von den ersten beiden bidentaten Liganden ist.

In einer weiteren Ausgestaltung kann vorgesehen sein, dass der reaktive Metallkomplex einen, zwei oder drei bidentate Liganden aufweist, wobei die bidentaten Liganden gleich oder verschieden bei jedem Auftreten ein Kohlenstoffatom und ein Stickstoffatom oder zwei Kohlenstoffatome oder zwei Stickstoffatome oder zwei Sauerstoffatome oder ein Sauerstoffatom und ein Stickstoffatom als koordinierende Atome aufweisen.

Darüber hinaus kann vorgesehen sein, dass der Metallkomplex drei bidentate Liganden aufweist, wobei zwei der bidentaten Liganden an das Iridium über jeweils ein Kohlenstoffatom und ein Stickstoffatom oder über zwei Kohlenstoffatome koordinieren und der dritte der bidentaten Liganden an das Iridium über ein Kohlenstoffatom und ein Stickstoffatom oder über zwei Kohlenstoffatome oder über zwei Stickstoffatome oder über ein Stickstoffatom und ein Sauerstoffatom oder über zwei Sauerstoffatome koordiniert, besonders bevorzugt wird das Iridium über ein Kohlenstoffatom und ein Stickstoffatom koordiniert.

Es ist weiterhin bevorzugt, wenn es sich bei dem Metallacyclus, der aus dem Metall und dem bidentaten Liganden aufgespannt wird, um einen Fünfring, der vor allem dann bevorzugt ist, wenn die koordinierenden Atome C und N, C und C, N und N oder N und O sind. Wenn es sich bei den koordinierenden Atomen um O handelt, kann auch ein Metallasechsring bevorzugt sein. Dies wird im Folgenden schematisch dargestellt: 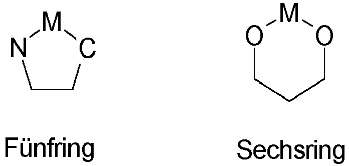 wobei M Ir, N ein koordinierendes Stickstoffatom, C ein koordinierendes Kohlenstoffatom und O koordinierende Sauerstoffatome darstellen und die eingezeichneten Kohlenstoffatome Atome des bidentaten Liganden darstellen.

In einer bevorzugten Ausführungsform der Erfindung ist jeder der bidentaten Liganden gleich oder verschieden entweder monoanionisch oder neutral. Besonders bevorzugt ist jeder der bidentaten Liganden monoanionisch.

In einer besonders bevorzugten Ausführungsform der Erfindung ist das Metall Ir(III) und zwei bidentate Liganden koordinieren an das Iridium über jeweils ein Kohlenstoffatom und ein Stickstoffatom oder über zwei Kohlenstoffatome und ein dritter bidentate Liganden koordiniert an das Iridium über ein Kohlenstoffatom und ein Stickstoffatom oder über zwei Kohlenstoffatome oder über zwei Stickstoffatome oder über ein Stickstoffatom und ein Sauerstoffatom oder über zwei Sauerstoffatome, insbesondere über ein Kohlenstoffatom und ein Stickstoffatom. Besonders bevorzugt handelt es sich somit um einen Iridiumkomplex, in dem alle drei bidentaten Liganden ortho-metalliert sind, d. h. mit dem Iridium einen Metallacyclus bilden, in dem mindestens eine Metall-Kohlenstoff-Bindung vorliegt.

Dabei bedeutet "reaktiver Metallkomplex" wie oben beschrieben, dass der Komplex mindestens eine funktionelle Gruppe aufweist, die in der Lage ist, mit der optisch aktiven Borverbindung zu reagieren.

In einer bevorzugten Ausführungsform der Erfindung enthalten die reaktiven Metallkomplexe der allgemeinen Formel (1) eine Teilstruktur M(L)ₙ der Formel (2): 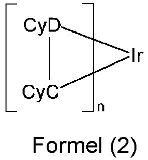 wobei R die oben genannten Bedeutungen aufweist und für die weiteren verwendeten Symbole und Indizes gilt:
- CyC: ist bei jedem Auftreten gleich oder verschieden eine Aryl- oder Heteroarylgruppe mit 5 bis 18 aromatischen Ringatomen oder eine Fluoren- bzw. Azafluorengruppe, welche jeweils über ein Kohlenstoff-atom an Ir koordiniert und welche jeweils mit einem oder mehreren Resten R substituiert sein kann und welche jeweils über eine kovalente Bindung mit CyD verbunden ist;
- CyD: ist bei jedem Auftreten gleich oder verschieden eine Heteroaryl-gruppe mit 5 bis 18 aromatischen Ringatomen, welche über ein neutrales Stickstoffatom oder über ein Carben-Kohlenstoffatom an Ir koordiniert und welche mit einem oder mehreren Resten R substituiert sein kann und welche über eine kovalente Bindung mit CyC ver-bunden ist;
- n: ist 1, 2 oder 3, vorzugsweise 2, besonders bevorzugt 3;
dabei können auch mehrere Liganden L miteinander über eine Einfachbindung oder eine bivalente oder trivalente Brücke verknüpft sein und so ein tridentates, tetradentates, pentadentates oder hexadentates Ligandensystem aufspannen;
dabei kann auch ein Substituent zusätzlich an Ir koordinieren.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können diese Reste, die miteinander ein Ringsystem bilden, benachbart sein, d.h. dass diese Reste an dasselbe Kohlenstoffatom oder an Kohlenstoffatome, die direkt aneinander gebunden sind, gebunden sind, oder sie können weiter voneinander entfernt sein.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

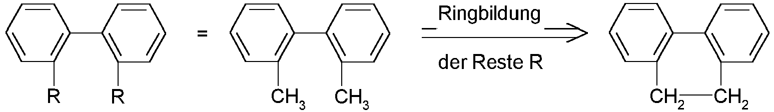

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

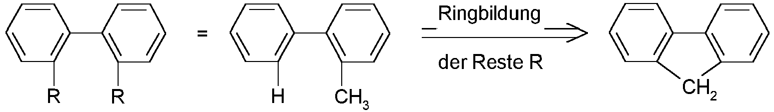

Wie oben beschrieben, kann diese Ringbildung an Resten erfolgen, die an direkt aneinander gebundene Kohlenstoffatome gebunden sind, oder an Resten, die an weiter entfernt liegende Kohlenstoffatome gebunden sind. Bevorzugt ist eine solche Ringbildung aber bei Resten, die an direkt aneinander gebundene Kohlenstoffatome gebunden sind.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD in Formel (2) miteinander einen Ring bilden, wodurch CyC und CyD auch zusammen eine einzige kondensierte Aryl- bzw. Heteroarylgruppe als bidentaten Liganden bilden können.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, welche über ein Kohlenstoffatom an das Metall koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-19), wobei die Gruppe CyC jeweils an der durch # gekennzeichneten Position an CyD bindet und an der durch * gekennzeichneten Position an das Metall koordiniert, 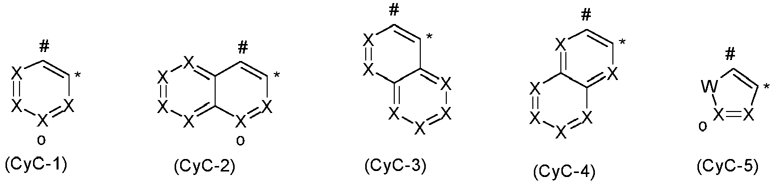 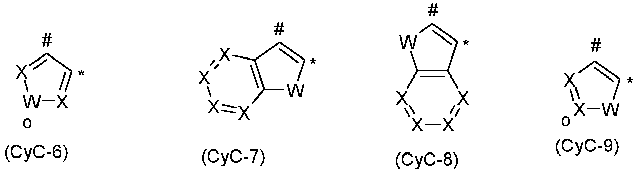 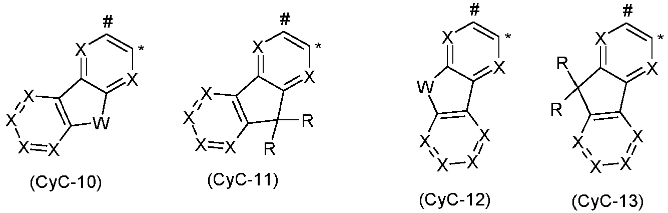 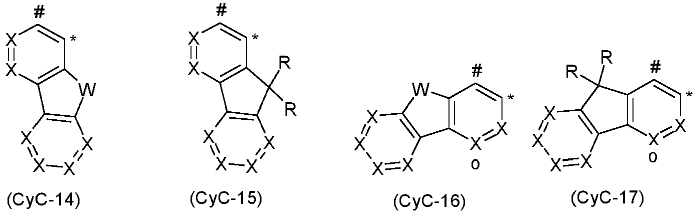 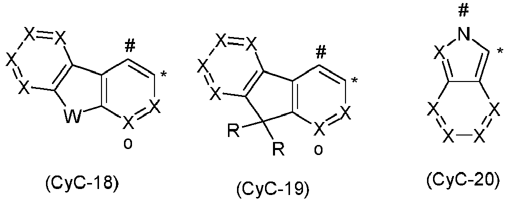 wobei R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist bei jedem Auftreten gleich oder verschieden NR, O oder S;
wobei die Liganden optional durch eine Brücke verbunden sein können, wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt.

Wenn die Gruppe CyC an eine Brücke gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an eine Brücke gebunden, da eine solche Bindung an die Brücke aus sterischen Gründen nicht vorteilhaft ist.

Bevorzugt stehen insgesamt maximal zwei Symbole X in CyC für N, besonders bevorzugt steht maximal ein Symbol X in CyC für N, ganz besonders bevorzugt stehen alle Symbole X für CR, mit der Maßgabe, dass, wenn CyC an eine Brücke gebunden ist, ein Symbol X für C steht und die Brücke an dieses Kohlenstoffatom gebunden ist.

Besonders bevorzugte Gruppen CyC sind die Gruppen der folgenden Formeln (CyC-1a) bis (CyC-20a), 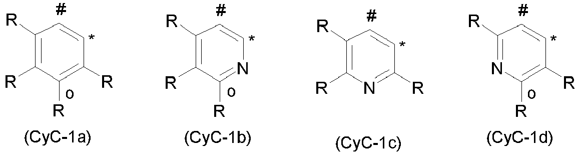 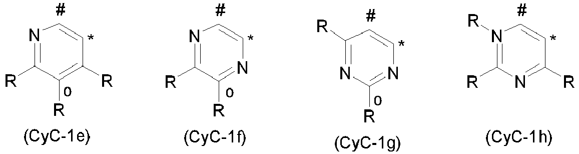 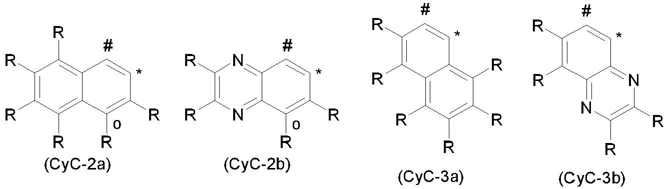 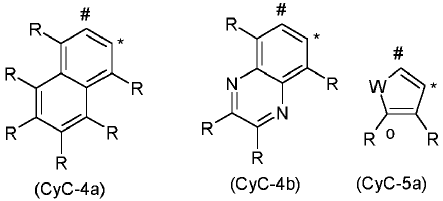 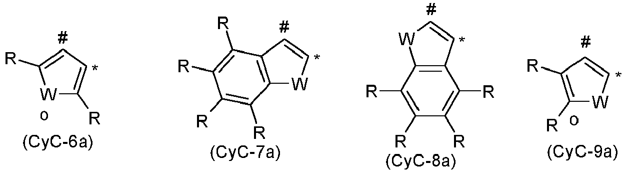 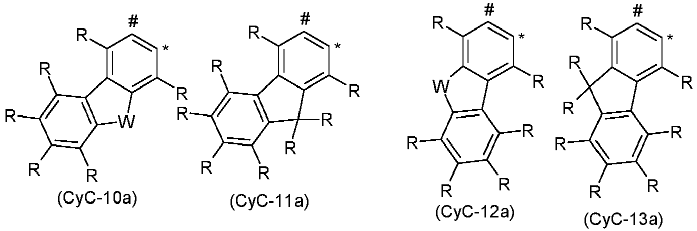 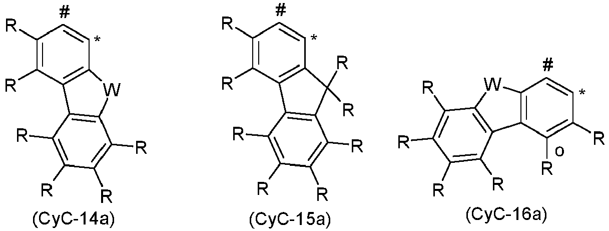 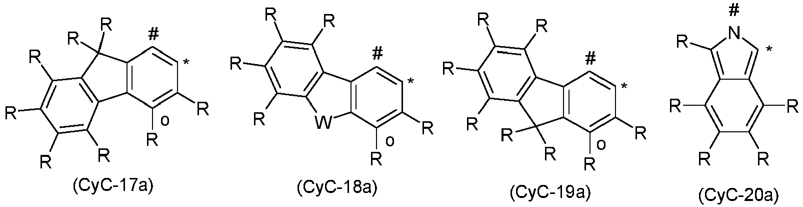 wobei die verwendeten Symbole die oben genannten Bedeutungen aufweisen. Hierbei können die Liganden optional durch eine Brücke verbunden sein, wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt. Die oben abgebildeten Strukturen, die kein mit "o" markiertes Kohlenstoffatom enthalten, sind bevorzugt nicht direkt an eine Brücke gebunden.

Bevorzugte Gruppen unter den Gruppen (CyC-1) bis (CyC-19) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-14), wobei die Gruppe CyD jeweils an der durch # gekennzeichneten Position an CyC bindet und an der durch * gekennzeichneten Position an das Metall koordiniert, 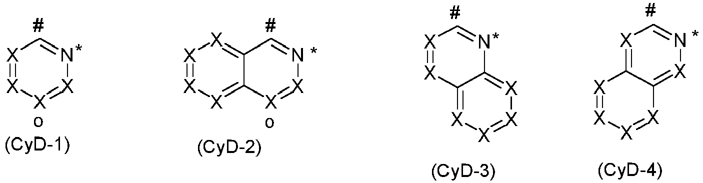 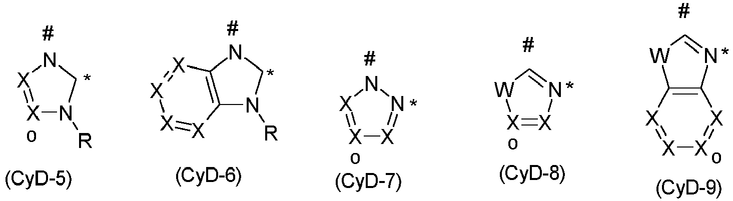 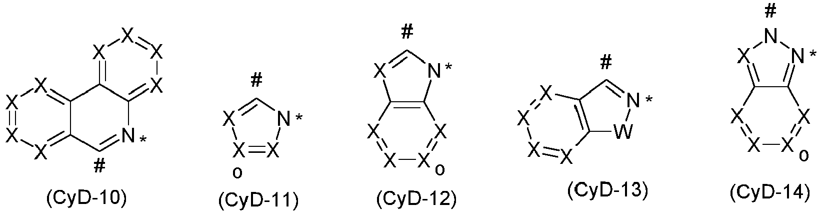 wobei X, W und R die oben genannten Bedeutungen aufweisen und die Liganden optional durch eine Brücke verbunden sein können, wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt. Die oben abgebildeten Strukturen, die kein mit "o" markiertes Symbol X enthalten, sind bevorzugt nicht direkt an eine Brücke gebunden, da eine solche Bindung an die Brücke aus sterischen Gründen nicht vorteilhaft ist.

Dabei koordinieren die Gruppen (CyD-1) bis (CyD-4), (CyD-7) bis (CyD-10), (CyD-13) und (CyD-14) über ein neutrales Stickstoffatom, (CyD-5) und (CyD-6) über ein Carben-Kohlenstoffatom und (CyD-11) und (CyD-12) über ein anionisches Stickstoffatom an das Metall.

Bevorzugt stehen insgesamt maximal zwei Symbole X in CyD für N, besonders bevorzugt steht maximal ein Symbol X in CyD für N, insbesondere bevorzugt stehen alle Symbole X für CR, mit der Maßgabe, dass, wenn eine Brücke an CyD gebunden ist, ein Symbol X für C steht und die Brücke an dieses Kohlenstoffatom gebunden ist.

Besonders bevorzugte Gruppen CyD sind die Gruppen der folgenden Formeln (CyD-1a) bis (CyD-14b), 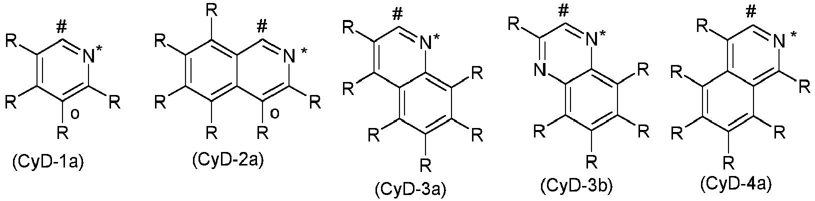 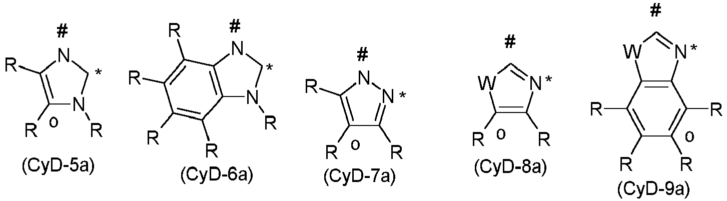 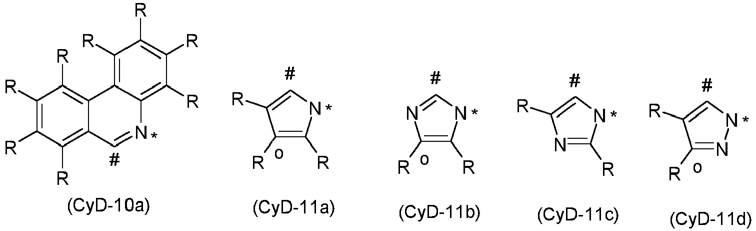 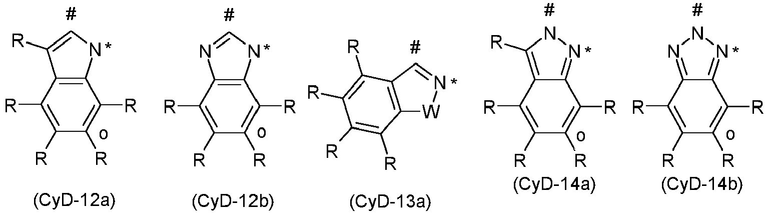 wobei die verwendeten Symbole die oben genannten Bedeutungen aufweisen und die Liganden optional durch eine Brücke verbunden sein können, wobei die Bindung an die Brücke bevorzugt über die mit "o" markierte Position erfolgen kann, wobei die mit "o" markierte Position ein Kohlenstoffatom darstellt, falls diese eine Brückenbindungsstelle darstellt. Die oben abgebildeten Strukturen, die kein mit "o" markiertes Kohlenstoffatom enthalten, sind bevorzugt nicht direkt an eine Brücke gebunden.

Bevorzugte Gruppen unter den Gruppen (CyD-1) bis (CyD-10) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1a), (CyD-2a), (CyD-3a), (CyD-4a), (CyD-5a) und (CyD-6a), insbesondere (CyD-1a), (CyD-2a) und (CyD-3a).

In einer bevorzugten Ausführungsform der vorliegenden Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen und CyD eine Heteroarylgruppe mit 6 bis 10 aromatischen Ringatomen. Dabei können CyC und CyD mit einem oder mehreren Resten R substituiert sein.

Die Liganden können, wie bereits erwähnt, verbrückt vorliegen, so dass bevorzugte Liganden durch die Formeln (L-1) und (L-2) dargestellt werden können 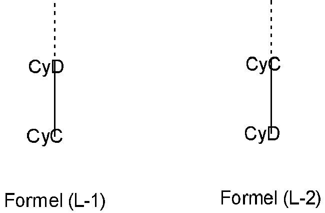 wobei die Gruppen CyC und CyD die zuvor, insbesondere in Formel (2) genannte Bedeutung aufweist und die gestrichelte Linie die optionale die Bindung an die Brücke darstellt.

Die oben genannten bevorzugten Gruppen (CyC-1) bis (CyC-20) und (CyD-1) bis (CyD-14) können in den bidentaten Liganden der Formeln (L-1) und (L-2) beliebig miteinander kombiniert werden.

Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD1-a) bis (CyD-14b) miteinander kombiniert werden. Sofern die Liganden über eine Brücke miteinander verbunden sind, sollte vorzugsweise mindestens eine der bevorzugten Gruppen CyC bzw. CyD eine geeignete Anknüpfungsstelle aufweisen, wobei geeignete Anknüpfungsstellen in den oben genannten Formeln mit "o" gekennzeichnet sind. Kombinationen, in denen weder CyC noch CyD eine solche geeignete Anknüpfungsstelle für eine Brücke aufweist, sind daher in Bezug auf verbrückte Liganden nicht bevorzugt.

Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte bidentaten Liganden L in der Struktur gemäß Formel (2) sind die Strukturen der folgenden Formeln (L-1-1) und (L-1-2), oder Strukturen der folgenden Formeln (L-2-1) bis (L-2-4), 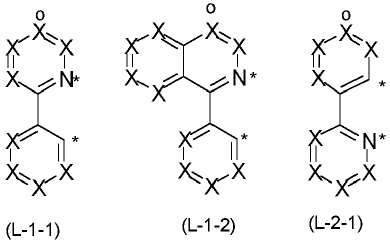 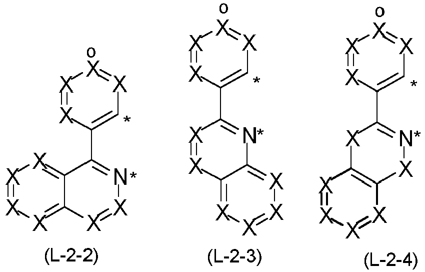 wobei die verwendeten Symbole die oben genannten Bedeutungen aufweisen und die Liganden optional durch eine Brücke verbunden sein können, wobei die Bindung an die Brücke bevorzugt über die mit "o" markierte Position erfolgen kann. Falls die Liganden unverbrückt sind, so kann die mit "o" markierte Position auch mit einem Rest R substituiert sein.

Besonders bevorzugte Liganden (L-1-1) und (L-1-2) sind die Strukturen der folgenden Formeln (L-1-1 a) und (L-1-2b), und besonders bevorzugte Liganden (L-2-1), (L-2-3) und (L-2-4) sind die Strukturen der folgenden Formeln (L-2-1a) bis (L-2-4a), 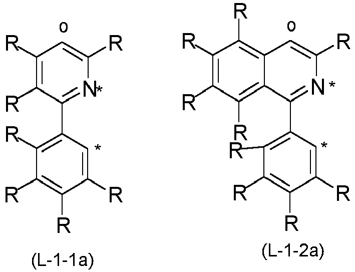 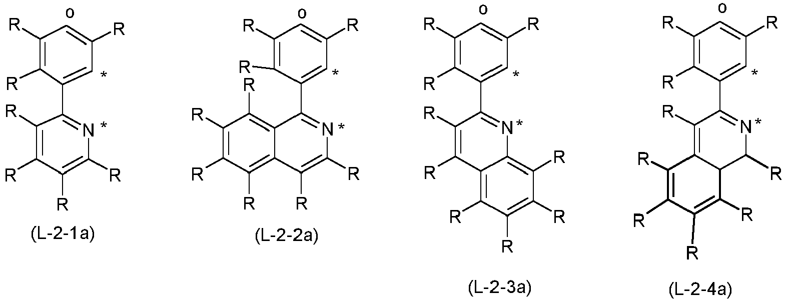 wobei die verwendeten Symbole die oben genannten Bedeutungen aufweisen und die Liganden optional durch eine Brücke verbunden sein können, wobei die Bindung an die Brücke bevorzugt über die mit "o" markierte Position erfolgen kann. Falls die Liganden unverbrückt sind, so kann die mit "o" markierte Position auch mit einem Rest R substituiert sein.

Wenn zwei Reste R, von denen einer an CyC und der andere an CyD in den Formeln (L-1-1) und (L-1-2), oder Strukturen der folgenden Formeln (L-2-1) bis (L-2-4) gebunden sind, miteinander ein aromatisches Ringsystem bilden, können sich überbrückte Liganden und beispielsweise auch Liganden ergeben, die insgesamt eine einzige größere Heteroarylgruppe darstellen, wie beispielsweise Benzo[h]chinolin, etc.. Die Ringbildung zwischen den Substituenten an CyC und CyD in den Formeln (L-1-1) und (L-1-2), oder Strukturen der folgenden Formeln (L-2-1) bis (L-2-4) erfolgt dabei bevorzugt durch eine Gruppe gemäß einer der folgenden Formeln (Ar-1) bis (Ar-10), 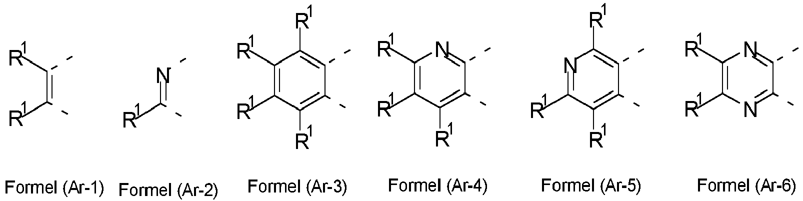 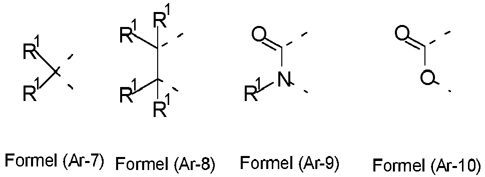 wobei R¹ die oben genannten Bedeutungen aufweist und die gestrichelten Bindungen die Bindungen an CyC bzw. CyD andeuten. Dabei können die unsymmetrischen der oben genannten Gruppen in jeder der beiden Möglichkeiten eingebaut werden, beispielsweise kann bei der Gruppe der Formel (Ar-10) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Dabei ist die Gruppe der Formel (Ar-7) besonders dann bevorzugt, wenn sich dadurch die Ringbildung zu einem Sechsring ergibt, wie beispielsweise unten durch die Formeln (L-21) und (L-22) dargestellt.

Bevorzugte Liganden, die durch Ringbildung zweier Reste R an den unterschiedlichen Cyclen entstehen, sind die im Folgenden aufgeführten Strukturen der Formeln (L-3) bis (L-30), 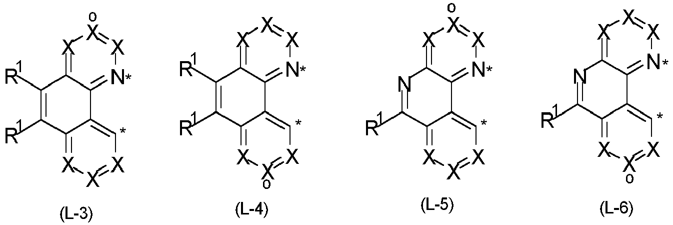 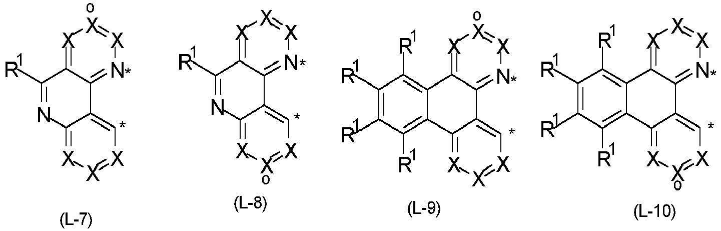 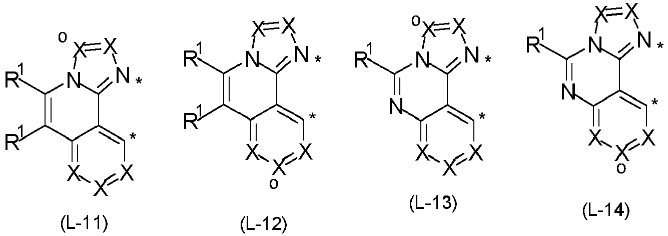 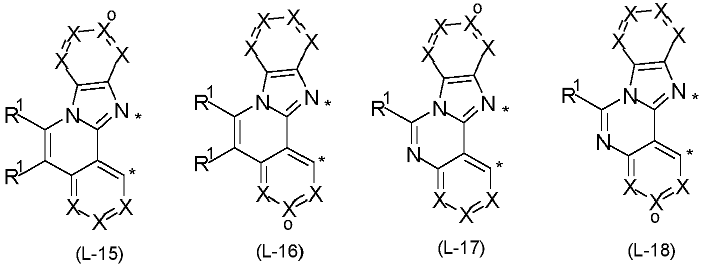 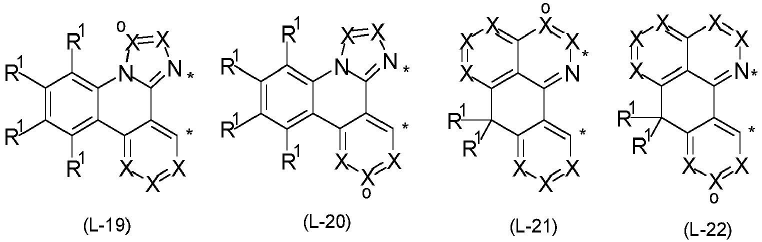 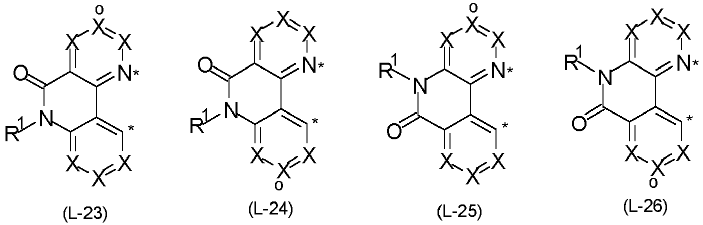 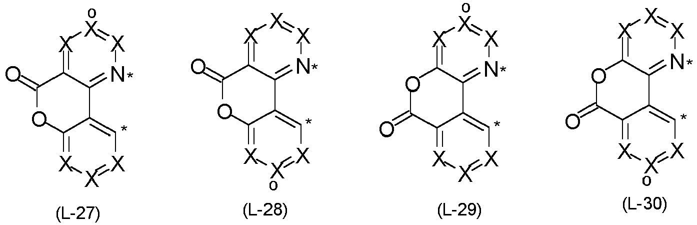 wobei die verwendeten Symbole die oben genannten Bedeutungen aufweisen und wobei die Liganden optional durch eine Brücke verbunden sein können, wobei die Bindung an die Brücke bevorzugt über die mit "o" markierte Position erfolgen kann.

In einer bevorzugten Ausführungsform der Liganden der Formeln (L-3) bis (L-30) steht insgesamt ein Symbol X für N und die anderen Symbole X stehen für CR, oder alle Symbole X stehen für CR.

In einer weiteren Ausführungsform der Erfindung ist es bevorzugt, falls in den Gruppen (CyC-1) bis (CyC-20) oder (CyD-1) bis (CyD-14) oder in den Liganden (L-3) bis (L-30) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1a) bis (CyD-14b), in denen bevorzugt benachbart zu einem nicht koordinierenden Stickstoffatom eine Gruppe R als Substituent gebunden ist, welche ungleich Wasserstoff oder Deuterium ist

Dabei ist dieser Substituent R bevorzugt eine Gruppe, ausgewählt aus CF₃, OCF₃, Alkyl- oder Alkoxygruppen mit 1 bis 10 C-Atomen, insbesondere verzweigten oder cyclischen Alkyl- oder Alkoxygruppen mit 3 bis 10

C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Ein weiterer geeigneter bidentater Liganden für Metallkomplexe, in denen das Metall Iridium ist, ist ein Ligand der folgenden Formel (L-31) oder (L-32), 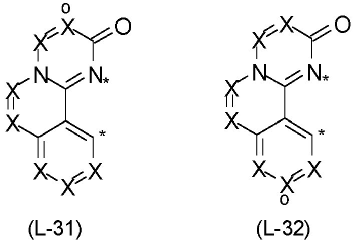 wobei R die oben genannten Bedeutungen aufweist, * die Position der Koordination an das Metall darstellt, wobei die Liganden optional durch eine Brücke verbunden sein können, wobei die Bindung an die Brücke bevorzugt über die mit "o" markierte Position erfolgen kann und für die weiteren verwendeten Symbole gilt:
- X: ist bei jedem Auftreten gleich oder verschieden CR oder N mit der Maßgabe, dass maximal ein Symbol X pro Cyclus für N steht, wobei X C ist, falls an dieser Position der Ligand mit einer Brücke verbunden ist.

Wenn zwei Reste R, die in den Liganden (L-31) bzw. (L-32) an benachbarten Kohlenstoffatomen gebunden sind, miteinander einen aromatischen Cyclus bilden, so ist dieser zusammen mit den beiden benachbarten Kohlenstoffatomen bevorzugt eine Struktur der folgenden Formel (Ar-11), 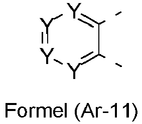 wobei die gestrichelten Bindungen die Verknüpfung dieser Gruppe im Liganden symbolisieren und Y gleich oder verschieden bei jedem Auftreten für CR¹ oder N steht und bevorzugt maximal ein Symbol Y für N steht.

In einer bevorzugten Ausführungsform des Liganden (L-31) bzw. (L-32) bilden maximal zwei Reste R ein aromatisches oder heteroaromatisches Ringsystem. Es handelt sich also bevorzugt um Liganden der folgenden Formeln (L-33) bis (L-38), 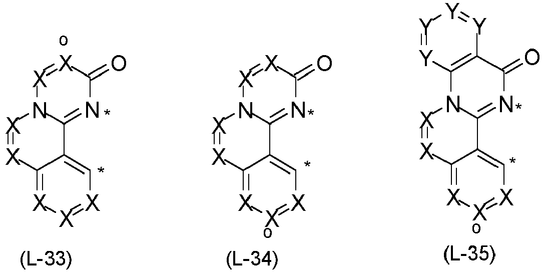 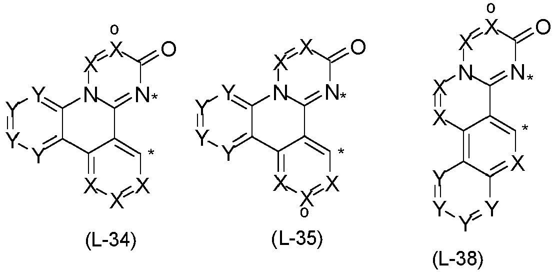 wobei X bei jedem Auftreten gleich oder verschieden für CR oder N steht, jedoch die Reste R nicht miteinander ein aromatisches oder heteroaromatisches Ringsystem bilden und die weiteren Symbole die oben genannten Bedeutungen aufweisen.

In einer bevorzugten Ausführungsform der Erfindung stehen im Liganden der Formel (L-31) bis (L-38) insgesamt 0, 1 oder 2 der Symbole X und, falls vorhanden, Y für N. Besonders bevorzugt stehen insgesamt 0 oder 1 der Symbole X und, falls vorhanden, Y für N.

Bevorzugte Ausführungsformen der Formeln (L-33) bis (L-38) sind die Strukturen der folgenden Formeln (L-33a) bis (L-38f), 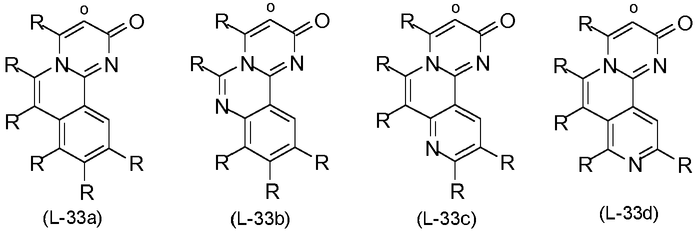 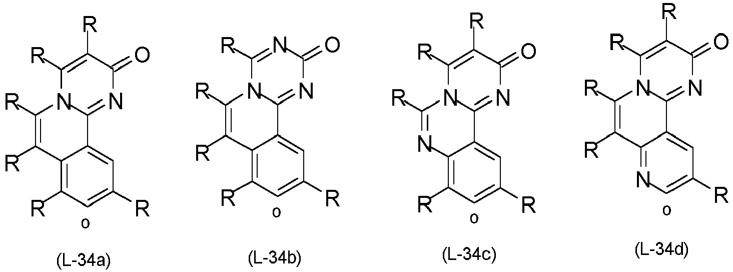 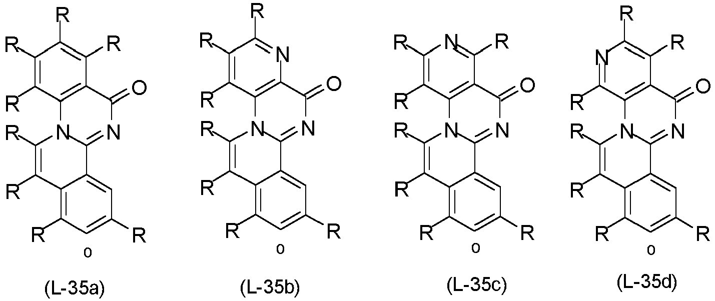 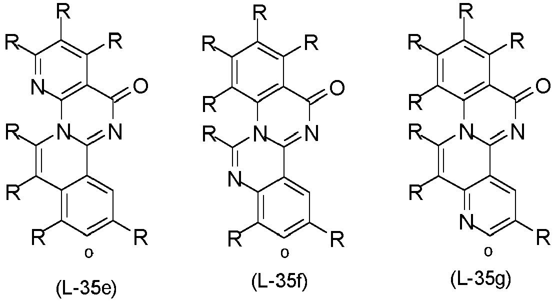 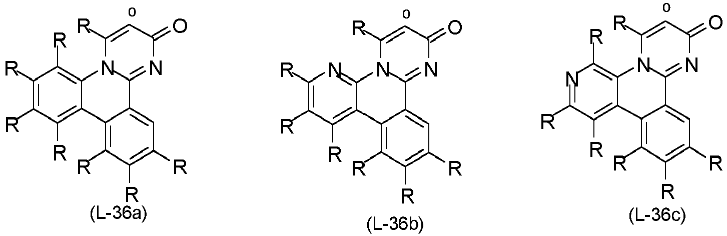 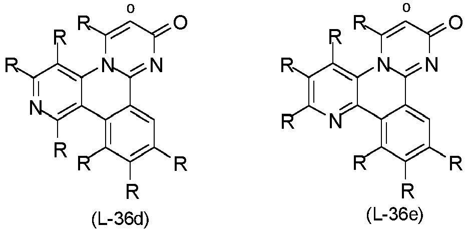 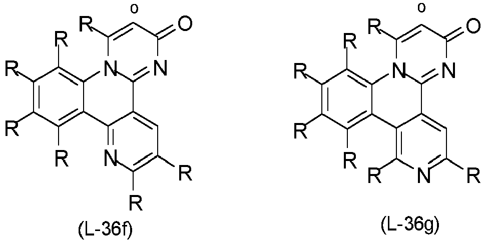 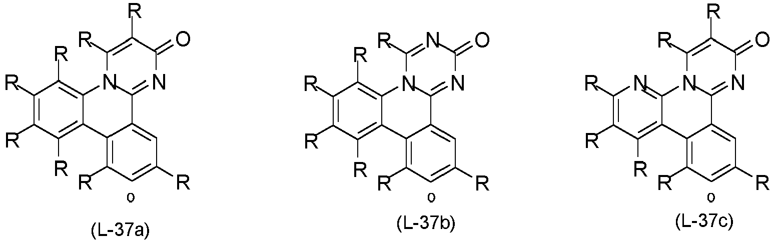 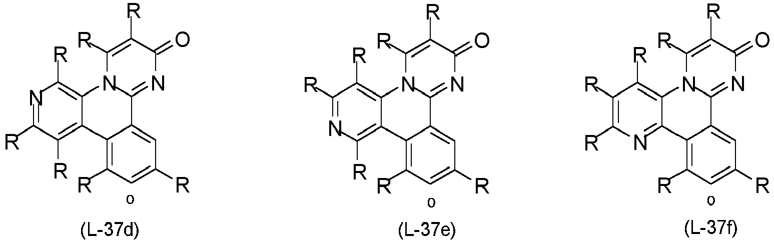 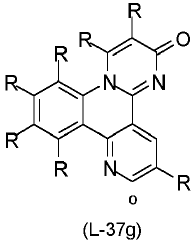 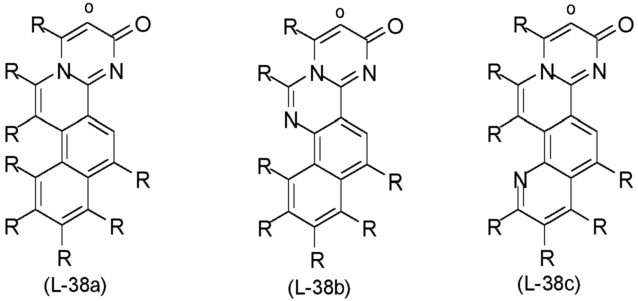 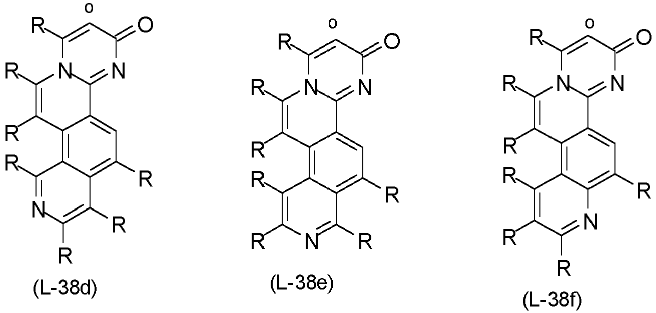 wobei die verwendeten Symbole die oben genannten Bedeutungen aufweisen und die Liganden optional durch eine Brücke verbunden sein können, wobei die Bindung an die Brücke bevorzugt über die mit "o" markierte Position erfolgen kann. Falls die Liganden unverbrückt sind, so kann die mit "o" markierte Position auch mit einem Rest R substituiert sein.

In einer bevorzugten Ausführungsform der Erfindung steht die Gruppe X, die in ortho-Position zur Koordination an das Metall vorliegt, für CR. Dabei ist in dieser Rest R, der in ortho-Position zur Koordination an das Metall gebunden ist, bevorzugt ausgewählt aus der Gruppe bestehend aus H, D, F und Methyl.

In einer weiteren Ausführungsform der Erfindung ist es bevorzugt, falls eines der Atome X oder, wenn vorhanden, Y für N steht, wenn benachbart zu diesem Stickstoffatom eine Gruppe R als Substituent gebunden ist, welche ungleich Wasserstoff oder Deuterium ist.

Dabei ist dieser Substituent R bevorzugt eine Gruppe, ausgewählt aus CF₃, OCF₃, Alkyl- oder Alkoxygruppen mit 1 bis 10 C-Atomen, insbesondere verzweigten oder cyclischen Alkyl- oder Alkoxygruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

In einer weiteren Ausführungsform kann maximal einer der bidentaten Liganden bei jedem Auftreten gleich oder verschieden ausgewählt sein aus den Liganden der folgenden Formeln (L-39) bis (L-42), 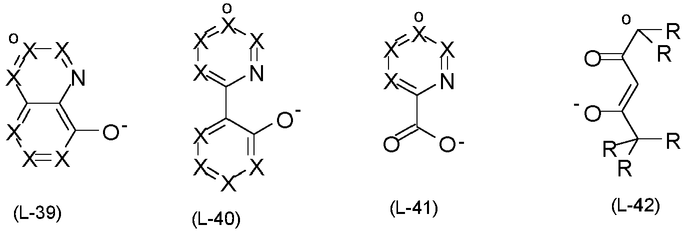 wobei die Liganden (L-39) bis (L-41) jeweils über das explizit eingezeichnete Stickstoffatom und das negativ geladene Sauerstoffatom und der Teilligand (L-42) über die beiden Sauerstoffatome an das Metall koordinieren, X die oben genannten Bedeutungen aufweist, wobei die Liganden optional durch eine Brücke verbunden sein können, wobei die Bindung an die Brücke bevorzugt über die mit "o" markierte Position erfolgen kann wobei X C ist, falls an dieser Position der Ligand mit einer Brücke verbunden ist oder in Formel (L-42) das Kohlenstoffatom einen Substituenten R aufweisen kann, falls der Ligand an dieser Position nicht mit einer Brücke verbunden ist.

Die oben ausgeführten bevorzugten Ausführungsformen für X sind auch bevorzugt für die Liganden der Formeln (L-39) bis (L-41).

Bevorzugte Liganden der Formeln (L-39) bis (L-41) sind daher die Liganden der folgenden Formeln (L-39a) bis (L-41a), 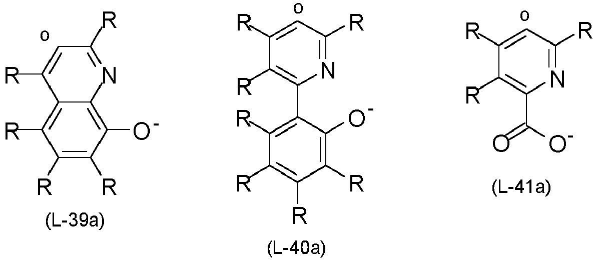 wobei die verwendeten Symbole die oben genannten Bedeutungen aufweisen und die Liganden optional durch eine Brücke verbunden sein können, wobei die Bindung an die Brücke bevorzugt über die mit "o" markierte Position erfolgen kann und das Kohlenstoffatom einen Substituenten R aufweisen kann, falls der Ligand an dieser Position nicht mit einer Brücke verbunden ist. Falls die Brücke an eine andere Stelle bindet ist eine Gruppe R an dieser Position nicht vorhanden.

Besonders bevorzugt steht in diesen Formeln R für Wasserstoff, wobei die Liganden optional durch eine Brücke verbunden sein können, wobei die Bindung an die Brücke bevorzugt über die mit "o" markierte Position erfolgen kann, so dass es sich um die Strukturen der folgenden Formeln (L-39b) bis (L-41b) handelt, 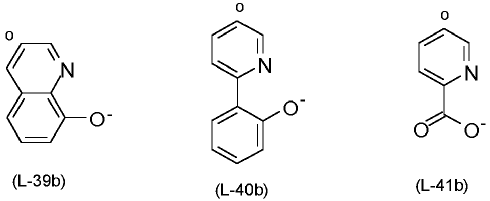 wobei die verwendeten Symbole die oben genannten Bedeutungen aufweisen.

Im Folgenden werden bevorzugte Substituenten beschrieben, wie sie an den oben beschriebenen Liganden vorliegen können.

In einer bevorzugten Ausführungsform der Erfindung enthält der erfindungsgemäß einzusetzende Metallkomplex mindestens einen Liganden mit zwei Substituenten R oder zwei Substituenten R¹, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an einem oder mehreren der Liganden, vorzugsweise der bidentaten Liganden vorliegen und/oder an einer Brücke, durch die diese Liganden verbunden sein können, vorliegen. Der aliphatische Ring, der durch die Ringbildung von zwei Substituenten R miteinander oder von zwei Substituenten R¹ miteinander gebildet wird, wird bevorzugt durch eine der folgenden Formeln (RI-1) bis (RI-8) beschrieben, 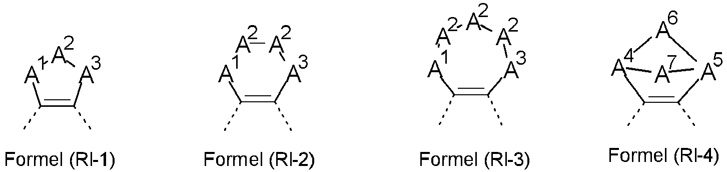 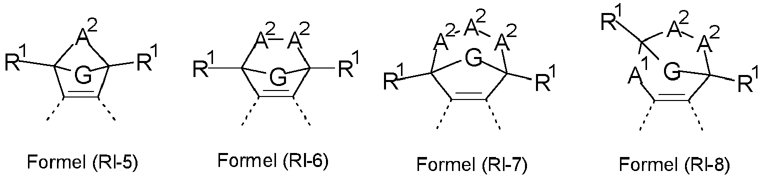 wobei R¹ und R² die oben genannten Bedeutungen aufweisen, die gestrichelten Bindungen die Verknüpfung der beiden Kohlenstoffatome im Liganden andeuten und weiterhin gilt:
- A¹, A³: ist gleich oder verschieden bei jedem Auftreten C(R³)₂, O, S, NR³ oder C(=O);
- A²: ist C(R¹)₂, O, S, NR³ oder C(=O);
- A⁴, A⁵: ist gleich oder verschieden bei jedem Auftreten CR¹ oder N;
- A⁶, A: ⁷ ist gleich oder verschieden bei jedem Auftreten eine Alkylengruppe mit 2 oder 3 C-Atomen, in welcher ein Kohlenstoffatom durch Sauerstoff ersetzt sein kann und welche mit einem oder mehreren Resten R¹ substituiert sein kann;
mit der Maßgabe, dass in A⁴-A⁶-A⁵ bzw. A⁴-A⁷-A⁵ nicht zwei Hetero-atome direkt aneinander gebunden sind;
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine gerad-kettige Alkyl- oder Alkoxygruppe mit 1 bis 10 C-Atomen, eine ver-zweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryl-oxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;

mit der Maßgabe, dass in diesen Gruppen nicht zwei Heteroatome direkt aneinander gebunden sind und nicht zwei Gruppen C=O direkt aneinander gebunden sind.

In einer bevorzugten Ausführungsform der Erfindung ist R³ ungleich H.

In den oben abgebildeten Strukturen der Formeln (RI-1) bis (RI-8) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (RI-1) bis (RI-3) dadurch erreicht, dass A¹ und A³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (RI-4) bis (RI-8) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (RI-4) bis (RI-8) für H steht, handelt es sich dabei daher um ein nicht-azides Proton im Sinne der vorliegenden Anmeldung.

In einer bevorzugten Ausführungsform der Struktur gemäß Formel (RI-1) bis (RI-8) steht maximal eine der Gruppen A¹, A² und A³ oder A⁴, A⁵, A⁶ und A⁷ für ein Heteroatom, insbesondere für O oder NR³, und die anderen Gruppen stehen für C(R³)₂ bzw. C(R¹)₂ oder A¹ und A³ stehen gleich oder verschieden bei jedem Auftreten für O oder NR³ und A² steht für C(R¹)₂. In einer besonders bevorzugten Ausführungsform der Erfindung stehen A¹ und A³ gleich oder verschieden bei jedem Auftreten für C(R³)₂ und A² steht für C(R¹)₂ und besonders bevorzugt für C(R³)₂ oder CH₂.

In einer bevorzugten Ausführungsform der Erfindung ist der Rest R¹, der an das Brückenkopfatom, vorzugsweise an das Brückenkopfatom gemäß Formel (RI-4) gebunden ist, gleich oder verschieden bei jedem Auftreten gewählt aus der Gruppe bestehend aus H, D, F, einer geradkettigen Alkylgruppe mit 1 bis 10 C-Atomen, die mit einem oder mehreren Resten R² substituiert sein kann, bevorzugt aber unsubstituiert ist, einer verzweigten oder cyclischen Alkylgruppe mit 3 bis 10 C-Atomen, die mit einem oder mehreren Resten R² substituiert sein kann, bevorzugt aber unsubstituiert ist, oder einem aromatischen oder heteroaromatischen Ringsystem mit 5 bis 12 aromatischen Ringatomen, das jeweils durch einen oder mehrere Reste R² substituiert sein kann. Besonders bevorzugt ist der Rest R¹, der an das Brückenkopfatom gemäß Formel (RI-4) gebunden ist, gleich oder verschieden bei jedem Auftreten gewählt aus der Gruppe bestehend aus H, F, einer geradkettigen Alkylgruppe mit 1 bis 4 C-Atomen, einer verzweigten Alkylgruppe mit 3 oder 4 C-Atomen oder einer Phenylgruppe, die durch eine Alkylgruppe mit 1 bis 4 C-Atomen substituiert sein kann, bevorzugt aber unsubstituiert ist. Ganz besonders bevorzugt ist der Rest R¹ bei jedem Auftreten gleich oder verschieden gewählt aus der Gruppe bestehend aus H, Methyl oder tert-Butyl.

In einer weiteren bevorzugten Ausführungsform stehen beide Gruppen A⁴ und A⁵ in Formel (RI-4) für CR¹ und die beiden Reste R¹ sind gleich gewählt.

In einer weiteren bevorzugten Ausführungsform der Erfindung stehen A⁶ und A⁷ gleich oder verschieden bei jedem Auftreten für eine Alkylengruppe mit 2 oder 3 Kohlenstoffatomen, die mit einem oder mehreren Resten R³ substituiert sein kann. Bevorzugt enthalten A⁶ und A⁷ somit keine Sauerstoffatome in der Alkylengruppe.

In einer bevorzugten Ausführungsform der Erfindung ist der Rest R¹, der an A⁶ bzw. A⁷ bindet, gleich oder verschieden bei jedem Auftreten ausgewählt aus der Gruppe bestehend aus H, D, F, einer geradkettigen Alkylgruppe mit 1 bis 10 C-Atomen, die mit einem oder mehreren Resten R² substituiert sein kann, bevorzugt aber unsubstituiert ist, einer verzweigten oder cyclischen Alkylgruppe mit 3 bis 10 C-Atomen, die mit einem oder mehreren Resten R² substituiert sein kann, bevorzugt aber unsubstituiert ist, oder einem aromatischen oder heteroaromatischen Ringsystem mit 5 bis 12 aromatischen Ringatomen, das jeweils durch einen oder mehrere Reste R² substituiert sein kann; dabei können zwei Reste R¹ miteinander einen Ring bilden und so ein polycyclisches, aliphatisches Ringsystem aufspannen. Dabei ist die Ringbildung auch möglich und bevorzugt zwischen einem Rest R¹, der an A⁶ gebunden ist, und einem Rest R¹, der an A⁷ gebunden ist. Die Ringbildung zwischen einem Rest R¹, der an A⁶ gebunden ist, und einem Rest R¹, der an A⁷ gebunden ist, erfolgt bevorzugt durch eine Einfachbindung, Sauerstoff, eine Methylengruppe, die durch ein oder zwei Gruppen R² substituiert sein kann, bevorzugt aber unsubstituiert ist, oder eine Ethylengruppe, die durch ein oder mehrere Gruppen R² substituiert sein kann, bevorzugt aber unsubstituiert ist. Besonders bevorzugt ist der Rest R¹ gleich oder verschieden bei jedem Auftreten gewählt aus der Gruppe bestehend aus H, F, einer geradkettigen Alkylgruppe mit 1 bis 4 C-Atomen oder einer verzweigten Alkylgruppe mit 3 oder 4 C-Atomen; dabei können zwei Reste R¹ miteinander einen Ring bilden und so ein polycyclisches, aliphatisches Ringsystem aufspannen.

Besonders bevorzugt stehen A⁴ und A⁵ gleich oder verschieden für CR¹, und A⁶ und A⁷ stehen gleich oder verschieden bei jedem Auftreten für eine Alkylengruppe mit 2 oder 3 Kohlenstoffatomen, die mit einem oder mehreren Resten R¹ substituiert sein kann, wobei für R¹ bevorzugt die oben genannten bevorzugten Definitionen gelten.

In einer bevorzugten Ausführungsform der Erfindung stehen A⁶ und A⁷ jeweils für eine Ethylengruppe, die mit einem oder mehreren Resten R¹ substituiert sein kann. In einer weiteren bevorzugten Ausführungsform der Erfindung steht A⁶ für eine Ethylengruppe und A⁷ für eine Propylengruppe, die jeweils mit einem oder mehreren Resten R¹ substituiert sein können. In nochmals einer weiteren Ausführungsform der Erfindung stehen A⁶ und A⁷ jeweils für eine Propylengruppe, die mit einem oder mehreren Resten R¹ substituiert sein können.

Bevorzugte Ausführungsformen der Formel (RI-1) sind somit die Strukturen der Formel (RI-1-A), (RI-1-B), (RI-1-C) und (RI-1-D), und eine besonders bevorzugte Ausführungsform der Formel (RI-1-A) sind die Strukturen der Formel (RI-1-E) und (RI-1-F), 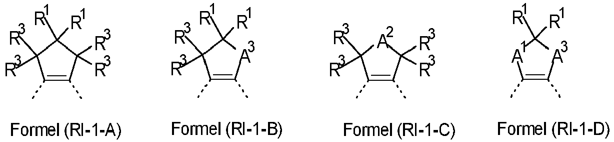 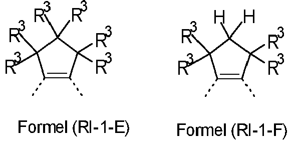 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (RI-2) sind die Strukturen der folgenden Formeln (RI-2-A) bis (RI-2-F), 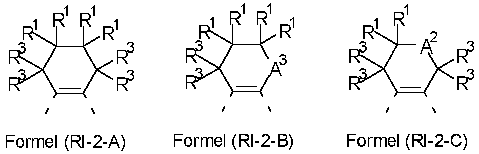 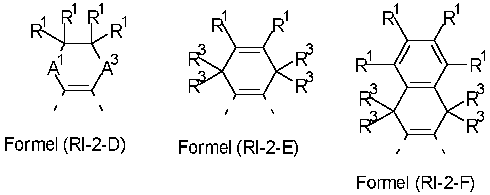 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (RI-3) sind die Strukturen der folgenden Formeln (RI-3-A) bis (RI-3-E), 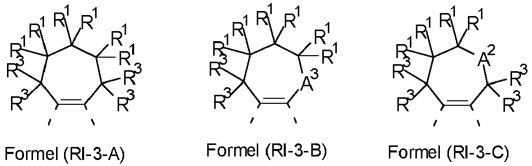 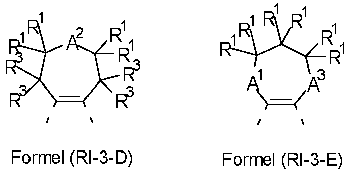 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (RI-4-1) sind die Strukturen der folgenden Formeln (RI-4-1), (RI-4-2) oder (RI-4-3), 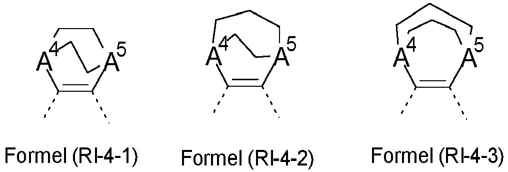 wobei A⁴ und A⁵ die oben genannten Bedeutungen aufweisen und die Ethylengruppen bzw. Propylengruppen, die der Übersichtlichkeit halber unsubstituiert eingezeichnet sind, durch einen oder mehrere Reste R¹ substituiert sein können, wobei R¹ die oben genannten Bedeutungen aufweist. Dabei können insbesondere auch zwei Reste R¹, die an die beiden unterschiedlichen Ethylen- bzw. Propylengruppen gebunden sind, miteinander zu einem Ringsystem verknüpft sein. Bevorzugte Strukturen der Formeln (RI-4-1), (RI-4-2) oder (RI-4-3) sind die Strukturen der folgenden Formeln (RI-4-1a), (RI-4-2a) oder (RI-4-3a), 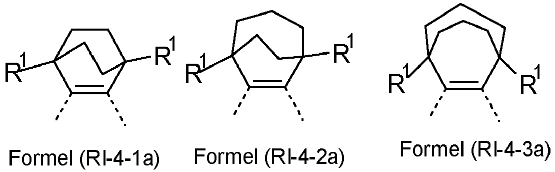 wobei die Ethylengruppen bzw. Propylengruppen durch einen oder mehrere Reste R¹ substituiert sein können, wobei R¹ die oben genannten Bedeutungen aufweist. Dabei können insbesondere auch zwei Reste R¹, die an die beiden unterschiedlichen Ethylen- bzw. Propylengruppen gebunden sind, miteinander zu einem Ringsystem verknüpft sein.

Bevorzugte Strukturen der Formeln (RI-4-1) und (RI-4-3), in denen zwei Reste R³ miteinander zu einem Ringsystem verknüpft sind, sind die Strukturen der folgenden Formeln (RI-4-1b) und (RI-4-3b), 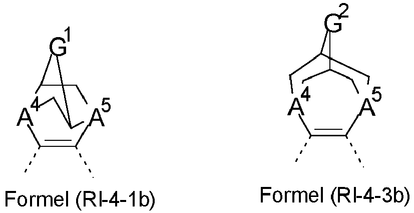 wobei A⁴ und A⁵ die oben genannten Bedeutungen aufweisen, die Ethylen- bzw. Propylengruppen durch einen oder mehrere Reste R¹ substituiert sein kann und G¹ für eine Ethylengruppe steht, die mit einem oder mehreren Gruppen R² substituiert sein kann, bevorzugt aber unsubstituiert ist, und G² für eine Einfachbindung, eine Methylen- oder Ethylengruppe, die jeweils mit einem oder mehreren Gruppen R² substituiert sein kann, bevorzugt aber unsubstituiert ist, oder für ein Sauerstoffatom steht. Bevorzugt stehen A⁴ und A⁵ in den Formeln (RI-4-1b) und (RI-4-3b) gleich oder verschieden für CR¹.

In einer bevorzugten Ausführungsform der Struktur gemäß Formel (RI-5) stehen die Reste R¹, die an den Brückenkopf gebunden sind, für H, D, F oder CH₃. Weiterhin bevorzugt steht A² für C(R¹)₂ oder O, und besonders bevorzugt für C(R³)₂. Bevorzugte Ausführungsformen der Formel (RI-5) sind somit eine Strukturen der Formel (RI-5-A) und (RI-5-B), und eine besonders bevorzugte Ausführungsform der Formel (RI-5-A) ist eine Struktur der Formel (RI-5-C), 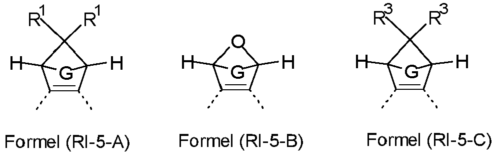 wobei die verwendeten Symbole die oben genannten Bedeutungen aufweisen.

In einer bevorzugten Ausführungsform der Struktur gemäß Formel (RI-6), (RI-7) und (RI-8) stehen die Reste R¹, die an den Brückenkopf gebunden sind, für H, D, F oder CH₃. Weiterhin bevorzugt steht A² für C(R¹)₂. Bevorzugte Ausführungsformen der Formel (RI-6), (RI-7) und (RI-8) sind somit die Strukturen der Formeln (RI-6-A), (RI-7-A) und (RI-8-A), 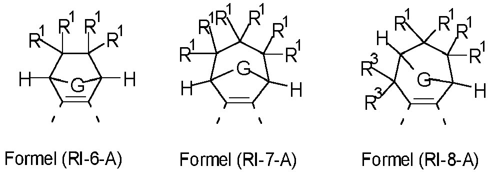 wobei die verwendeten Symbole die oben genannten Bedeutungen aufweisen.

Weiterhin bevorzugt steht die Gruppe G in den Formeln (RI-5), (RI-5-A), (RI-5-B), (RI-5-C), (RI-6), (RI-6-A), (RI-7), (RI-7-A), (RI-8) und (RI-8-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (RI-1) bis (RI-8) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (RI-1) bis (RI-8) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (RI-1) sind die im Folgenden aufgeführten Gruppen (RI-1-1) bis (RI-1-71):

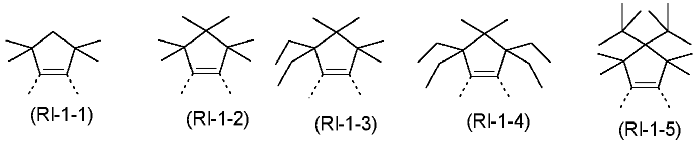

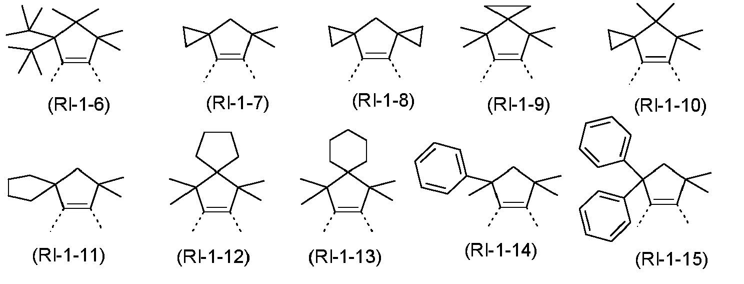

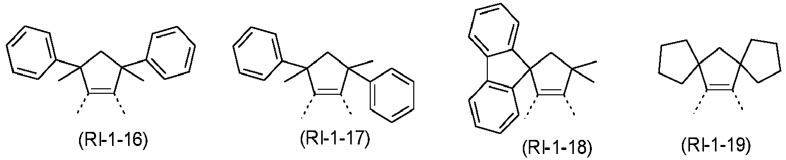

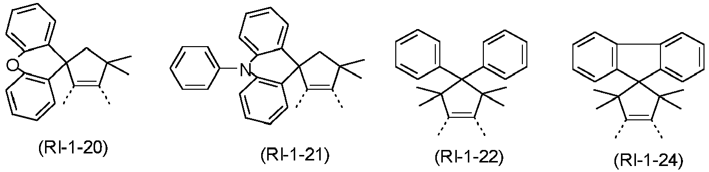

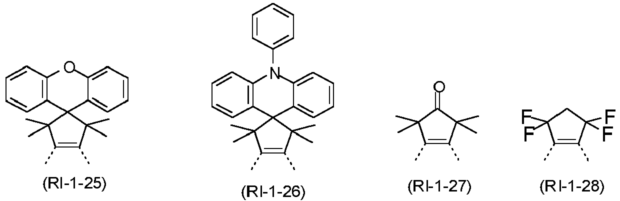

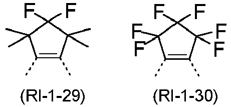

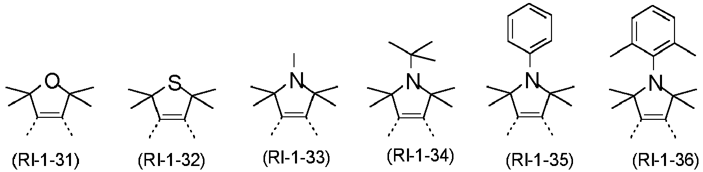

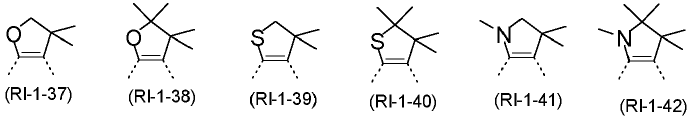

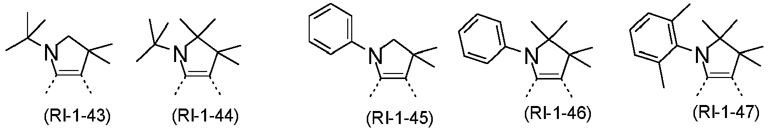

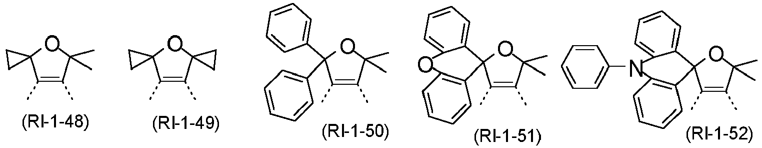

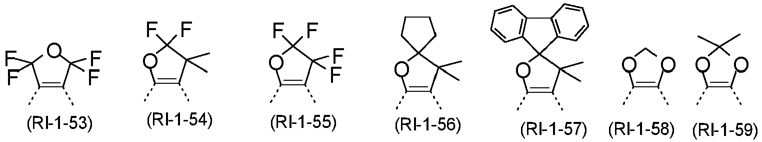

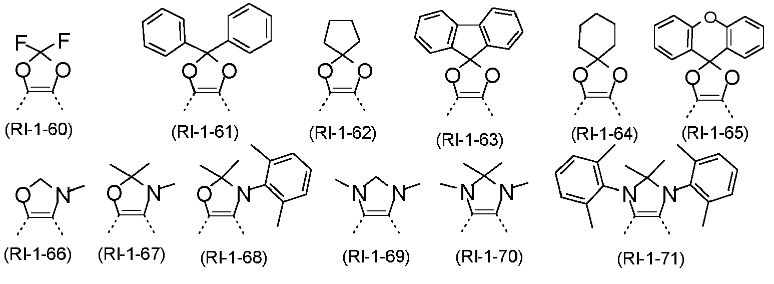

Beispiele für besonders geeignete Gruppen der Formel (RI-2) sind die im Folgenden aufgeführten Gruppen (RI-2-1) bis (RI-2-14):

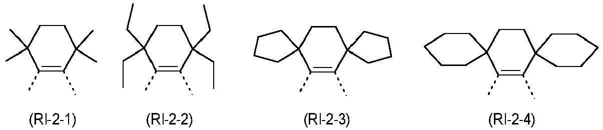

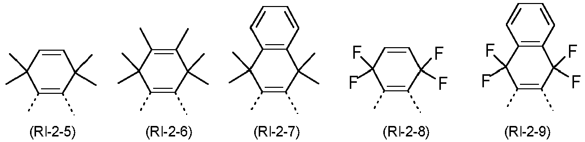

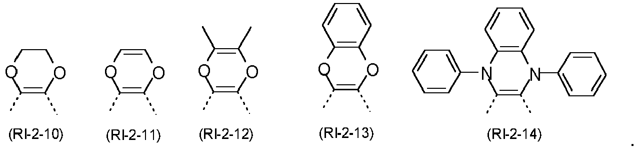

Beispiele für besonders geeignete Gruppen der Formel (RI-3), (RI-7) und (RI-8) sind die im Folgenden aufgeführten Gruppen (RI-3-1), (RI-7-1) und (RI-8-1):

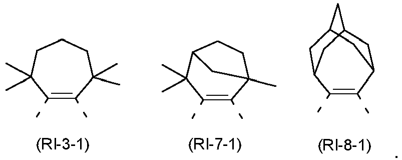

Beispiele für geeignete Strukturen der Formel (RI-4-1) sind die folgenden Strukturen (RI-4-1-1) bis (RI-4-1-20):

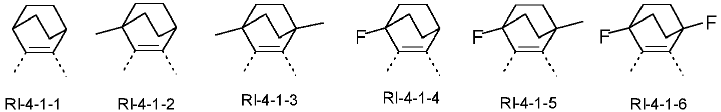

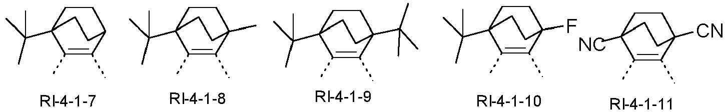

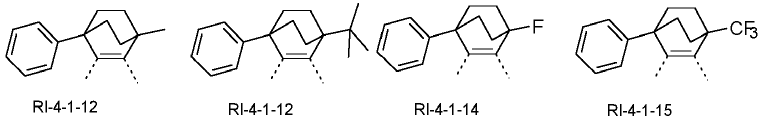

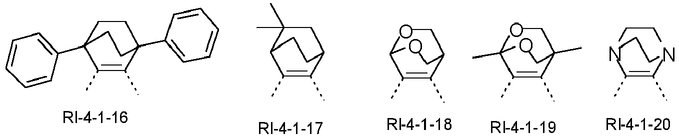

Dabei sind die folgenden beiden Strukturen besonders bevorzugt:

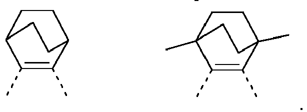

Beispiele für geeignete Strukturen der Formel (RI-4-2) sind die folgenden Strukturen (RI-4-2-1) bis (RI-4-2-5):

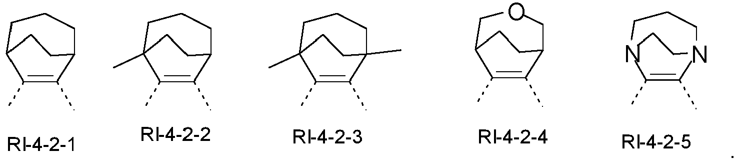

Beispiele für geeignete Strukturen der Formel (RI-4-3) sind die folgenden Strukturen (RI-4-3-1) bis (RI-4-3-3):

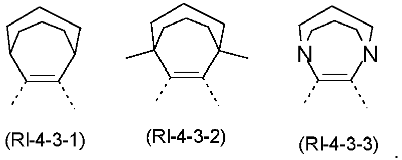

Beispiele für geeignete Strukturen der Formel (RI-4-1b) und (RI-4-3b) sind die folgenden Strukturen:

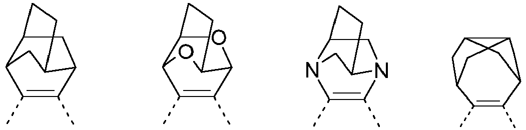

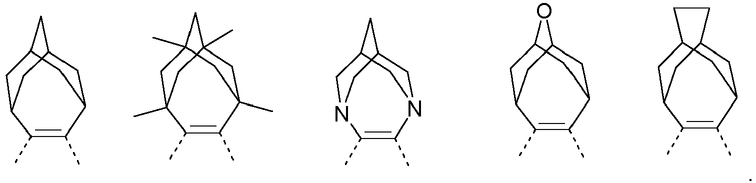

Dabei sind die drei folgenden Strukturen besonders bevorzugt:

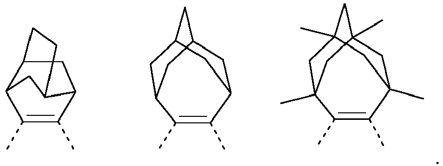

Beispiele für besonders geeignete Gruppen der Formel (RI-5) sind die im Folgenden aufgeführten Gruppen (RI-5-1) bis (RI-5-22):

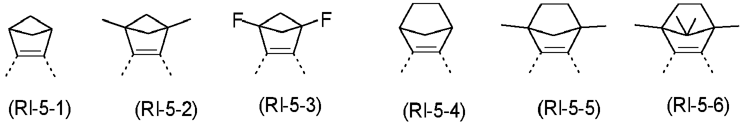

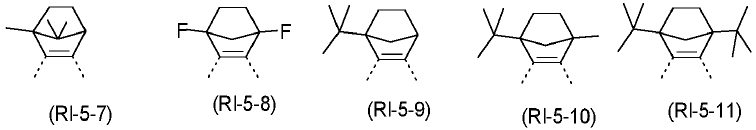

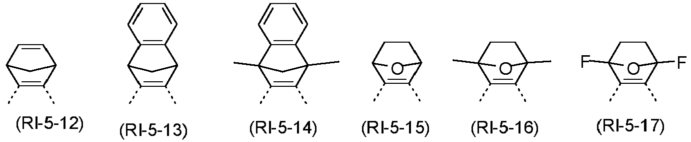

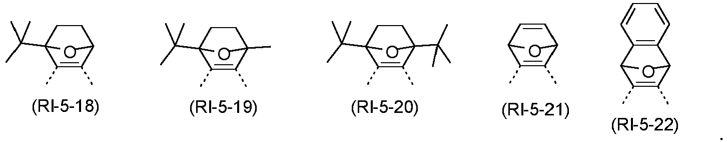

Beispiele für besonders geeignete Gruppen der Formel (RI-6) sind die im Folgenden aufgeführten Gruppen (RI-6-1) bis (RI-6-5):

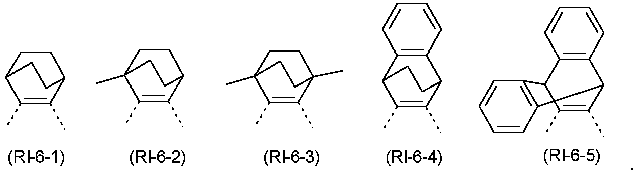

In einer bevorzugten Ausführungsform der Erfindung stehen A⁴ und A⁵ beide gleich oder verschieden für CR¹, oder A⁴ und A⁵ stehen beide für N. Besonders bevorzugt stehen A⁴ und A⁵ gleich oder verschieden für CR¹. Es handelt sich also besonders bevorzugt um Kohlenstoff-Brückenkopfatome.

Wie oben beschrieben, kann bevorzugt vorgesehen sein, dass CyD und/oder CyC bzw. die oben aufgeführten bevorzugten Ausführungsformen zwei benachbarte Kohlenstoffatome aufweist, die jeweils mit Substituenten R und/oder Substituenten R¹ substituiert sind, die an benachbarte Kohlenstoffatome gebunden sind, wobei die jeweiligen Reste R und/oder R¹ zusammen mit den C-Atomen eine bi- bzw. polycyclische Struktur der oben genannten Formeln (RI-1) bis (RI-8) aufspannen.

In einer bevorzugten Ausführungsform der Erfindung enthält der Ligand L oder gegebenenfalls der Ligand L' genau eine Gruppe der Formeln (RI-1) bis (RI-8). Dabei kann entweder CyC oder CyD diese Struktur aufweisen. Generell kann die Gruppe gemäß einer der Formeln (RI-1) bis (RI-8) in jeder möglichen Position an CyC oder CyD gebunden sein.

In den folgenden Gruppen (CyC-1-1) bis (CyC-19-1) und (CyD-1-1) bis (CyD-10-1) sind jeweils die bevorzugten Positionen für benachbarte Gruppen X, welche für CR stehen, wobei die jeweiligen Reste R zusammen mit den C-Atomen, an die sie gebunden sind, einen Ring gemäß einer der oben genannten Formeln (RI-1) bis (RI-8) aufspannen, abgebildet, 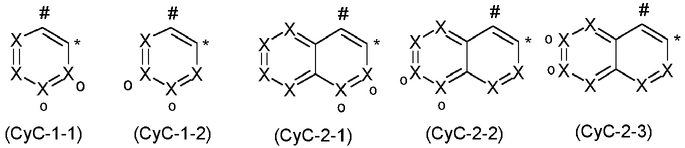 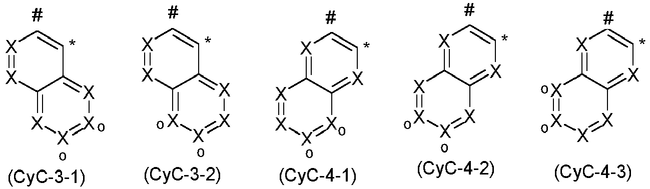 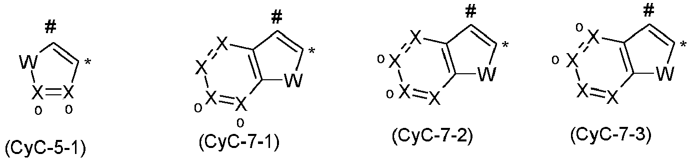 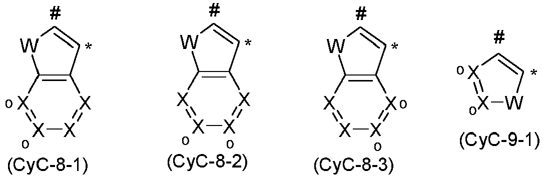 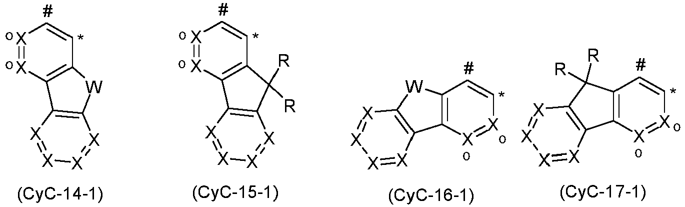 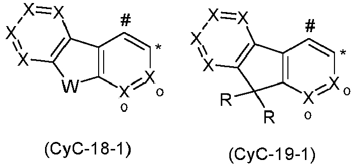 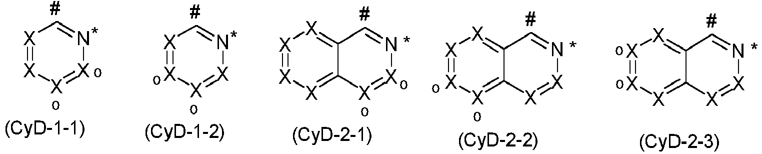 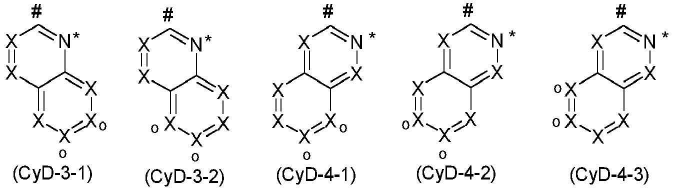 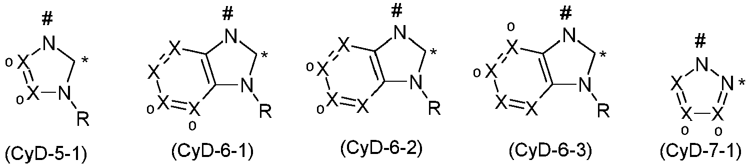 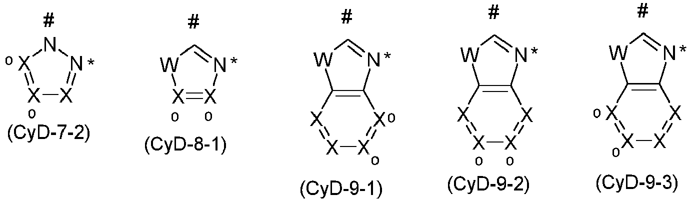 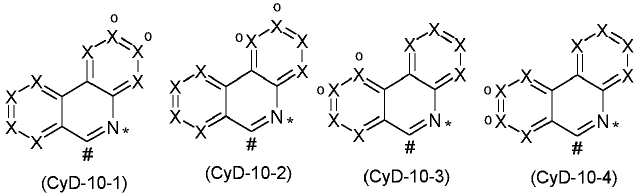 wobei die verwendeten Symbole die oben genannten Bedeutungen aufweisen und ° jeweils die Positionen kennzeichnet, die für CR stehen, wobei die jeweiligen Reste R zusammen mit den C-Atomen, an die sie gebunden sind, einen Ring der oben genannten Formeln (RI-1) bis (RI-8) aufspannen.

Bevorzugte Positionen für die Bindung der Ringstruktur der oben genannten Formeln (RI-1) bis (RI-8) in den Liganden (L1) bis (L6) sind in den folgenden Strukturen (L1-1) bis (L6-6) abgebildet: 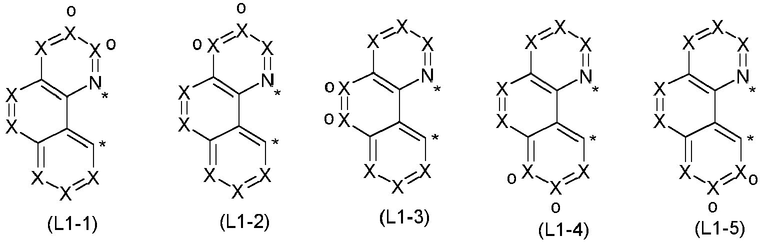 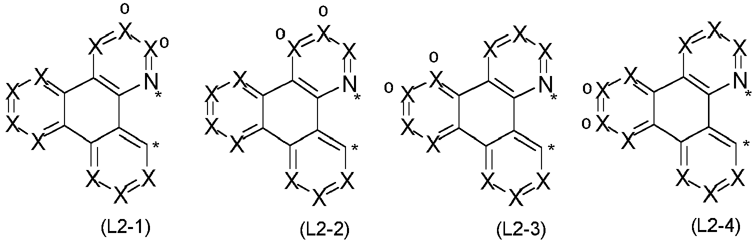 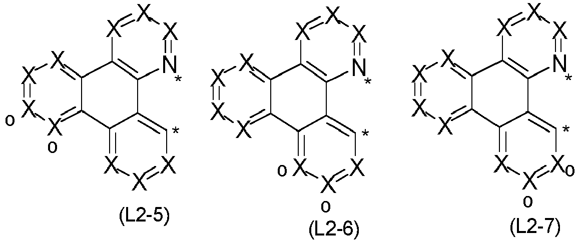 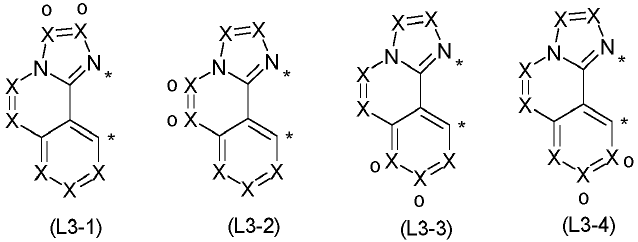 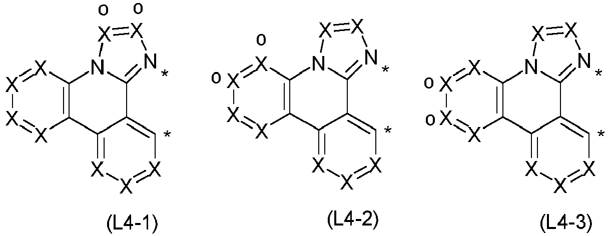 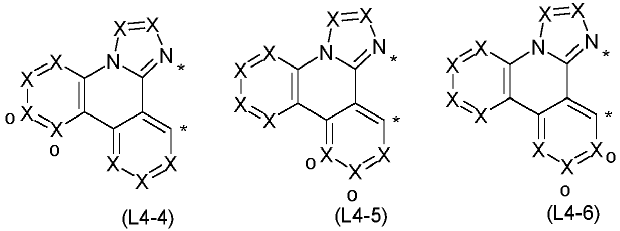 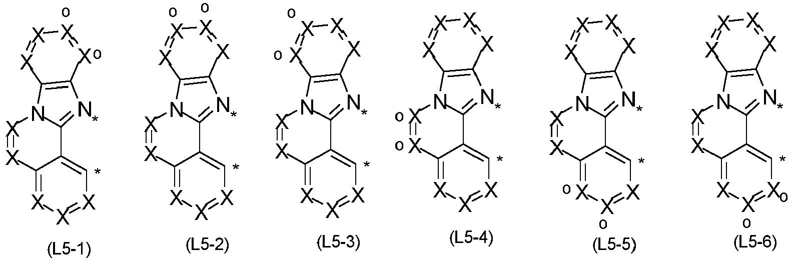 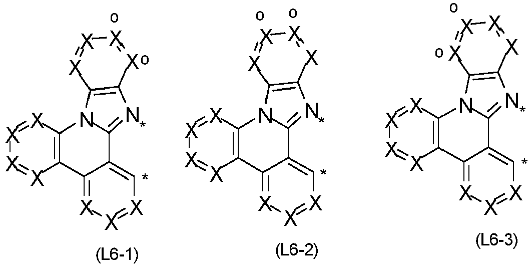 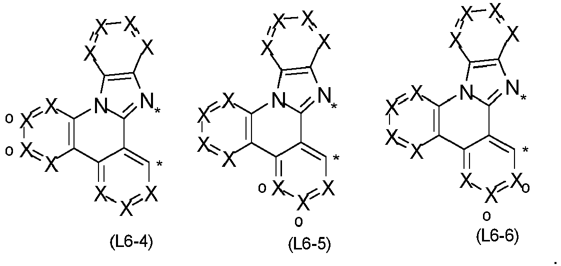 wobei die verwendeten Symbole die oben genannten Bedeutungen aufweisen und ° jeweils die Positionen kennzeichnet, die für CR stehen, wobei die jeweiligen Reste R zusammen mit den C-Atomen, an die sie gebunden sind, einen Ring der oben genannten Formeln (RI-1) bis (RI-8) aufspannen.

Wenn in der Teilstruktur der Formel (2) Reste R gebunden sind, die nicht für eine Gruppe der Formel (RI-1) bis (RI-8) stehen, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden. Weiterhin ist auch eine Ringbildung zwischen CyC und CyD möglich, wie oben beschrieben.

Weiterhin ist es möglich, dass der Substituent R, der in der ortho-Position zur Metallkoordination gebunden ist, eine Gruppe darstellt, die ebenfalls an das Metall M koordiniert bzw. bindet. Bevorzugte koordinierende Gruppen R sind Aryl- bzw. Heteroarylgruppen, beispielsweise Phenyl oder Pyridyl, Aryl- oder Alkylcyanide, Aryl- oder Alkylisocyanide, Amine oder Amide, Alkohole oder Alkoholate, Thioalkohole oder Thioalkoholate, Phosphine, Phosphite, Carbonylfunktionen, Carboxylate, Carbamide oder Aryl- oder Alkylacetylide. Beispiele für Teilstrukturen IrL der Formel (2), in denen CyD für Pyridin und CyC für Benzol steht, sind die Strukturen der folgenden Formeln (TS-1) bis (TS-12): 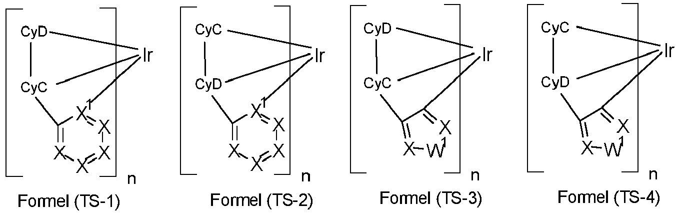 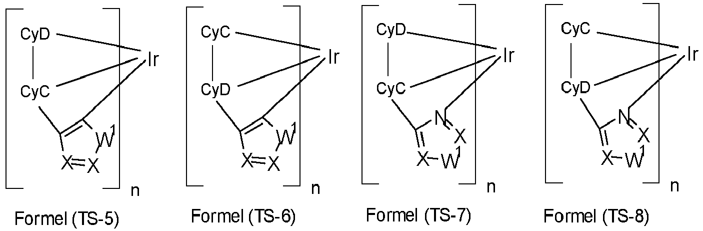 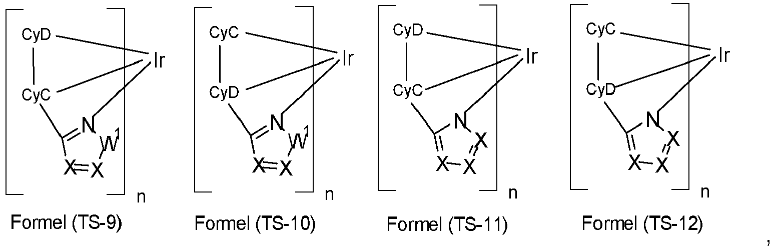 wobei die verwendeten Symbole und Indizes die gleichen Bedeutungen aufweisen, wie oben beschrieben, X¹ gleich oder verschieden bei jedem Auftreten für C oder N steht und W¹ gleich oder verschieden bei jedem Auftreten für S, O oder NR¹ steht.

Die Formeln (TS-1) bis (TS-12) zeigen nur exemplarisch, wie der Substituent R zusätzlich an das Metall koordinieren kann. Ganz analog sind ohne weiteres erfinderisches Zutun auch andere an Iridium koordinierende Gruppen R zugänglich, beispielsweise auch Carbene.

Wie oben beschrieben, kann auch statt einem der Reste R eine verbrückende Einheit vorhanden sein, die diesen Liganden L mit einem oder mehreren weiteren Liganden L bzw. L' verknüpft. In einer bevorzugten Ausführungsform der Erfindung ist statt einem der Reste R, insbesondere statt der Reste R, die in ortho- oder meta-Position zum koordinierenden Atom stehen, eine verbrückende Einheit vorhanden, so dass die Liganden dreizähnigen oder mehrzähnigen oder polypodalen Charakter aufweisen. Es können auch zwei solcher verbrückenden Einheiten vorhanden sein. Dies führt zur Bildung makrocyclischer Liganden bzw. zur Bildung von Kryptaten.

Bevorzugte Strukturen mit mehrzähnigen Liganden bzw. mit polydentaten Liganden sind die Metallkomplexe der folgenden Formeln (V-1) bis (V-6), 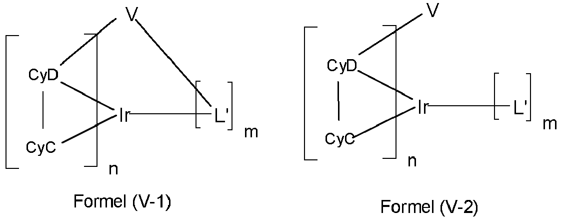 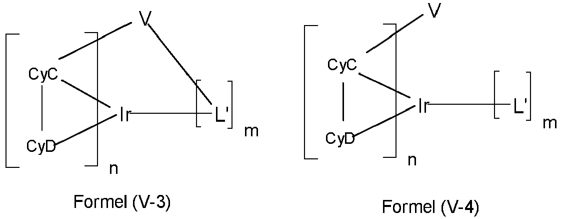 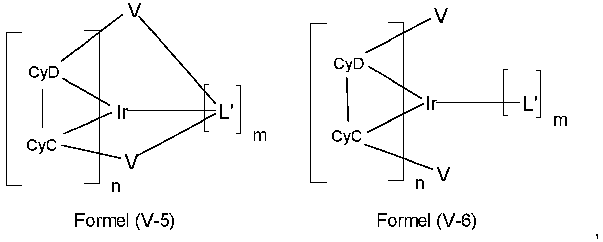 wobei die verwendeten Symbole und Indizes die oben genannten Bedeutungen aufweisen.

Ebenso können die Liganden über cyclische Gruppen gemäß der Formeln (RI-1) bis (RI-8) miteinander verbrückt sein.

Dabei stellt in den Strukturen der Formeln (V-1) bis (V-6) V bevorzugt eine Einfachbindung oder eine verbrückende Einheit dar, enthaltend 1 bis 80 Atome aus der dritten, vierten, fünften und/oder sechsten Hauptgruppe (Gruppe 13, 14, 15 oder 16 gemäß IUPAC) oder einen 3- bis 6-gliedrigen Homo- oder Heterocyclus, die die Teilliganden L miteinander oder L mit L' miteinander kovalent verbindet. Dabei kann die verbrückende Einheit V auch unsymmetrisch aufgebaut sein, d. h. die Verknüpfung von V zu L bzw. L' muss nicht identisch sein. Die verbrückende Einheit V kann neutral, einfach, zweifach oder dreifach negativ oder einfach, zweifach oder dreifach positiv geladen sein. Bevorzugt ist V neutral oder einfach negativ oder einfach positiv geladen, besonders bevorzugt neutral. Dabei wird die Ladung von V bevorzugt so gewählt, dass insgesamt ein neutraler Komplex entsteht. Dabei gelten für die Liganden die oben für die Teilstruktur MLₙ genannten Bevorzugungen und n ist bevorzugt mindestens 2.

Die genaue Struktur und chemische Zusammensetzung der Gruppe V hat keinen wesentlichen Einfluss auf die elektronischen Eigenschaften des Komplexes, da die Aufgabe dieser Gruppe im Wesentlichen darin liegt, durch die Verbrückung von L miteinander bzw. mit L' die chemische und thermische Stabilität der Komplexe zu erhöhen.

Wenn V eine trivalente Gruppe ist, also drei Liganden L miteinander bzw. zwei Liganden L mit L' oder einen Liganden L mit zwei Liganden L' verbrückt, ist V bevorzugt gleich oder verschieden bei jedem Auftreten gewählt aus der Gruppe bestehend aus B, B(R¹)⁻, B(C(R¹)₂)₃, (R¹)B(C(R¹)₂)₃⁻, B(O)₃, (R¹)B(O)₃⁻, B(C(R¹)₂C(R¹)₂)₃,
(R¹)B(C(R¹)₂C(R¹)₂)₃⁻, B(C(R¹)₂O)₃, (R¹)B(C(R¹)₂O)₃⁻, B(OC(R¹)₂)₃, (R¹)B(OC(R¹)₂)₃⁻, C(R¹), CO⁻, CN(R¹)₂, (R¹)C(C(R¹)₂)₃, (R¹)C(O)₃, (R¹)C(C(R¹)₂C(R¹)₂)₃, (R¹)C(C(R¹)₂O)₃, (R¹)C(OC(R¹)₂)₃, (R¹)C(Si(R¹)₂)₃, (R¹)C(Si(R¹)₂C(R¹)₂)₃, (R¹)C(C(R¹)₂Si(R¹)₂)₃, (R¹)C(Si(R¹)₂Si(R¹)₂)₃, Si(R¹), (R¹)Si(C(R¹)₂)₃, (R¹)Si(O)₃, (R¹)Si(C(R¹)₂C(R¹)₂)₃, (R¹)Si(OC(R¹)₂)₃, (R¹)Si(C(R¹)₂O)₃, (R¹)Si(Si(R¹)₂)₃, (R¹)Si(Si(R¹)₂C(R¹)₂)₃, (R¹)Si(C(R¹)₂Si(R¹)₂)₃, (R¹)Si(Si(R¹)2Si(R¹)₂)₃, N, NO, N(R¹)⁺, N(C(R¹)₂)₃, (R¹)N(C(R¹)₂)₃⁺, N(C=O)₃, N(C(R¹)₂C(R¹)₂)₃, (R¹)N(C(R¹)₂C(R¹)₂)⁺, P, P(R¹)⁺, PO, PS, P(O)₃, PO(O)₃, P(OC(R¹)₂)₃, PO(OC(R¹)₂)₃, P(C(R¹)₂)₃, P(R¹)(C(R¹)₂)₃⁺, PO(C(R¹)₂)₃, P(C(R¹)₂C(R¹)₂)₃, P(R¹)(C(R¹)₂C(R¹)₂)₃⁺, PO(C(R¹)₂C(R¹)₂)₃, S⁺, S(C(R¹)₂)₃⁺, S(C(R¹)₂C(R₁)²)₃⁺,
oder eine Einheit gemäß Formel (V-7) bis (V-11), 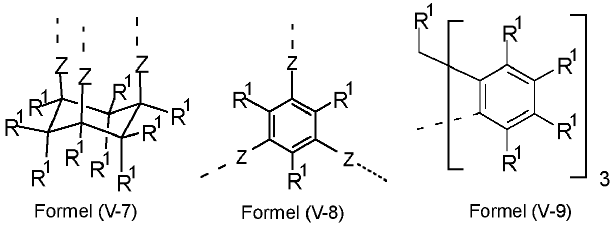 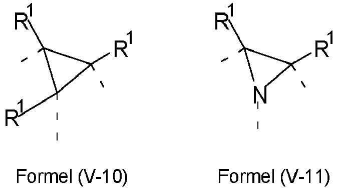 wobei die gestrichelten Bindungen jeweils die Bindung zu den Teilliganden L bzw. L' andeuten und Z gleich oder verschieden bei jedem Auftreten ausgewählt ist aus der Gruppe bestehend aus einer Einfachbindung, O, S, S(=O), S(=O)₂, NR¹, PR¹, P(=O)R¹, C(R¹)₂, C(=O), C(=NR¹), C(=C(R¹)₂), Si(R¹)₂ oder BR¹. Die weiteren verwendeten Symbole haben die oben genannten Bedeutungen.

Wenn V für eine Gruppe CR₂ steht, so können die beiden Reste R auch miteinander verknüpft sein, so dass auch Strukturen wie zum Beispiele 9,9-Fluoren geeignete Gruppen V sind.

Wenn V eine bivalente Gruppe ist, also zwei Liganden L miteinander bzw. einen Liganden L mit L' verbrückt, ist V bevorzugt gleich oder verschieden bei jedem Auftreten gewählt aus der Gruppe bestehend aus BR¹, B(R¹)₂⁻, C(R¹)₂, C(=O), Si(R¹)₂, NR¹, PR¹, P(R¹)₂⁺, P(=O)(R¹), P(=S)(R¹), O, S, Se, oder eine Einheit gemäß Formel (V-12) bis (V-21), 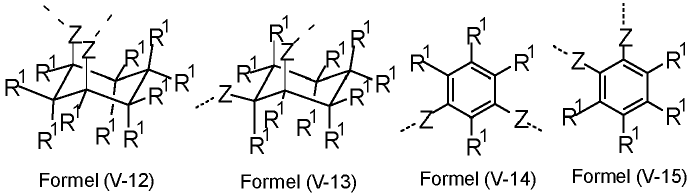 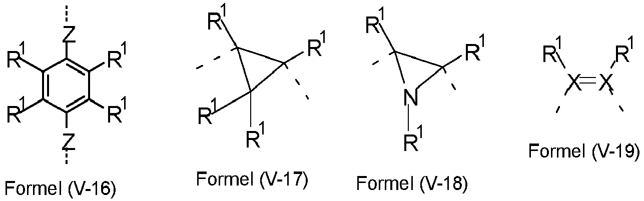 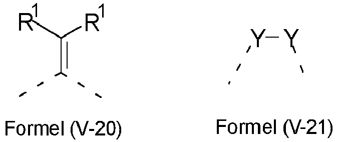 wobei die gestrichelten Bindungen jeweils die Bindung zu den Teilliganden L bzw. L' andeuten, Y bei jedem Auftreten gleich oder verschieden für C(R¹)₂, N(R¹), O oder S steht und die weiteren verwendeten Symbole jeweils die oben aufgeführten Bedeutungen haben.

In einer bevorzugten Ausführungsform entsprechen die reaktiven Metallkomplexe der allgemeinen Formel

Ir(L)ₙ(L')ₘ Formel (1a).

Dabei weisen die Komplexe mindestens eine funktionelle Gruppe auf, die in der Lage ist, mit der optisch aktiven Borverbindung zu reagieren, wobei bevorzugte funktionelle Gruppen die vorne aufgeführten Gruppen sind.

Dabei weisen die Symbole m, n und Liganden L und/oder L' die zuvor genannte Bedeutung auf und sind über eine Brücke verknüpft, wobei gegebenenfalls eine Teilstruktur der Formel (2) gebildet wird, so dass vorzugsweise ein Metallkomplex enthaltend einen hexadentaten tripodalen Liganden gebildet wird und die Liganden L und L' als drei bidentate Teilliganden angesehen werden können, die an ein Metall koordinieren. Vorzugsweise wird ein monometallischer Metallkomplex in dem erfindungsgemäßen Verfahren eingesetzt.

Die drei bidentaten Teilliganden können gleich sein, oder sie können unterschiedlich sein. Wenn alle drei bidentaten Teilliganden gleich gewählt sind, entstehen dadurch, C₃-symmetrische Metallkomplexe, wenn auch die Einheit der Formel (1) C₃-symmetrisch ist, was vorteilhaft bezüglich der Synthese der Liganden ist. Es kann aber auch vorteilhaft sein, die drei bidentaten Teilliganden unterschiedlich zu wählen bzw. zwei Teilliganden gleich und den dritten Teilliganden davon verschieden zu wählen, so dass C₁-symmetrische Metallkomplexe entstehen, weil dies größere Variationsmöglichkeiten der Liganden zulässt, so dass sich die gewünschten Eigenschaften des Komplexes, wie beispielsweise die Lage von HOMO und LUMO bzw. die Emissionsfarbe leichter variieren lassen. Außerdem lässt sich so auch die Löslichkeit der Komplexe verbessern, ohne lange aliphatische oder aromatische, löslichkeitsvermittelnde Gruppen anbringen zu müssen. Weiterhin weisen unsymmetrische Komplexe häufig eine geringere Sublimationstemperatur auf als ähnliche symmetrische Komplexe.

In einer bevorzugten Ausführungsform der Erfindung sind die drei bidentaten Teilliganden entweder gleich gewählt oder zwei der bidentaten Teilliganden sind gleich gewählt und der dritte bidentate Teilligand ist unterschiedlich von den ersten beiden bidentaten Teilliganden.

In einer bevorzugten Ausgestaltung kann vorgesehen sein, dass die Brücke, über die Liganden L und/oder L' verknüpft sind, eine Aryl- oder Heteroarylgruppe mit 5 bis 36 aromatischen Ringatomen ist, welche mit einem oder mehreren Resten R substituiert sein kann.

In einer besonders bevorzugten Ausführungsform entspricht die Brücke, über die die Liganden verknüpft sind, der Formel (3), 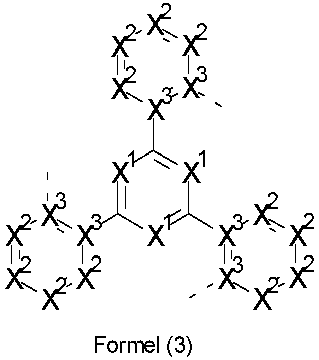 wobei die gestrichelte Bindung die Bindung der bidentaten Liganden an diese Struktur darstellt und für die verwendeten Symbole gilt:
- X¹: ist bei jedem Auftreten gleich oder verschieden C, welches auch sub-stituiert sein kann, oder N;
- X²: ist bei jedem Auftreten gleich oder verschieden C, welches auch sub-stituiert sein kann, oder N oder zwei benachbarte Gruppen X² stehen zusammen für N, welches auch substituiert sein kann, O oder S, so dass ein Fünfring entsteht; oder zwei benachbarte Gruppen X² stehen zusammen für C, welches auch substituiert sein kann, oder N, wenn in dem Cyclus eine der Gruppen X³ für N steht, so dass ein Fünfring ent-steht; mit der Maßgabe, dass maximal zwei benachbarte Gruppen X² in jedem Ring für N stehen; dabei können gegebenenfalls vorhandene Substituenten auch miteinander oder mit Substituenten, die an X¹ gebunden sind, ein Ringsystem bilden;
- X³: ist bei jedem Auftreten in einem Cyclus C oder eine Gruppe X³ steht für N und die andere Gruppe X³ in demselben Cyclus steht für C, wobei die Gruppen X³ in den drei Cyclen unabhängig voneinander gewählt werden können; mit der Maßgabe, dass zwei benachbarte Gruppen X² zusammen für C, welches auch substituiert sein kann, oder N stehen, wenn in dem Cyclus eine der Gruppen X³ für N steht;
dabei können die drei bidentaten Liganden außer durch die Brücke der Formel (3) auch durch eine weitere Brücke zu einem Kryptat geschlossen sein.

In einer weiteren bevorzugten Ausführungsform entspricht die Brücke, über die die Liganden verknüpft sind, der Formel (4), 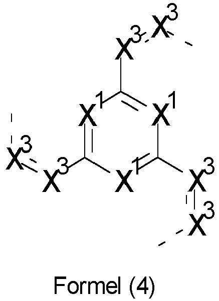 wobei die gestrichelte Bindung die Bindung der Liganden, vorzugsweise der bidentaten Liganden an diese Struktur darstellt und für die verwendeten Symbole gilt:
- X¹: ist bei jedem Auftreten gleich oder verschieden C, welches auch sub-stituiert sein kann, oder N;
- X³: ist bei jedem Auftreten gleich oder verschieden CR oder N mit der Maßgabe, dass nicht zwei Stickstoffatome direkt aneinander gebun-den sind, wobei R die oben genannten Bedeutungen aufweist;
dabei können die drei bidentaten Liganden außer durch die Brücke der Formel (4) auch durch eine weitere Brücke zu einem Kryptat geschlossen sein.

In einer weiteren bevorzugten Ausführungsform entspricht die Brücke, über die die Liganden verknüpft sind, der Formel (5), 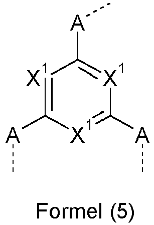 wobei die gestrichelte Bindung die Bindung der Liganden, vorzugsweise der bidentaten Liganden an diese Struktur darstellt und für die verwendeten Symbole gilt:
- X¹: ist bei jedem Auftreten gleich oder verschieden C, welches auch sub-stituiert sein kann, oder N;
- A: ist bei jedem Auftreten gleich oder verschieden gewählt aus der Gruppe bestehend aus -O-C(=O)-, -NR-C(=O)- oder -CR₂-CR₂-, wobei R die oben genannten Bedeutungen aufweist und der Rest R, der an das Stickstoffatom gebunden ist, nicht H oder D ist;
dabei können die drei bidentaten Liganden außer durch die Brücke der Formel (5) auch durch eine weitere Brücke zu einem Kryptat geschlossen sein.

In einer weiteren bevorzugten Ausführungsform entspricht die Brücke, über die die Liganden verknüpft sind, der Formel (6), (7) oder (8), 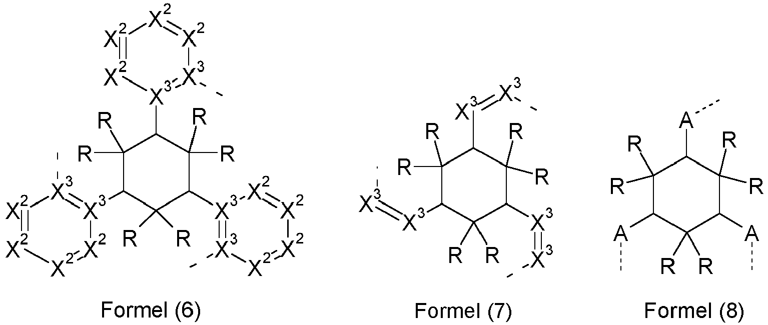 wobei die gestrichelte Bindung die Bindung der Liganden, vorzugsweise der bidentaten Liganden an diese Struktur darstellt und die verwendeten Symbole in Formel (6) die oben für Formel (3) angegebenen Bedeutungen haben und die Symbole in Formel (7) die für Formel (4) angegebenen Bedeutungen haben und die Symbole in Formel (8) die für Formel (5) angegebenen Bedeutungen haben.

Wenn X¹ oder X² für C steht, dann trägt dieses C-Atom bzw. N-Atom entweder ein Wasserstoffatom, oder es ist substituiert mit einem Substituenten ungleich Wasserstoff. Wenn zwei benachbarte Gruppen X² zusammen für N stehen und die Gruppen X³ in demselben Cyclus beide für C stehen, dann trägt dieses N-Atom entweder ein Wasserstoffatom oder es ist substituiert mit einem Substituenten ungleich Wasserstoff. Bevorzugt ist das N-Atom substituiert mit einem Substituenten ungleich Wasserstoff. Wenn zwei benachbarte Gruppen X² zusammen für N stehen und eine der Gruppen X³ in demselben Cyclus für N steht, dann ist das N-Atom, das für zwei benachbarte Gruppen X² steht, unsubstituiert. Wenn X¹ bzw. X² für ein substituiertes Kohlenstoffatom stehen bzw. wenn zwei benachbarte Gruppen X² für ein substituiertes Stickstoffatom stehen, ist der Substituent bevorzugt ausgewählt aus den Substituenten R, die zuvor, insbesondere für Formel (2) definiert sind.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können diese Reste, die miteinander ein Ringsystem bilden, benachbart sein, d.h. dass diese Reste an dasselbe Kohlenstoffatom oder an Kohlenstoffatome, die direkt aneinander gebunden sind, gebunden sind, oder sie können weiter voneinander entfernt sein. So ist beispielsweise auch die Ringbildung eines Restes R, der an der Gruppe X² gebunden ist, mit einem Rest R, der an der Gruppe X¹ gebunden ist, möglich. Wenn eine solche Ringbildung zwischen einem Rest R, der an der Gruppe X² gebunden ist, mit einem Rest R, der an der Gruppe X¹ gebunden ist, erfolgt, so erfolgt diese Ringbildung bevorzugt durch eine Gruppe mit drei Brückenatomen, bevorzugt mit drei Kohlenstoffatomen und besonders bevorzugt durch eine Gruppe -(CR₂)₃-.

Bei dem Liganden handelt es sich in einer bevorzugten Ausführungsform, die vorzugsweise eine Brücke gemäß einer der Formeln (3) bis (8) aufweisen können, somit um einen hexadentaten, tripodalen Liganden mit drei bidentaten Teilliganden. Die Struktur des hexadentaten, tripodalen Liganden wird schematisch durch die folgende Formel (Lig) dargestellt: 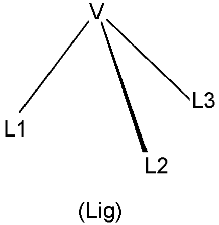 wobei V die Brücke, vorzugsweise eine Brücke gemäß einer der Formeln (3) bis (8) darstellt und L1, L2 und L3 gleich oder verschieden bei jedem Auftreten jeweils bidentate Teilliganden darstellen. Dabei bedeutet bidentat, dass der jeweilige Teilligand im Komplex über zwei Koordinationsstellen an das Metall koordiniert bzw. bindet. Tripodal bedeutet, dass der Ligand drei Teilliganden aufweist, die an die Brücke V, vorzugsweise die Brücke der Formel (3) gebunden sind. Da der Ligand drei bidentate Teilliganden aufweist, ergibt sich insgesamt ein hexadentater Ligand, also ein Ligand, der über sechs Koordinationsstellen an das Metall koordiniert bzw. bindet. Der Begriff "bidentater Teilligand" bedeutet im Sinne dieser Anmeldung, dass es sich bei dieser Einheit um einen bidentaten Liganden handeln würde, wenn die Brücke der Formel (3) bis (8) nicht vorhanden wäre. Durch die formale Abstraktion eines Wasserstoffatoms an diesem bidentaten Liganden und die Anknüpfung an die Brücke der Formel (3) bis (8) ist dieser jedoch kein separater Ligand mehr, sondern ein Teil des so entstehenden hexadentaten Liganden, so dass hierfür der Begriff "Teilligand" verwendet wird.

Der mit diesem Liganden der Formel (Lig) gebildete Metallkomplex Ir-(Lig) kann somit schematisch durch die folgende Formel dargestellt werden: 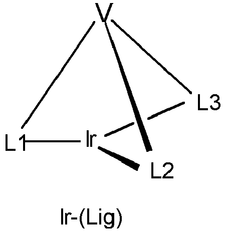 wobei V die Brücke, vorzugsweise eine Brücke gemäß Formel (3) darstellt, L1, L2 und L3 gleich oder verschieden bei jedem Auftreten jeweils bidentate Teilliganden darstellen und Ir für Iridium steht.

Im Folgenden werden bevorzugte Ausführungsformen der Brücke der Formel (3) bis (8) ausgeführt.

Wenn X¹ bzw. X² für ein substituiertes Kohlenstoffatom stehen bzw. wenn zwei benachbarte Gruppen X² für ein substituiertes Stickstoffatom stehen, dann ist der Substituent bevorzugt ausgewählt aus den folgenden Substituenten R:
- R: ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, C(=O)OR¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substi-tuiert sein kann, oder eine Aryloxy- oder Heteroaryloxygruppe mit 5 bis 40 aromatischen Ringatomen, die durch einen oder mehrere Reste R¹ substituiert sein kann; dabei können zwei Reste R auch miteinander ein Ringsystem bilden;

- R¹: ist bei jedem Auftreten gleich oder verschieden H, D, F, Cl, Br, I, N(R²)₂, CN, NO₂, Si(R²)₃, B(OR²)₂, C(=O)R², C(=O)OR², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinyl-gruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ring-system mit 5 bis 40 aromatischen Ringatomen, das jeweils durch einen oder mehrere Reste R² substituiert sein kann, oder eine Aryl-oxy- oder Heteroaryloxygruppe mit 5 bis 40 aromatischen Ring-atomen, die durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können.

Geeignete Ausführungsformen der Gruppe der Formel (3) bzw. (4) sind die Strukturen der folgenden Formeln (3-1) bis (3-4) oder (4-1) bis (4-4), 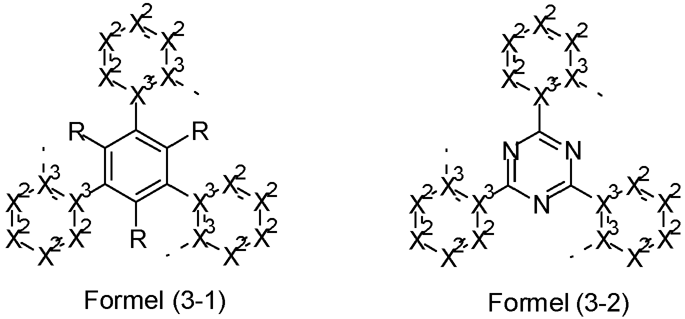 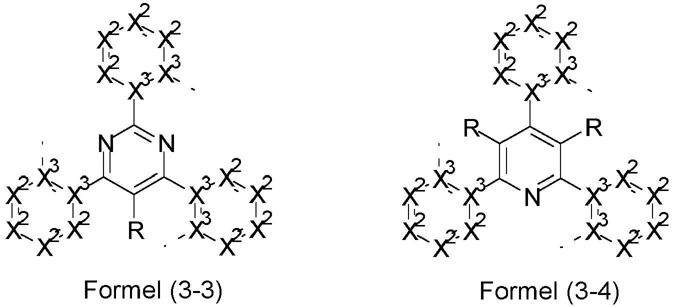 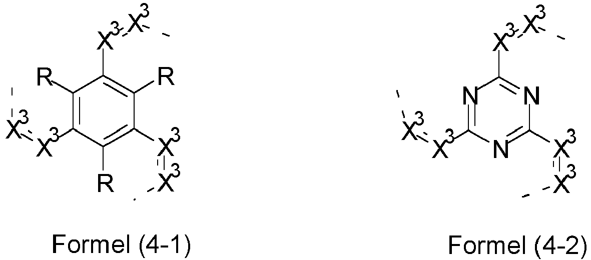 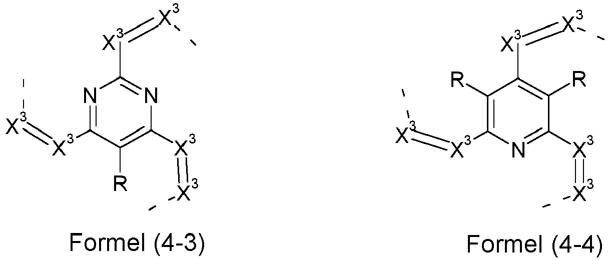 wobei die verwendeten Symbole die oben genannten Bedeutungen aufweisen.

In einer bevorzugten Ausführungsform der Erfindung stehen entweder alle Gruppen X¹ in der Gruppe der Formel (3), (4) oder (5) für ein gegebenenfalls substituiertes Kohlenstoffatom, wobei der Substituent bevorzugt ausgewählt ist aus den oben genannten Gruppen R, so dass der zentrale trivalente Cyclus der Formel (3), (4) oder (5) ein Benzol darstellt. Besonders bevorzugt stehen alle Gruppen X¹ für CH. In einer weiteren bevorzugten Ausführungsform der Erfindung stehen alle Gruppen X¹ für ein Stickstoffatom, so dass der zentrale trivalente Cyclus der Formel (3), (4) oder (5) ein Triazin darstellt. Bevorzugte Ausführungsformen der Formel (3) oder (4) sind somit die Strukturen der Formeln (3-1) oder (4-1).

Besonders bevorzugt ist die Struktur der Formel (3-1), (4-1) oder (5) eine Struktur der folgenden Formel (3-1'), (4-1') oder (5-1'), 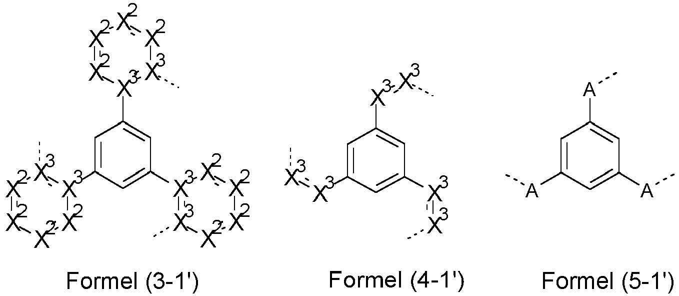 wobei die verwendeten Symbole die oben genannten Bedeutungen aufweisen.

Ferner kann vorgesehen sein, dass die Substituenten R, die in den Strukturen der Formeln (3) bis (8) bzw. deren bevorzugten Ausgestaltungen enthalten sein können, eine Ringstruktur der zuvor näher ausgeführten Formeln (RI-1) bis (RI-8) oder deren bevorzugten Ausführungsformen bilden.

Für bevorzugte Reste R am trivalenten zentralen Benzolring der Formel (3-1) oder (4-1) gilt:
- R: ist bei jedem Auftreten gleich oder verschieden H, D, F, CN, eine geradkettige Alkyl- oder Alkoxygruppe mit 1 bis 10 C-Atomen oder eine Alkenylgruppe mit 2 bis 10 C-Atomen oder eine verzweigte oder cyclische Alkyl- oder Alkoxygruppe mit 3 bis 10 C-Atomen, die jeweils mit einem oder mehreren Resten R¹ substituiert sein kann, oder ein aromatisches oder heteroaromatisches Ringsystem mit 5 bis 24 aromatischen Ringatomen, das jeweils durch einen oder mehrere Reste R¹ substituiert sein kann; dabei kann der Rest R auch mit einem Rest R an X² ein Ringsystem bilden;
- R¹: ist bei jedem Auftreten gleich oder verschieden H, D, F, CN, eine geradkettige Alkyl- oder Alkoxygruppe mit 1 bis 10 C-Atomen oder eine Alkenylgruppe mit 2 bis 10 C-Atomen oder eine verzweigte oder cyclische Alkyl- oder Alkoxygruppe mit 3 bis 10 C-Atomen, die jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können.

Für besonders bevorzugte Reste R am trivalenten zentralen Benzolring der Formel (3-1) oder (4-1) gilt:
- R: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R¹ substituiert sein kann, oder ein aromatisches oder heteroaromatisches Ringsystem mit 6 bis 12 aromatischen Ringatomen, das jeweils durch einen oder mehrere Reste R¹ substituiert sein kann; dabei kann der Rest R auch mit einem Rest R an X² ein Ringsystem bilden;
- R¹: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R² substituiert sein kann, oder ein aromatisches oder heteroaromatisches Ringsystem mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer oder aromatischer Kohlenwasserstoffrest mit 1 bis 12 C-Atomen.
Im Folgenden werden bevorzugte bivalente Arylen- bzw. Heteroaryleneinheiten beschrieben, wie sie in den Strukturen der Formeln (3), vorzugsweise (3-1) bis (3-4), und (6) vorkommen. Wie aus den Strukturen der Formeln (3), vorzugsweise (3-1) bis (3-4), und (6) ersichtlich, enthalten diese Strukturen drei ortho-verknüpfte bivalente Arylen- bzw. Heteroaryleneinheiten.

In einer bevorzugten Ausführungsform der Erfindung steht das Symbol X³ in den Formeln (3), (4), (6) und (7) für C, so dass die Gruppen der Formeln (3), vorzugsweise (3-1) bis (3-4), durch die folgenden Formeln (3-a), vorzugsweise (3-1a) bis (3-4a), und (4-a), vorzugsweise (4-1a) bis (4-4a), (6-a) und (7-a) dargestellt werden können: 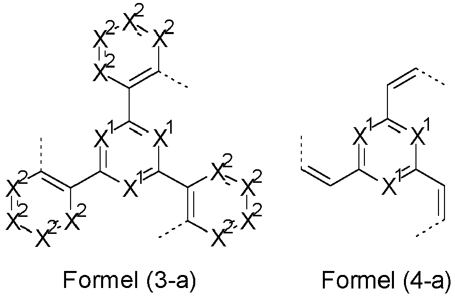 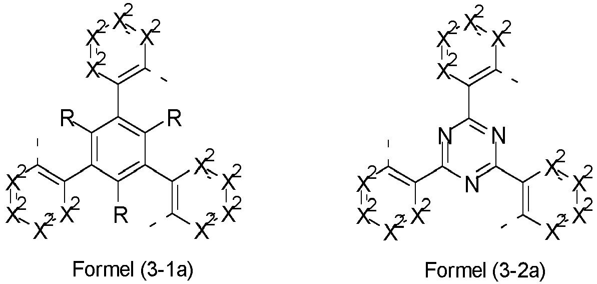 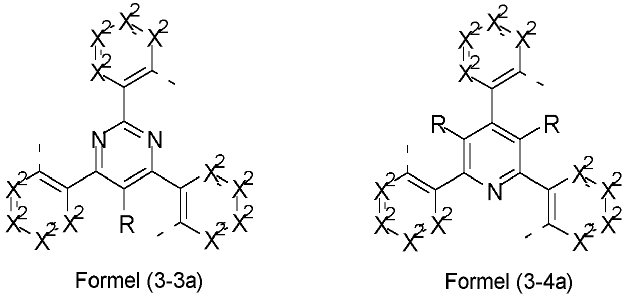 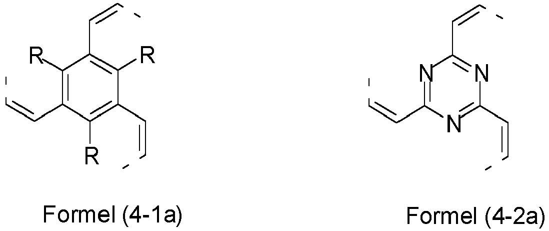 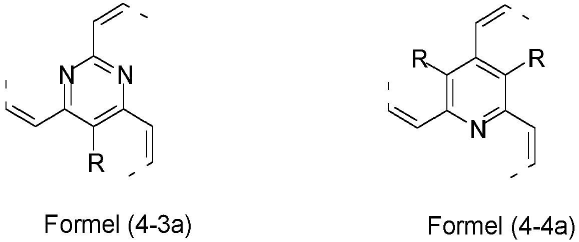 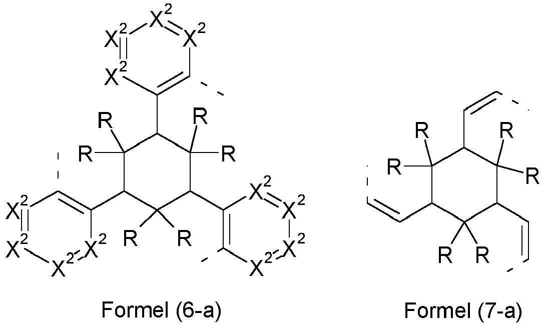 wobei die Symbole die oben aufgeführten Bedeutungen aufweisen.

Die Einheit der Formel (3) kann auch formal durch die folgende Formel (3') dargestellt werden, wobei die Formeln (3) und (3') dieselben Strukturen umfassen: 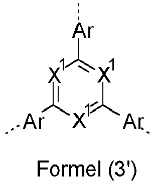 wobei Ar jeweils gleich oder verschieden für eine Gruppe der folgenden Formel (BA) steht: 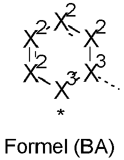 wobei die gestrichelte Bindung jeweils die Position der Bindung der bidentaten Teilliganden an diese Struktur darstellt, * die Position der Verknüpfung der Einheit der Formel (BA) mit der zentralen trivalenten Aryl- bzw. Heteroarylgruppe darstellt und X² die oben genannten Bedeutungen aufweist. Dabei sind bevorzugte Substituenten an der Gruppe der Formel (BA) ausgewählt aus den oben beschriebenen Substituenten R.

Die Gruppe der Formel (BA) kann somit einen heteroaromatischen Fünfring oder einen aromatischen oder heteroaromatischen Sechsring darstellen. In einer bevorzugten Ausführungsform der Erfindung enthält die Gruppe der Formel (BA) maximal zwei Heteroatome in der aromatischen bzw. heteroaromatischen Einheit, besonders bevorzugt maximal ein Heteroatom. Dies schließt nicht aus, dass Substituenten, die gegebenenfalls an dieser Gruppe gebunden sind, auch Heteroatome enthalten können. Weiterhin schließt diese Definition nicht aus, dass durch die Ringbildung von Substituenten kondensierte aromatische oder heteroaromatische Strukturen entstehen, wie beispielsweise Naphthalin, Benzimidazol, etc.. Die Gruppe der Formel (BA) ist somit bevorzugt ausgewählt aus Benzol, Pyridin, Pyrimidin, Pyrazin, Pyridazin, Pyrrol, Furan, Thiophen, Pyrazol, Imidazol, Oxazol und Thiazol.

Wenn beide Gruppen X³ in einem Cyclus für Kohlenstoffatome stehen, sind bevorzugte Ausführungsformen der Gruppe der Formel (BA) die Strukturen der folgenden Formeln (BA-1) bis (BA-17), 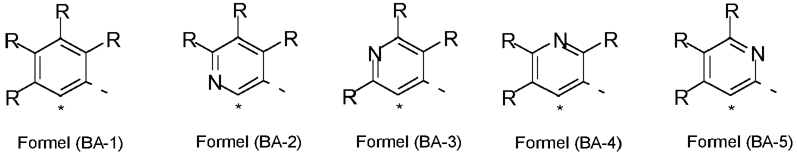 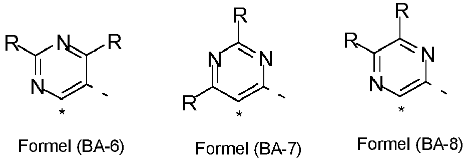 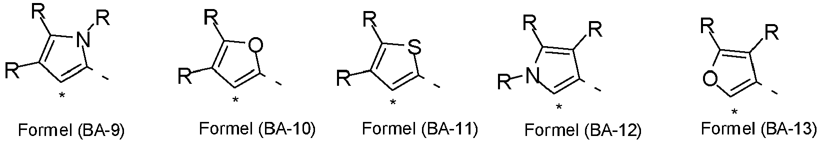 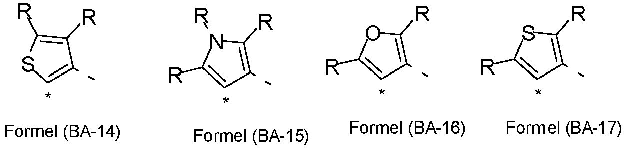 wobei die verwendeten Symbole die oben genannten Bedeutungen aufweisen.

Wenn eine Gruppe X³ in einem Cyclus für ein Kohlenstoffatom und die andere Grupp X³ in demselben Cyclus für ein Stickstoffatom steht, sind bevorzugte Ausführungsformen der Gruppe der Formel (BA) die Strukturen der folgenden Formeln (BA-18) bis (BA-25), 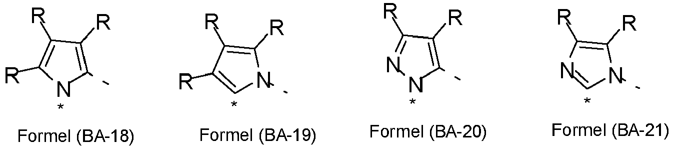 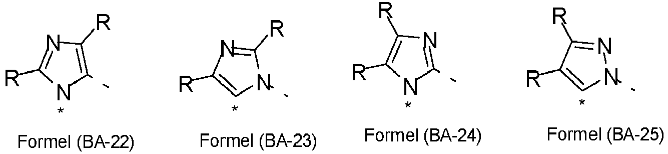 wobei die verwendeten Symbole die oben genannten Bedeutungen aufweisen.

Besonders bevorzugt sind die gegebenenfalls substituierten Sechsring-Aromaten und Sechsring-Heteroaromaten der oben abgebildeten Formeln (BA-1) bis (BA-5). Ganz besonders bevorzugt ist ortho-Phenylen, also eine Gruppe der oben genannten Formel (BA-1).

Dabei können, wie auch oben bei der Beschreibung des Substituenten beschrieben, auch benachbarte Substituenten miteinander ein Ringsystem bilden, so dass kondensierte Strukturen, auch kondensierte Aryl- und Heteroarylgruppen, wie beispielsweise Naphthalin, Chinolin, Benzimidazol, Carbazol, Dibenzofuran oder Dibenzothiophen, entstehen können. Eine solche Ringbildung ist im Folgenden schematisch an Gruppen der oben genannten Formel (BA-1) aufgeführt, was zu Gruppen der folgenden Formeln (BA-1a) bis (BA-1j) führt: 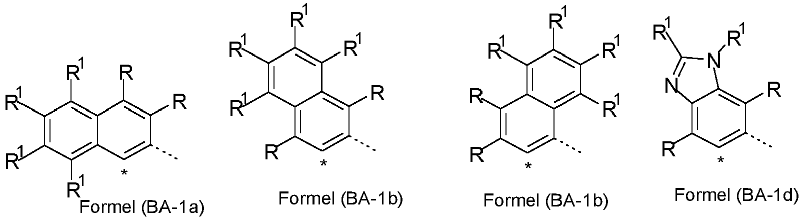 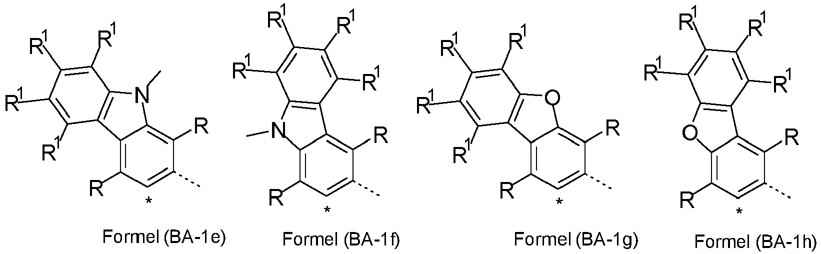 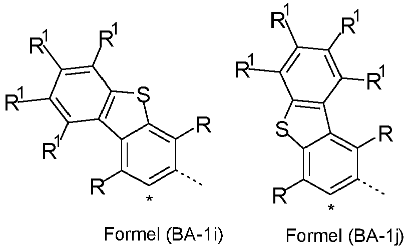 wobei die verwendeten Symbole die oben genannten Bedeutungen aufweisen.

Generell können die ankondensierten Gruppen an jeder Position der Einheit gemäß Formel (BA) ankondensiert sein, wie durch die ankondensierte Benzogruppe in den Formeln (BA-1a) bis (BA-1c) dargestellt. Die Gruppen, wie sie in den Formeln (BA-1d) bis (BA-1j) an die Einheit der Formel (BA) ankondensiert sind, können daher auch an andere Positionen der Einheit der Formel (BA) ankondensiert werden.

Dabei können die drei Gruppen der Formel (BA), die in der Einheit der Formeln (3), (3-1) bis (3-4) oder ganz analog auch in Formel (6) vorhanden sind, gleich oder verschieden sein. In einer bevorzugten Ausführungsform der Erfindung sind alle drei Gruppen der Formel (BA) in der Einheit der Formeln (3), (3-1) bis (3-4) gleich und sind auch gleich substituiert.

Besonders bevorzugt sind die Gruppen der Formel (3-1) bis (3-4) ausgewählt aus den Gruppen der folgenden Formeln (3-1b) bis (3-4b), 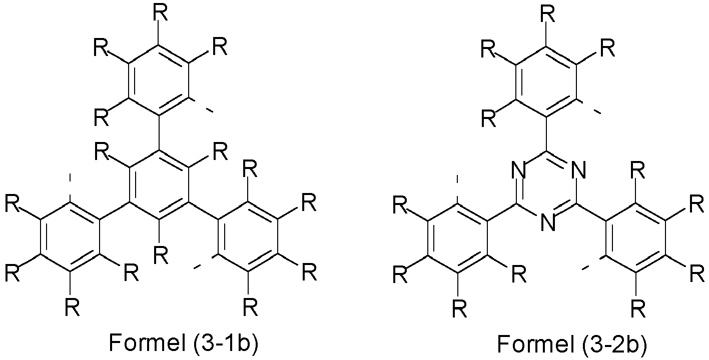 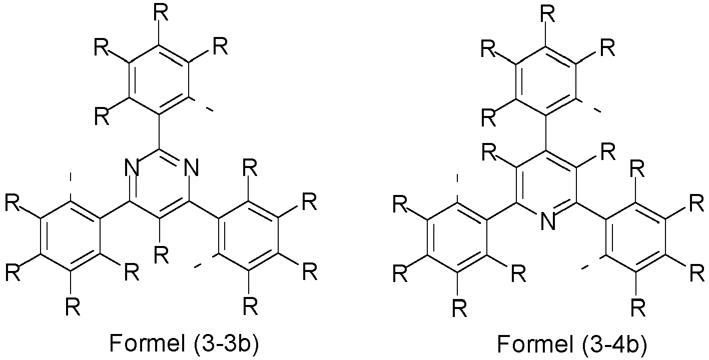 wobei die verwendeten Symbole die oben genannten Bedeutungen aufweisen.

Eine bevorzugte Ausführungsform der Formel (3-1b) ist die Gruppe der folgenden Formel (3-1b'), 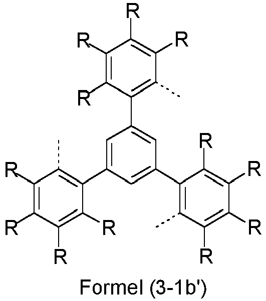 wobei die verwendeten Symbole die oben genannten Bedeutungen aufweisen.

Besonders bevorzugt sind die Gruppen R in den Formeln (3), (3-1) bis (3-4) gleich oder verschieden H, D oder eine Alkylgruppe mit 1 bis 4 C-Atomen. Ganz besonders bevorzugt ist R = H. Ganz besonders bevorzugt sind also die Strukturen der folgenden Formeln (3-1c) bis (3-2c), 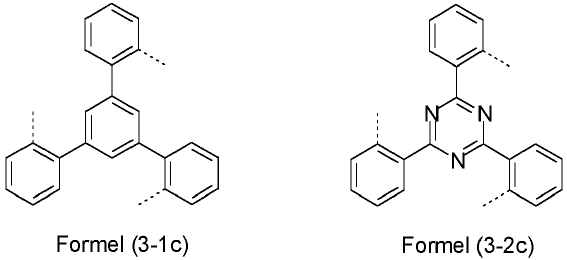 wobei die verwendeten Symbole die oben genannten Bedeutungen aufweisen.

Wenn in den bidentaten Teilliganden bzw. in den bivalenten Arylen- bzw. Heteroarylengruppen der Formel (BA), welche in den Formeln (3), vorzugsweise (3-1) bis (3-4), oder den bevorzugten Ausführungsformen gebunden sind, Reste R gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹, die an R gebunden sind, sind bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Im Folgenden werden bevorzugte Liganden L' beschrieben, wie sie in Formel (1) enthalten sein können. Entsprechend können auch die Ligandengruppen L' gewählt sein, wenn diese über eine Brücke, beispielsweise eine Gruppe der Formel (3) beziehungsweise (4) oder verbrückende Einheit V an L gebunden sind, wie in Formeln (V-1), (V-2) und (V-3) angedeutet.

Die Liganden L' sind bevorzugt neutrale, monoanionische, dianionische oder trianionische Liganden, besonders bevorzugt neutrale oder monoanionische Liganden. Sie können monodentat, bidentat, tridentat oder tetradentat sein und sind bevorzugt bidentat, weisen also bevorzugt zwei Koordinationsstellen auf. Wie oben beschrieben, können die Liganden L' auch über eine Brücke, beispielsweise eine Gruppe der Formel (3) beziehungsweise (4) oder verbrückende Einheit V an L gebunden sein.

Bevorzugte neutrale, monodentate Liganden L' sind ausgewählt aus der Gruppe bestehend aus Kohlenmonoxid, Stickstoffmonoxid, Alkylcyaniden, wie z. B. Acetonitril, Arylcyaniden, wie z. B. Benzonitril, Alkylisocyaniden, wie z. B. Methylisonitril, Arylisocyaniden, wie z. B. Benzoisonitril, Aminen, wie z. B. Trimethylamin, Triethylamin, Morpholin, Phosphinen, insbesondere Halogenphosphine, Trialkylphosphine, Triarylphosphine oder Alkylarylphosphine, wie z. B. Trifluorphosphin, Trimethylphosphin, Tricyclohexylphosphin, Tri-*tert*-butylphosphin, Triphenylphosphin, Tris(pentafluorphenyl)phosphin, Dimethylphenylphosphin, Methyldiphenylphosphin, Bis(tert-butyl)phenylphosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsin, Tris(pentafluorphenyl)arsin, Stibinen, wie z. B. Trifluorstibin, Trimethylstibin, Tricyclohexylstibin, Tri-*tert*-butylstibin, Triphenylstibin, Tris(pentafluorphenyl)stibin, stickstoffhaltigen Heterocyclen, wie z. B. Pyridin, Pyridazin, Pyrazin, Pyrimidin, Triazin, und Carbenen, insbesondere Arduengo-Carbenen.

Bevorzugte monoanionische, monodentate Liganden L' sind ausgewählt aus Hydrid, Deuterid, den Halogeniden F⁻, Cl⁻, Br⁻ und I⁻, Alkylacetyliden, wie z. B. Methyl-C≡C-, tert-Butyl-C≡C⁻, Arylacetyliden, wie z. B. Phenyl-C≡C⁻, Cyanid, Cyanat, Isocyanat, Thiocyanat, Isothiocyanat, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, Arylgruppen, wie z. B. Phenyl, Naphthyl, und anionischen, stickstoffhaltigen Heterocyclen, wie Pyrrolid, Imidazolid, Pyrazolid. Dabei sind die Alkylgruppen in diesen Gruppen bevorzugt C₁-C₂₀-Alkylgruppen, besonders bevorzugt C₁-C₁₀-Alkylgruppen, ganz besonders bevorzugt C₁-C₄-Alkylgruppen. Unter einer Arylgruppe werden auch Heteroarylgruppen verstanden. Diese Gruppen sind wie oben definiert.

Bevorzugte di- bzw. trianionische Liganden sind O²⁻, S²⁻, Carbide, welche zu einer Koordination der Form R-C≡M führen, und Nitrene, welche zu einer Koordination der Form R-N=M führen, wobei R allgemein für einen Substituenten steht, oder N³⁻.

Bevorzugte neutrale oder mono- oder dianionische, bidentate oder höherdentate Liganden L' sind ausgewählt aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2-[1-(Phenylimino)ethyl]pyridin, 2-[1-(2-Methylphenylimino)ethyl]pyridin, 2-[1-(2,6-Di-*iso*-propylphenylimino)ethyl]pyridin, 2-[1-(Methylimino)ethyl]pyridin, 2-[1-(ethylimino)ethyl]pyridin, 2-[1-(*Iso*-Propylimino)ethyl]pyridin, 2-[1-(*Tert*-Butylimino)ethyl]pyridin, Diiminen, wie z. B. 1,2-Bis(methylimino)-ethan, 1,2-Bis(ethylimino)ethan, 1,2-Bis(*iso*-propylimino)ethan, 1,2-Bis-(*tert*-butylimino)ethan, 2,3-Bis(methylimino)butan, 2,3-Bis(ethylimino)-butan, 2,3-Bis(*iso*-propylimino)butan, 2,3-Bis(*tert*-butylimino)butan, 1,2-Bis(phenylimino)ethan, 1,2-Bis(2-methylphenylimino)ethan, 1,2-Bis-(2,6-di-*iso*-propylphenylimino)ethan, 1,2-Bis(2,6-di-*tert*-butylphenylimino)-ethan, 2,3-Bis(phenylimino)butan, 2,3-Bis(2-methylphenylimino)butan, 2,3-Bis(2,6-di-*iso*-propylphenylimino)butan, 2,3-Bis(2,6-di-*tert*-butylphenylimino)butan, Heterocyclen enthaltend zwei Stickstoffatome, wie z. B. 2,2'-Bipyridin, o-Phenanthrolin, Diphosphinen, wie z. B. Bis(diphenylphosphino)methan, Bis(diphenylphosphino)ethan, Bis(diphenylphosphino)-propan, Bis(diphenylphosphino)butan, Bis(dimethylphosphino)methan, Bis(dimethylphosphino)ethan, Bis(dimethylphosphino)propan, Bis(diethylphosphino)methan, Bis(diethylphosphino)ethan, Bis(diethylphosphino)-propan, Bis(di-*tert*-butylphosphino)methan, Bis(di-*tert*-butylphosphino)-ethan, Bis(*tert*-butylphosphino)propan, 1,3-Diketonaten abgeleitet von 1,3-Diketonen, wie z. B. Acetylaceton, Benzoylaceton, 1,5-Diphenylacetylaceton, Dibenzoylmethan, Bis(1,1,1-trifluoracetyl)methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethylglycin, Alanin, N,N-Dimethyl-aminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol, Dithiolaten abgeleitet von Dithiolen, wie z. B. 1,2-Ethylendithiol, 1,3-Propylendithiol, Bis(pyrazolylboraten), Bis(imidazolyl)boraten, 3-(2-Pyridyl)-diazolen oder 3-(2-Pyridyl)-triazolen.

Bevorzugte tridentate Liganden sind Borate stickstoffhaltiger Heterocyclen, wie z. B. Tetrakis(1-imidazolyl)borat und Tetrakis(1-pyrazolyl)borat.

Bevorzugt sind weiterhin bidentate monoanionische, neutrale oder dianionische Liganden L', insbesondere monoanionische Liganden, welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein im Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand L' für Verbindungen gemäß Formel (1) auswählen. Generell eignet sich dafür besonders die Kombination aus zwei Gruppen, wie sie durch die folgenden Formeln (LT'-1) bis (LT'-25) dargestellt sind, wobei eine Gruppe bevorzugt über ein neutrales Stickstoffatom oder ein Carbenkohlenstoffatom bindet und die andere Gruppe bevorzugt über ein negativ geladenes Kohlenstoffatom oder ein negativ geladenes Stickstoffatom bindet. Der Ligand L' kann dann aus den Gruppen der Formeln (LT'-1) bis (LT'-25) gebildet werden, indem diese Gruppen jeweils an der durch # gekennzeichneten Position aneinander binden. Die Position, an der die Gruppen an das Metall koordinieren, sind durch * gekennzeichnet. Diese Gruppen können auch über eine oder zwei verbrückende Einheiten V an den Liganden L gebunden sein.

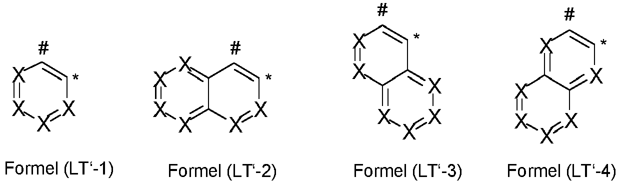

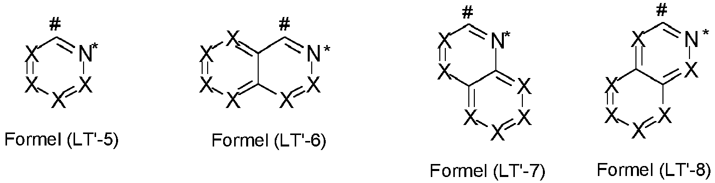

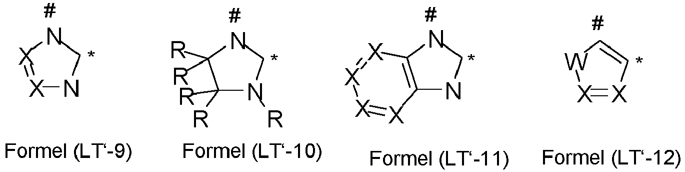

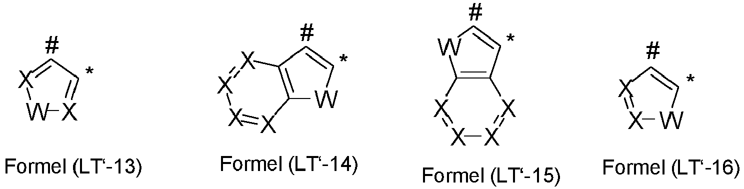

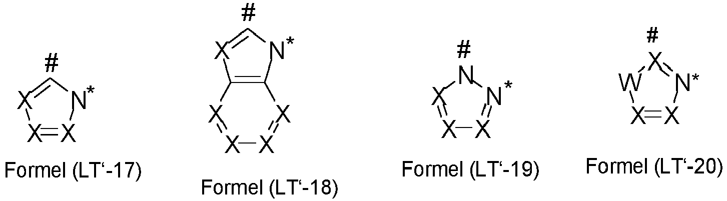

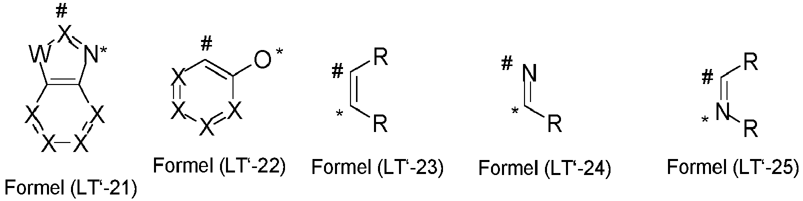

Dabei hat W die oben genannte Bedeutung und X steht bei jedem Auftreten gleich oder verschieden für CR oder N, wobei R dieselbe Bedeutung hat wie oben beschrieben. Bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X für CR.

Ebenfalls bevorzugte Liganden L' sind η⁵-Cyclopentadienyl, η⁵-Pentamethylcyclopentadienyl, η⁶-Benzol oder η⁷-Cycloheptatrienyl, welche jeweils durch einen oder mehrere Reste R substituiert sein können. Bevorzugte Reste R in den oben aufgeführten Strukturen sind bei jedem Auftreten gleich oder verschieden ausgewählt aus der Gruppe bestehend aus H, D, F, Br, N(R¹)₂, CN, B(OR¹)₂, C(=O)R¹, P(=O)(R¹)₂, einer geradkettigen Alkylgruppe mit 1 bis 10 C-Atomen oder einer Alkenyl- oder Alkinylgruppe mit 2 bis 10 C-Atomen oder einer verzweigten oder cyclischen Alkylgruppe mit 3 bis 10 C-Atomen, die jeweils mit einem oder mehreren Resten R¹ substituiert sein kann, wobei ein oder mehrere H-Atome durch D oder F ersetzt sein können, oder einem aromatischen oder heteroaromatischen Ringsystem mit 5 bis 14 aromatischen Ringatomen, das jeweils durch einen oder mehrere Reste R¹ substituiert sein kann; dabei können zwei oder mehrere benachbarte Reste R auch miteinander ein mono- oder polycyclisches, aliphatisches, aromatisches und/oder benzoannelliertes Ringsystem bilden. Besonders bevorzugte Reste R sind bei jedem Auftreten gleich oder verschieden ausgewählt aus der Gruppe bestehend aus H, D, F, Br, CN, B(OR¹)₂, einer geradkettigen Alkylgruppe mit 1 bis 5 C-Atomen, insbesondere Methyl, oder einer verzweigten oder cyclischen Alkylgruppe mit 3 bis 5 C-Atomen, insbesondere iso-Propyl oder tert-Butyl, wobei ein oder mehrere H-Atome durch D oder F ersetzt sein können, oder einem aromatischen oder heteroaromatischen Ringsystem mit 5 bis 12 aromatischen Ringatomen, das jeweils durch einen oder mehrere Reste R¹ substituiert sein kann; dabei können zwei oder mehrere Reste R auch miteinander ein mono- oder polycyclisches, aliphatisches, aromatisches und/oder benzoannelliertes Ringsystem bilden.

In einer bevorzugten Ausführungsform der Erfindung koordiniert L' über eine oder mehrere aromatische bzw. heteroaromatische Gruppen an das Metallatom, vorzugsweise Ir, aber koordiniert nicht über nicht-aromatische und nicht-heteroaromatische Gruppen.

Die erfindungsgemäß einzusetzenden oder erhältlichen Komplexe können facial bzw. pseudofacial sein, oder sie können meridional bzw. pseudomeridional sein.

Die Liganden L können je nach Struktur auch chiral sein. Dies ist beispielsweise dann der Fall, wenn in der Struktur der Formel (RI-4) die Gruppen A⁶ und A⁷ unterschiedlich sind oder wenn sie Substituenten enthalten, beispielsweise Alkyl-, Alkoxy, Dialkylamino- oder Aralkylgruppen, welche ein oder mehrere Stereozentren aufweisen. Da es sich bei der Grundstruktur des Komplexes auch um eine chirale Struktur handeln kann, ist die Bildung von Diastereomeren und mehreren Enantiomerenpaaren möglich. Die erfindungsgemäß einzusetzenden Komplexe umfassen dann sowohl die Mischungen der verschiedenen Diastereomere bzw. die entsprechenden Racemate wie auch die einzelnen isolierten Diastereomere bzw. Enantiomere.

Die erfindungsgemäß einzusetzenden reaktiven Metallkomplexe sind prinzipiell durch verschiedene Verfahren darstellbar. Generell wird hierzu ein Metallsalz mit dem entsprechenden freien Liganden umgesetzt.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht. Die Synthese der einzusetzenden Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bisphenoxybenzol, Triphenylphosphinoxid, 18-Krone-6, Phenol, 1-Naphthol, Hydrochinon, etc.. Dabei ist die Verwendung von Hydrochinon besonders bevorzugt.

Die einzusetzenden Metallkomplexe sind reaktiv, so dass diese mit einer Borverbindung umgesetzt werden können, wobei die reaktiven Metallkomplexe als reaktive Gruppe eine Abgangsgruppe umfassen, die vorzugsweise ausgewählt ist aus Halogen, besonders bevorzugt Cl oder Br. Die Halogenierung derartiger Komplexe ist beispielsweise in WO 2002/068435 beschrieben. Dementsprechend können Liganden zur Herstellung der einzusetzenden Metallkomplexe diese reaktiven Gruppen aufweisen oder die gemäß den zuvor dargestellten Methoden hergestellten Komplexe können beispielsweise durch Halogenierung in reaktive Metallkomplexe überführt werden. Je nach vorgesehener Umsetzungsmethode des reaktiven Metallkomplexes mit der chiralen Borverbindung können die halogenierten Metallkomplexe über die Umsetzung mit Metallen oder metallorganischen Verbindungen, beispielsweise t-Butyllithium, in Metallkomplexe mit einer metallorganischen reaktiven Gruppe überführt werden. Hierzu finden sich in den Beispielen weitere wertvolle Hinweise für den Fachmann, ohne dass hierdurch eine Begrenzung der Erfindung erfolgen soll.

Durch diese Verfahren, gegebenenfalls gefolgt von Aufreinigung, wie z. B. Chromatographie, Umkristallisation oder Sublimation, lassen sich die erfindungsgemäß einsetzbaren Verbindungen gemäß Formel (1) in hoher Reinheit, bevorzugt mehr als 99 % (bestimmt mittels ¹H-NMR und/oder HPLC) erhalten.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Bei bevorzugten reaktiven Metallkomplexen handelt es sich um chirale Strukturen.

Die zuvor dargelegten reaktiven Metallkomplexe werden in Schritt B) mit einer optisch aktiven Borverbindung unter Erhalt einer DiastereomerenMischung umgesetzt. Der Ausdruck optisch aktiv bedeutet, dass eine Verbindung mindestens ein Chiralitätszentrum aufweist und diese Verbindung nicht als Racemat vorliegt. Dabei wird, wie oben beschrieben, eine optisch aktive Borverbindungen gemäß Formel (BE-1) eingesetzt: 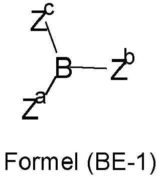 wobei die Symbole die oben genannten Bedeutungen aufweisen.

Die Art des Rests Z^{a} kann insbesondere gemäß der zur Erhalt einer Diastereomerenmischung durchgeführten Reaktion gewählt werden. So kann beispielsweise der Metallkomplex mit einer metallorganischen Verbindung, unter anderem t-Butyllithium umgesetzt werden, um einen reaktiven Metallkomplex zu erhalten. Reaktive Metallkomplexe, die eine nukleophile Gruppe aufweisen, können bevorzugt mit einem Borelektrophil umgesetzt werden, so dass in diesem Fall die Gruppe Z^{a} bevorzugt ausgewählt ist aus OR oder Halogen, besonders bevorzugt OR, Fluor, Chlor oder Brom, wobei R die zuvor genannte Bedeutung aufweist.

In einer besonders bevorzugten Ausführungsform kann die Umsetzung des reaktiven Metallkomplexes mit einer chiralen Borverbindung durch ein Übergangsmetall, beispielsweise Palladium, katalysiert werden. In diesem Fall umfasst die chirale Borverbindung vorzugsweise eine Gruppe Z^{a}, die ausgewählt ist aus H, D, B(R)₂, wobei R die zuvor genannte Bedeutung aufweist.

In einer weiteren bevorzugten Ausgestaltung des erfindungsgemäßen Verfahren ist die optisch aktive Borverbindung eine Borverbindung gemäß Formel (BE-2) oder (BE-3), 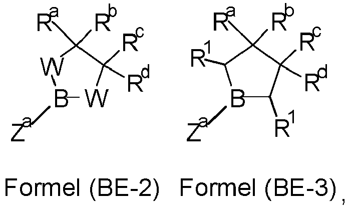 wobei Z^{a} die zuvor genannte Bedeutung aufweist und die weiteren Symbole die folgende Bedeutung aufweisen:
- W: ist bei jedem Auftreten gleich oder verschieden NR, O oder S, vorzugsweise NR oder O und besonders bevorzugt O;
- R^{a}, R^{b}, R^{c}, R^{d}: ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, C(=O)OR¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thio-alkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können, oder ein aromatisches oder heteroaromatisches Ringsystem mit 5 bis 40 aromatischen Ring-atomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann; dabei können zwei Reste R^{a}, R^{b}, R^{c}, R^{d} und/oder R¹ auch miteinander ein Ringsystem bilden;
- R, R¹: weist die zuvor genannte Bedeutung auf.

Für bevorzugte Reste R, R^{a}, R^{b}, R^{c}, R^{d} in den Formeln (BE-1), (BE-2) und (BE-3) gilt:
- R, R^{a}, R^{b}, R^{c}, R^{d}: ist bei jedem Auftreten gleich oder verschieden H, D, F, C(=O)OR¹, eine geradkettige Alkyl- oder Alkoxygruppe mit 1 bis 10 C-Atomen oder eine Alkenylgruppe mit 2 bis 10 C-Atomen oder eine verzweigte oder cyclische Alkyl- oder Alkoxygruppe mit 3 bis 10 C-Atomen, die jeweils mit einem oder mehreren Resten R¹ substituiert sein kann, oder ein aromatisches oder heteroaromatisches Ring-system mit 5 bis 24 aromatischen Ringatomen, das jeweils durch einen oder mehrere Reste R¹ substituiert sein kann; dabei können zwei Rest R oder ein Rest R mit einem Rest R¹ ein Ringsystem bilden;
- R¹: ist bei jedem Auftreten gleich oder verschieden H, D, F, C(=O)OR², eine geradkettige Alkyl- oder Alkoxygruppe mit 1 bis 10 C-Atomen oder eine Alkenylgruppe mit 2 bis 10 C-Atomen oder eine verzweigte oder cyclische Alkyl- oder Alkoxygruppe mit 3 bis 10 C-Atomen, die jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer, aromatischer und/oder heteroaromatischer organischer Rest mit 1 bis 20 C-Atomen, in dem auch ein oder mehrere H-Atome durch F ersetzt sein können.

Die Verbindungen gemäß Formeln (BE-1), (BE-2) und (BE-3) sind optisch aktiv, so dass diese Verbindungen mindestens ein Chiralitätszentrum aufweisen und nicht als Racemat vorliegen. Demgemäß sind die Reste Z^{b} und/oder Z^{c} beziehungsweise R¹, R^{a}, R^{b}, R^{c} und/oder R^{d} so zu wählen, dass mindestens ein Chiralitätszentrum gebildet wird.

Für besonders bevorzugte Reste R, R^{a}, R^{b}, R^{c}, R^{d} in den Formeln (BE-1), (BE-2) und (BE-3) gilt:
- R: ist bei jedem Auftreten gleich oder verschieden H, D, F, C(=O)OR¹, eine geradkettige Alkylgruppe mit 1 bis 4 C-Atomen oder eine ver-zweigte oder cyclische Alkylgruppe mit 3 bis 6 C-Atomen, die jeweils mit einem oder mehreren Resten R¹ substituiert sein kann, oder ein aromatisches oder heteroaromatisches Ringsystem mit 6 bis 12 aromatischen Ringatomen, das jeweils durch einen oder mehrere Reste R¹ substituiert sein kann; dabei können zwei Rest R oder ein Rest R mit einem Rest R¹ ein Ringsystem bilden;
- R¹: ist bei jedem Auftreten gleich oder verschieden H, D, F, C(=O)OR², eine geradkettige Alkylgruppe mit 1 bis 4 C-Atomen oder eine ver-zweigte oder cyclische Alkylgruppe mit 3 bis 6 C-Atomen, die jeweils mit einem oder mehreren Resten R² substituiert sein kann, oder ein aromatisches oder heteroaromatisches Ringsystem mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer oder aromatischer Kohlenwasserstoffrest mit 1 bis 12 C-Atomen.

Vorzugsweise kann vorgesehen sein, dass die Reste R^{a}, R^{b}, R^{c}, R^{d} in Summe höchstens 40, bevorzugt höchstens 20 Kohlenstoffatome aufweisen und vorzugsweise einen Alkyl- oder Cycloalkyrest darstellen.

Ferner kann vorgesehen sein, dass die optisch aktive Borverbindung ein Borondiester umfassend mindestens einen optisch aktiven Alkoholrest ist.

Ferner kann vorgesehen sein, dass der Borondiester eines optisch aktiven Alkohols ein Derivat eines cyclischen oder polycyclischen Diols, vorzugsweise eines Pinens, Weinsäurederivats oder von Campher abgeleiteten Diols ist.

In einer weiteren Ausgestaltung kann die optisch aktive Borverbindung ein Prolinderivat sein.

Besonders bevorzugte Borverbindungen sind ausgewählt aus 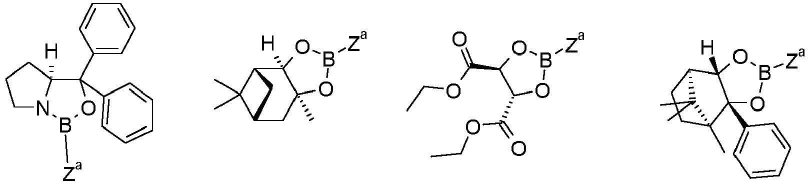 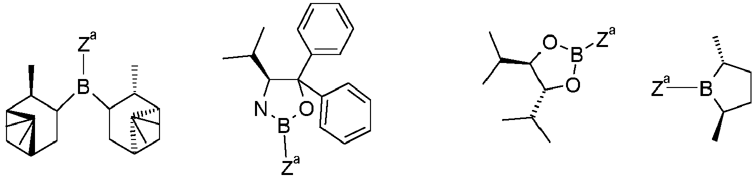 wobei Z^{a} die zuvor genannte Bedeutung hat und vorzugsweise H, B(R)₂ oder Alkyl mit 1 bis 10 Kohlenstoffatomen ist. Ferner können auch die jeweils anderen Enantiomere der zuvor abgebildeten besonders bevorzugte Bor-haltigen Substituenten eingesetzt werden.

Die Borverbindung ist optisch aktiv, so dass diese zumindest ein Chiralitätszentrum aufweist. Zur Durchführung des erfindungsgemäßen Verfahren kann hierbei eine Mischung der zwei Enantiomere der optisch aktiven Borverbindung eingesetzt werden, wobei durch das Mischungsverhältnis der beiden Enantiomere der eingesetzten Borverbindung die Enantiomerenreinheit der Metallkomplexmischung eingestellt werden kann, die durch das vorliegende Verfahren erhalten wird. Bevorzugt kann die optisch aktive Borverbindung mit einem Enantiomerenüberschuss von mindestens 80%, vorzugsweise mindestens 90%, besonders bevorzugt mindestens 95, speziell bevorzugt mindestens 99% und ganz besonders bevorzugt mindestens 99,9% eingesetzt werden. Je höher der Enantiomerenüberschuss der optisch aktiven Borverbindung desto höher die Enantiomerenreinheit eines Metallkomplexes nach der Auftrennung der Diastereomerenmischung und gegebenenfalls Abspaltung des Borsubstituenten.

Die Reaktionsbedingungen bei der Umsetzung des reaktiven Metallkomplexes mit der optisch aktiven Borverbindung gemäß Schritt B) kann gemäß an sich bekannten Verfahren durchgeführt werden, wobei die genauen Reaktionsbedingungen von der Art des eingesetzten reaktiven Metallkomplexes und der optisch aktiven Borverbindung abhängig sind. Hierzu liefern die Beispiele wertvolle Hinweise, ohne dass eine Begrenzung der Erfindung hierdurch erfolgen soll.

Die Umsetzung gemäß Schritt B) kann in Lösung oder in einem Zweiphasensystem, beispielsweise einer wäßrigen Suspension durchgeführt werden, je nach Art der Reaktion. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO) oder Sulfone (Dimethylsulfon, Sulfolan, etc.).

In einer bevorzugten Ausgestaltung der vorliegenden Erfindung kann die Umsetzung durch Übergangsmetallkatalyse, insbesondere Palladium-Katalyse insbesondere gemäß SUZUKI oder hiervon abgeleiteten Verfahren erfolgen, beispielsweise SUZUKI-MIYAURA. Diese Verfahren sind in der Fachwelt weithin bekannt, so dass hierauf Bezug genommen wird, wobei die Beispiele dem Fachmann weitere Hinweise bereitstellen.

In einer bevorzugten Ausgestaltung des Verfahrens beträgt das Stoffmengenverhältnis der optisch aktiven Borverbindung zu den Abgangsgruppen des Metallkomplexes vorzugsweise 1:1 bis 10:1, bevorzugt 2:1 bis 4:1.

Ferner kann vorgesehen sein, dass die Schritte B) und C) bei Temperaturen unterhalb von 140 °C, vorzugsweise unterhalb von 120 °C durchgeführt werden.

In Schritt C) wird die in Schritt B) erhaltene Diastereomerenmischung getrennt, um einen optisch aktiven Metallkomplex zu erhalten. Die Enantiomerenreinheit des erhaltenen Metallkomplexes hängt hierbei von der Reinheit der eingesetzten Borverbindung ab, so dass der Enantiomerenüberschuss des erhaltenen Metallkomplexes durch den Enantiomerenüberschuss der eingesetzten Borverbindung gesteuert werden kann. Vorzugsweise können enantiomerenreine Borverbindungen eingesetzt werden, so dass enantiomerenreine Metallkomplexe erhalten werden können.

Die Auftrennung der in Schritt B) erhaltenen Diastereomerenmischung kann durch übliche Methoden durchgeführt werden, wobei hierzu insbesondere Chromatographie, Umkristallisation und/oder Sublimation zählen. Insbesondere ist hierfür keine chirale Chromatographiesäue erforderlich, da es sich um Diastereomere handelt.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Das erfindungsgemäße Verfahren zur Auftrennung von Mischungen, die Enantiomere von Metallkomplexen mit aromatischen und/oder heteroaromatischen Ligenden enthalten, wird nachfolgend anhand einer schematischen Darstellung kurz erläutert.

Werden beispielsweise in der ortho-Metallierung C₃- bzw. C₃ᵥ-symmetrische Liganden eingesetzt, fällt üblicherweise ein racemisches Gemisch der C₃-symmetrischen Komplexe, also des Δ- und des Δ-Enantiomers, an. Diese werden durch die Umsetzung mit einer chiralen Borverbindung in ein Diastereomerengemisch überführt, das durch gängige Methoden (z. B. Chromatographie / Kristallisation) getrennt werden. Dies ist im folgenden Schema am Beispiel eines C₃-symmetrischen Liganden, der drei Phenylpyridin-Teilliganden trägt, gezeigt und gilt in analoger Form auch für alle anderen C₃- bzw. C₃ᵥ-symmetrischen Liganden.

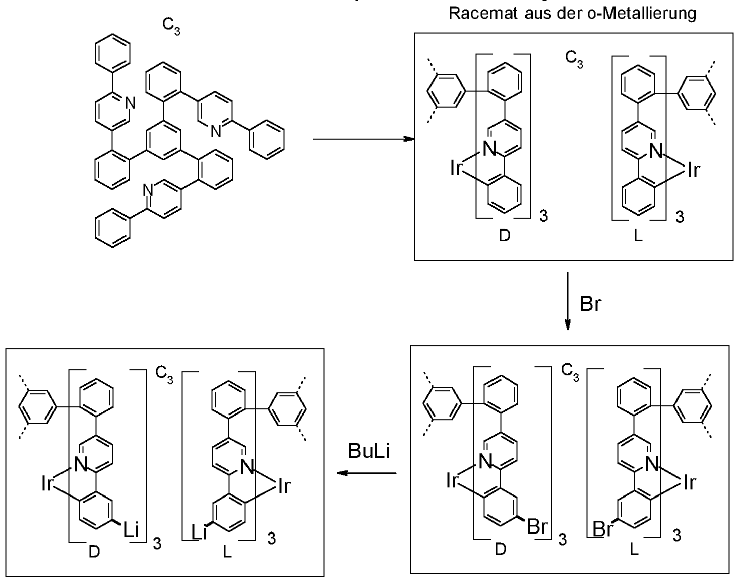

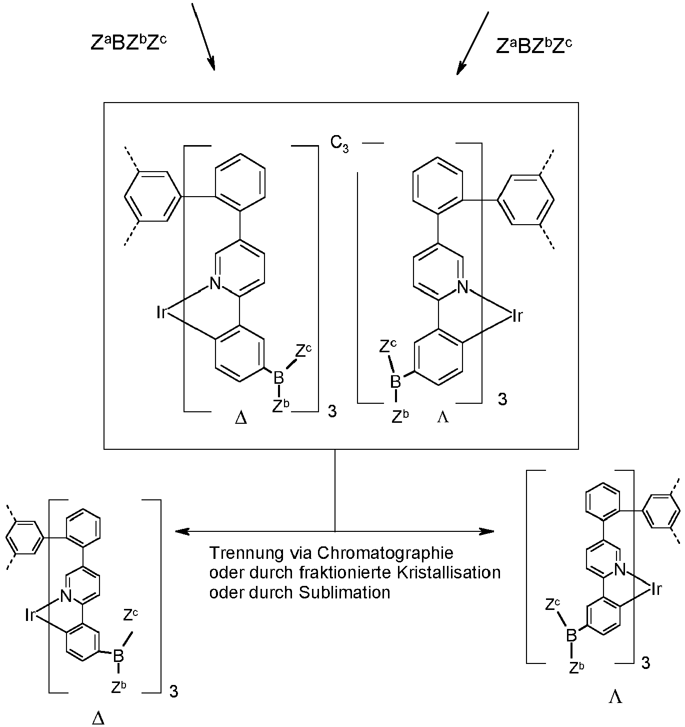

Analoge Verfahren können auch mit Komplexen Cₛ-symmetrischer Liganden durchgeführt werden.

Die durch die Umsetzung mit einer chiralen Borverbindung erhältlichen Iridiumkomplexe sind neu. Daher ist ein weiterer Gegenstand der vorliegenden Erfindung ein Metallkomplex gemäß der allgemeinen Formel (1b),

Ir(L)ₙ(L')ₘ Formel (1b)

worin die Symbole L und L' die zuvor genannte Bedeutung haben und mindestens einer der Liganden L und/oder L' einen Bor-haltigen Substituenten mit einem Chiralitätszentrum umfasst. Der Bor-haltige Substituent kann hierbei auch an eine Brücke, beispielsweise eine Gruppe der Formel (3) beziehungsweise (4) oder verbrückende Einheit V oder an einer Ringstruktur der Formel (RI-1) bis (RI-8) gebunden sein.

Bevorzugt kann vorgesehen sein, dass der Bor-haltige Substituent mit einem Chiralitätszentrum der Formel (BS-1) entspricht, 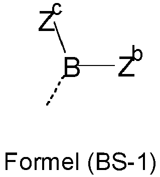 wobei die Symbole Z^{b} und Z^{c} die zuvor genannten Bedeutung aufweisen

Die zuvor für die Formel (BE-1) dargelegten bevorzugten Ausführungsformen der Gruppen Z^{b} und Z^{c} gelten auch für die Formel (BS-1). Demgemäß stellen die Formeln (BS-2) und (BS-3) bevorzugte Ausgestaltungen eines Bor-haltigen Substituenten mit einem Chiralitätszentrum, der an einem Liganden gemäß Formel (1b) gebunden ist, dar, 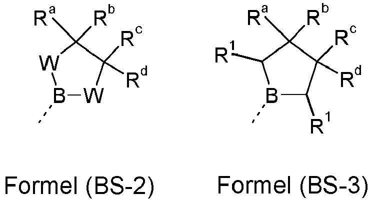 wobei die Reste R^{a}, R^{b}, R^{c}, R^{d} und W die zuvor genannte Bedeutung aufweisen und die gestrichelte Linie die Bindungsstelle darstellt.

Besonders bevorzugte Bor-haltigen Substituenten sind ausgewählt aus 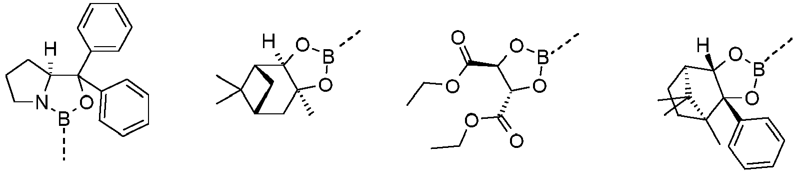 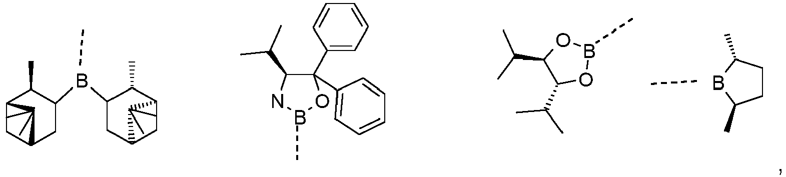 wobei die gestrichelte Linie die Bindungsstelle darstellt. Ferner können auch die jeweils anderen Enantiomere der zuvor abgebildeten besonders bevorzugte Bor-haltigen Substituenten eingesetzt werden.

Die erfindungsgemäßen Metallkomplexe können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (RI-1) bis (RI-8) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol, bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Die erfindungsgemäßen Metallkomplexe können auch mit einem Polymer gemischt werden. Ebenso ist es möglich, diese Metallkomplexe kovalent in ein Polymer einzubauen. Dies ist insbesondere möglich mit Verbindungen, welche mit reaktiven Abgangsgruppen, wie Brom, Iod, Chlor, Boronsäure oder Boronsäureester, oder mit reaktiven, polymerisierbaren Gruppen, wie Olefinen oder Oxetanen, substituiert sind. Diese können als Monomere zur Erzeugung entsprechender Oligomere, Dendrimere oder Polymere Verwendung finden. Die Oligomerisation bzw. Polymerisation erfolgt dabei bevorzugt über die Halogenfunktionalität bzw. die Boronsäurefunktionalität bzw. über die polymerisierbare Gruppe. Es ist weiterhin möglich, die Polymere über derartige Gruppen zu vernetzen. Die erfindungsgemäß erhältlichen Verbindungen und Polymere können als vernetzte oder unvernetzte Schicht eingesetzt werden.

Weiterer Gegenstand der Erfindung sind daher Oligomere, Polymere oder Dendrimere enthaltend eine oder mehrere der oben aufgeführten erfindungsgemäßen Metallkomplexe, wobei statt eines oder mehrerer Wasserstoffatome ein oder mehrere Bindungen des erfindungsgemäßen Metallkomplexes zum Polymer, Oligomer oder Dendrimer vorhanden sind. Je nach Verknüpfung des erfindungsgemäßen Metallkomplexes bildet diese daher eine Seitenkette des Oligomers oder Polymers oder ist in der Hauptkette verknüpft. Die Polymere, Oligomere oder Dendrimere können konjugiert, teilkonjugiert oder nicht-konjugiert sein. Die Oligomere oder Polymere können linear, verzweigt oder dendritisch sein. Für die Wiederholeinheiten der erfindungsgemäßen Metallkomplexe in Oligomeren, Dendrimeren und Polymeren gelten dieselben Bevorzugungen, wie oben beschrieben.

Zur Herstellung der Oligomere oder Polymere werden die erfindungsgemäßen Monomere homopolymerisiert oder mit weiteren Monomeren copolymerisiert. Bevorzugt sind Copolymere, wobei die erfindungsgemäßen Metallkomplexe zu 0.01 bis 99.9 mol%, bevorzugt 5 bis 90 mol%, besonders bevorzugt 5 bis 50 mol% vorhanden sind. Geeignete und bevorzugte Comonomere, welche das Polymergrundgerüst bilden, sind gewählt aus Fluorenen (z. B. gemäß EP 842208 oder WO 2000/022026), Spirobifluorenen (z. B. gemäß EP 707020, EP 894107 oder WO 2006/061181), Para-phenylenen (z. B. gemäß WO 92/18552), Carbazolen (z. B. gemäß WO 2004/070772 oder WO 2004/113468), Thiophenen (z. B. gemäß EP 1028136), Dihydrophenanthrenen (z. B. gemäß WO 2005/014689), cis- und trans-Indenofluorenen (z. B. gemäß WO 2004/041901 oder WO 2004/113412), Ketonen (z. B. gemäß WO 2005/040302), Phenanthrenen (z. B. gemäß WO 2005/104264 oder WO 2007/017066) oder auch mehreren dieser Einheiten. Die Polymere, Oligomere und Dendrimere können noch weitere Einheiten enthalten, beispielsweise Lochtransporteinheiten, insbesondere solche basierend auf Triarylaminen, und/oder Elektronentransporteinheiten.

Für die Verarbeitung der erfindungsgemäßen Metallkomplexe aus flüssiger Phase, beispielsweise durch Spin-Coating oder durch Druckverfahren, sind Formulierungen der erfindungsgemäßen Metallkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens einen erfindungsgemäß erhältlichen Metallkomplex oder ein Metallkomplex gemäß Formel (1b) bzw. mindestens ein erfindungsgemäßes Oligomer, Polymer oder Dendrimer und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Der oben beschriebene erfindungsgemäße Metallkomplex bzw. die oben aufgeführten bevorzugten Ausführungsformen können in der elektronischen Vorrichtung als aktive Komponente oder als Sauerstoff-Sensibilisatoren verwendet werden. Ein weiterer Gegenstand der vorliegenden Erfindung ist somit die Verwendung einer erfindungsgemäß erhältlichen Verbindung in einer elektronischen Vorrichtung oder als Sauerstoff-Sensibilisator. Nochmals ein weiterer Gegenstand der vorliegenden Erfindung ist eine elektronische Vorrichtung enthaltend mindestens eine erfindungsgemäße Verbindung.

Ferner können die erfindungsgemäß erhältlichen Metallkomplexe oder Metallkomplexe gemäß Formel (1b) zur Herstellung von optisch aktiven Metallkomplexen eingesetzt werden. Ein weiterer Gegenstand der vorliegenden Erfindung ist daher die Verwendung eines erfindungsgemäßen Metallkomplexes oder eines Oligomers, Polymers oder Dendrimers gemäß der vorliegenden Erfindung zur Herstellung eines optisch aktiven Metallkomplexes, der vorzugsweise mindestens ein Boratom weniger aufweist als der eingesetzte Metallkomplex. Hierbei wird vorzugsweise die Gruppe (BS-1) von dem eingesetzten Metallkomplex abgespalten. Demgemäß kann die Gruppe (BS-1) mittels geeigneter Verfahren durch einen beliebigen Rest ersetzt werden.

Vorzugsweise können die erfindungsgemäß erhältlichen Metallkomplexe oder Metallkomplexe gemäß Formel (1b) in bekannten Reaktionen, beispielsweise einer SUZUKI oder SUZUKI-MIYAURA Kupplung, umgesetzt werden, um funktionalisierte Komplexe zu erhalten. Zu den bevorzugten Resten R, durch die die Gruppe (BS-1) ersetzt werden kann, zählen unter anderem Alkylgruppen, Arylgruppen, Heteroarylgruppen, OH und/oder Halogenide, vorzugsweise Br oder Cl. Hierzu können entsprechende Verbindungen, insbesondere Arylhalogenide, Heteroarylhalogenide, Alkylhalogenide eingesetzt werden. Ferner kann die Gruppe (BS-1) reduktiv abgespalten werden, so dass statt der Gruppe (BS-1) Wasserstoff (vorzugsweise H oder D) am Komplex gebunden ist.

Diese Komplexe der Formel (1c) entsprechen

Ir(L)ₙ(L')ₘ Formel (1c),

worin die Symbole L und L' die zuvor genannte Bedeutung haben und mindestens einer der Liganden L und/oder L' eine Gruppe Q umfasst, wobei Q ausgewählt ist aus den zuvor genannten Resten R. Vorzugsweise ist Q ausgewählt aus aromatischen oder heteroaromatischen Ringsystemen mit 5 bis 24 aromatischen Ringatomen.

Dementsprechend kann vorgesehen sein, dass eine nach Schritt C) des Verfahren erhaltene Zusammensetzung bzw. Metallkomplex in einer Kupplungsreaktion unter Abspaltung von Borverbindungen umgesetzt wird. Ein weiterer Gegenstand der vorliegenden Erfindung ist somit ein Verfahren zur Herstellung von optisch aktiven Metallkomplexen, wobei nach Schritt C) die erhaltene Zusammensetzung in einer Kupplungsreaktion unter Abspaltung von Borverbindungen umgesetzt wird, vorzugsweise unter Erhalt von Komplexen gemäß Formel (1c).

Durch diese Verfahren, gegebenenfalls gefolgt von Aufreinigung, wie z. B. Chromatographie, Umkristallisation oder Sublimation, lassen sich die erfindungsgemäß erhältlichen Verbindungen gemäß (1c) in hoher Reinheit, bevorzugt mehr als 99 % (bestimmt mittels ¹H-NMR und/oder HPLC) erhalten.

Die erfindungsgemäßen Verbindungen bzw. Verbindungen, welche durch das erfindungsgemäße Verfahren erhalten werden, können in elektronischen Vorrichtungen eingesetzt werden.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Metallkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens einen erfindungsgemäßen Metallkomplex. Besonders bevorzugt sind organische Elektrolumineszenzvorrichtungen. Dies gilt insbesondere, wenn das Metall Iridium oder Aluminium ist. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäß erhältlichen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäß erhältlichen Verbindungen zur Erzeugung von Singulett-Sauerstoff oder in der Photokatalyse eingesetzt werden. Insbesondere wenn das Metall Ruthenium ist, ist der Einsatz als Photosensibilisator in einer farbstoffsensibilisierten Solarzelle ("Grätzel-Zelle") bevorzugt.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Eine weitere Ausführungsform für weiß emittierende OLEDs sind Tandem-OLEDs. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Metallkomplex als emittierende Verbindung in einer oder mehreren emittierenden Schichten.

Wenn der erfindungsgemäße Metallkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Metallkomplex und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% des erfindungsgemäßen Metallkomplexes bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäß erhältlichen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015 oder WO 2015/169412, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe als Co-Matrix für längerwellig emittierende Triplettemitter, beispielsweise für grün oder rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist.

Die erfindungsgemäßen Metallkomplexe lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht, je nach Wahl des Metalls und genauer Struktur des Liganden. Wenn es sich bei dem erfindungsgemäßen Metallkomplex um einen Aluminiumkomplex handelt, so wird dieser bevorzugt in einer Elektronentransportschicht eingesetzt. Ebenso lassen sich die erfindungsgemäßen Metallkomplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1b) oder erfindungsgemäß erhältliche Metallkomplexe bzw. die oben aufgeführten bevorzugten Ausführungsformen angewandt werden.

Das erfindungsgemäße Verfahren zeichnet sich durch einen oder mehrere der folgenden überraschenden Vorteile gegenüber dem Stand der Technik aus:
1. Die erfindungsgemäßen Verfahren können weithin angewandt werden, wobei keine ungewöhnlich teuren und aufwendigen Apparaturen notwendig sind.
2. Durch die erfindungsgemäßen Verfahren sind optisch aktive Metallkomplexe einfach und kostengünstig erhältich, wobei konventionelle Chromatographieverfahren eingesetzt werden können, so dass übliche Verfahren durch den Einsatz von optisch aktiven Borverbindungen leicht abgewandelt werden können, um optisch aktive Metallkomplexe zu erhalten. Die Verwendung von Chromatographieverfahren an chiralen Säulen ist nicht erforderlich.
3. Die erfindungsgemäßen Verfahren ermöglichen die Herstellung von optisch aktiven Metallkomplexen in sehr hoher Ausbeute und sehr hoher Reinheit bei außergewöhnlich kurzen Reaktionszeiten und vergleichsweise geringen Reaktionstemperaturen.
4. Optisch aktive Metallkomplexe sind mit einer Vielzahl von Vorteilen verbunden. So kann beispielsweise die Sublimationstemperatur von Übergangsmetallkomplexen durch die Verwendung von enantiomerenreinen Verbindungen statt den entsprechenden Racematen herabgesetzt werden. Ferner zeigen optisch aktive Metallkomplexe eine sehr hohe Löslichkeit in üblichen Lösungsmitteln, wobei die Löslichkeiten gegenüber Racematen deutlich gesteigert werden kann.
5. Die erfindungsgemäß erhältichen Metallkomplexe weisen eine hervorragende thermische Stabilität auf, was sich auch bei der Sublimation der Komplexe zeigt, wobei besondere Vorteile durch die Verwendung von verbrückten Liganden, insbesondere Liganden die Brücken gemäß Formel (3) oder (4) aufweisen, oder Liganden, die Ringstrukturen, bevorzugt Ringstrukturen gemäß Formeln (RI-1) bis (Ri-8), besonders bevorzugt (RI-4), enthalten, erzielt werden können.
6. Die erfindungsgemäß erhältlichen verbrückten/polypodalen Metallkomplexe zeigen weder thermisch noch photochemisch fac/mer- bzw. mer/fac-Isomerisierung, was zu Vorteilen in der Anwedung dieser Komplexe führt, wobei besondere Vorteile durch die Verwendung von verbrückten Liganden, insbesondere Liganden die Brücken gemäß Formel (3) oder (4) aufweisen, erzielt werden können.
7. Die erfindungsgemäß erhältlichen Metallkomplexe weisen teilweise ein sehr schmales Emissionsspektrum auf, was zu einer hohen Farbreinheit der Emission führt, wie sie insbesondere für Displayanwendungen wünschenswert ist, wobei besondere Vorteile durch die Verwendung von verbrückten Liganden, insbesondere Liganden, die Brücken gemäß Formel (3) oder (4) aufweisen, oder Liganden, die Ringstrukturen, bevorzugt Ringstrukturen gemäß Formeln (RI-1) bis (Ri-8), besonders bevorzugt (RI-4), enthalten, erzielt werden können.
8. Organische Elektrolumineszenzvorrichtungen enthaltend die erfindungsgemäßen Metallkomplexe als emittierende Materialien weisen eine sehr gute Lebensdauer auf, wobei besondere Vorteile durch die Verwendung von verbrückten Liganden, insbesondere Liganden die Brücken gemäß Formel (3) oder (4) aufweisen, oder Liganden, die Ringstrukturen, bevorzugt Ringstrukturen gemäß Formeln (RI-1) bis (Ri-8), besonders bevorzugt (RI-4), enthalten, erzielt werden können.
9. Organische Elektrolumineszenzvorrichtungen enthaltend die erfindungsgemäßen Metallkomplexe als emittierende Materialien weisen eine hervorragende Effizienz auf, wobei besondere Vorteile durch die Verwendung von verbrückten Liganden, insbesondere Liganden die Brücken gemäß Formel (3) oder (4) aufweisen, oder Liganden, die Ringstrukturen, bevorzugt Ringstrukturen gemäß Formeln (RI-1) bis (Ri-8), besonders bevorzugt (RI-4), enthalten, erzielt werden können.
10. Die erfindungsgemäß erhältlichen Metallkomplexe ermöglichen weitere Vorteile, die von der jeweiligen Anwendung abhängig sind. So können Polarisationsfilter auf entsprechenden Devices eingespart werden. Außerdem eignen sich erfindungsgemäß erhältlichen Metallkomplexe insbesondere zur Verwendung in Sicherheitslabeln, da sie neben der Emission auch die Polarisation des Lichts als einfach auslesbares Merkmal aufweisen.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### A: Synthese hexadentater Liganden:

### Beispiel L1:

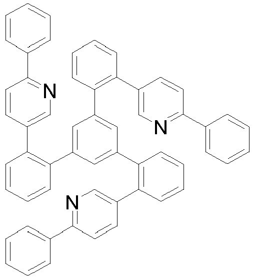

Ein Gemisch aus 54.1 g (100 mmol) 1,3,5-Tris(2-bromphenyl)benzol, [380626-56-2], 98.4 g (350 mmol) 2-Phenyl-5-(4,4,5,5-tetramethyl-[1,3,2]-dioxaborolan-2-yl)-pyridin [879291-27-7], 106.0 g (1 mol) Natriumcarbonat, 5.8 g (5 mmol) Tetrakis(triphenyphosphino)-palladium(0), 750 ml Toluol, 200 ml Ethanol und 500 ml Wasser wird unter sehr gutem Rühren 24 h unter Rückfluss erhitzt. Nach 24 h fügt man 300 ml 5 Gew.-%ige wässrige Acetylcystein-Lösung zu, rührt weitere 10 h unter Rückfluss, lässt erkalten, trennt die wässrige Phase ab und engt die organische Phase zur Tockene ein. Man nimmt den braunen Schaum nach Einengen der organischen Phase aus der Suzuki-Kupplung in 300 ml eines Gemisches aus Dichlormethan:Ethylacetat (8:1, vv) auf und filtriert über ein mit Dichlormethan: Ethylacetat (8:1, vv) vorgeschlämmtes Kieselgelbett (Durchmesser 15 cm, Länge 20 cm), um braune Anteile zu entfernen. Nach Einengen wird der verbliebene Schaum aus 800 ml Ethylacetat unter Zusatz von 400 ml Methanol in der Siedehitze und dann ein zweites Mal aus 1000 ml reinem Ethylacetat umkristallisiert und anschließend im Hochvakuum (p ca. 10⁻⁵ mbar, T 280 °C) Kugelrohr-sublimiert. Ausbeute: 50.6 g (66 mmol), 66 %. Reinheit: ca. 99.7 % ig n. ¹H-NMR.

### Beispiel L2:

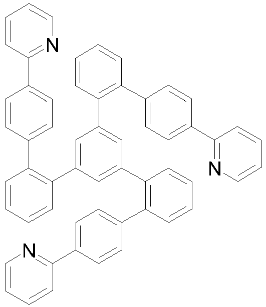

Analog kann Ligand L2 dargestellt werden. Anstalle von 2-Phenyl-5-(4,4,5,5-tetramethyl-[1,3,2]dioxaborolan-2-yl)-pyridin [879291-27-7] wird 2-[4-(4,4,5,5-tetramethyl-[1,3,2]dioxaborolan-2-yl)phenyl]-pyridin [908350-80-1] verwendet. Ausbeute: 56.0 g (73 mmol), 73 %. Reinheit: ca. 99.5 %ig n. ¹H-NMR.

### Beispiel L3:

Synthon S1:

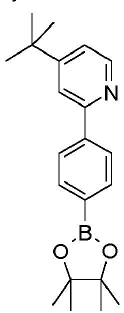

Ein Gemisch aus 29.0 g (100 mmol) 2-(4-bromophenyl)-4-tert-butyl-pyridin [1246851-70-6], 25.4 g (100 mmol) Bis(pinacolato)diboran [73183-34-3], 49.1 g (500 mmol) Kaliumacetat, 1.5 g (2 mmol) 1,1-Bis(diphenyl-phosphino)ferrocendichlorpalladium(II)-Komplex mit DCM [95464-05-4], 200 g Glaskugeln (3 mm Durchmesser), 700 ml 1,4-Dioxan und 700 ml Toluol wird 16 h unter Rückfluss erhitzt. Nach Abkühlen wird die Suspension über ein Celite-Bett filtriert und das Lösemittel im Vakuum entfernt. Der schwarze Rückstand wird mit 1000 ml heißem n-Heptan digeriert, es wird noch heiß über ein Celite-Bett abfiltriert, dann auf ca. 200 ml eingeengt wobei das Produkt zu kristallisieren beginnt. Die Kristallisation wird über Nacht im Kühlschrank vervollständigt, die Kristalle werden abfiltriert und mit wenig n-Heptan gewaschen. Aus der Mutterlauge kann eine zweite Produktfraktion gewonnen werden. Ausbeute: 26.6 g (79 mmol) 79 %. Reinheit: ca. 95 % ig nach 1H NMR

### Ligand L3:

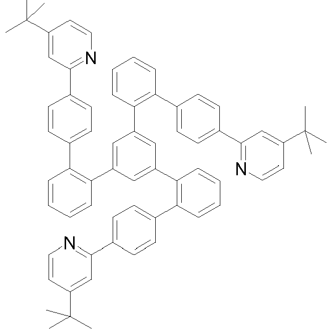

Analog zu Ligand L1 kann Ligand L3 dargestellt werden. Anstalle von 2-Phenyl-5-(4,4,5,5-tetramethyl-[1,3,2]dioxaborolan-2-yl)-pyridin [879291-27-7] wird Synthon S1 verwendet. Ausbeute: 65.4 g (70 mmol), 70 %. Reinheit: ca. 99 % ig nach ¹H-NMR.

### B: Metallorganische Synthone:

### 1. Literaturbekannte Metallkomplex-Synthone MS:

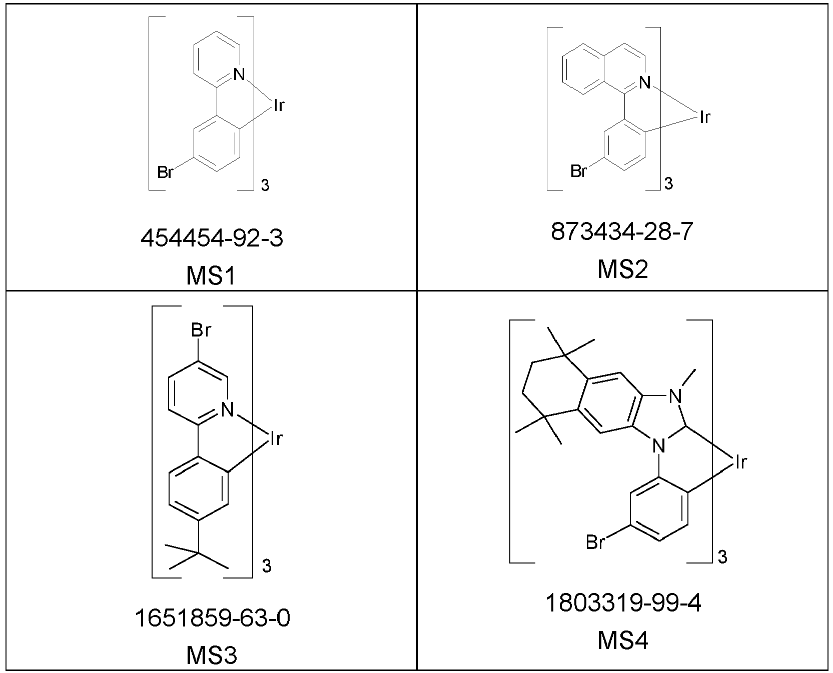

### 2. Synthese der Metallkomplexe Ir(L1):

### Beispiel Ir(L1):

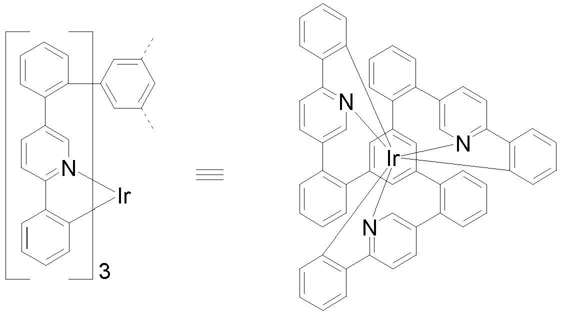

Ein Gemisch aus 7.66 g (10 mmol) des Liganden L1, 4.90 g (10 mmol) Tris-acetylacetonato-iridium(III) [15635-87-7] und 120 g Hydrochinon [123-31-9] werden in einem 500 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250 - 260 °C, gemessen am Pt-100 Thermofühler, der in die aufgeschmolzene, gerührte Reaktionsmischung eintaucht, erhitzt. Während der nächsten 1.5 h wird das Reaktionsgemisch bei 250-260 °C gehalten, wobei wenig Kondensat abdestilliert und sich im Wasserabscheider sammelt. Nach Erkalten wird der Schmelzkuchen mechanisch zerkleinert und mit 500 ml Methanol ausgekocht. Die so erhaltene beige Suspension wird über eine Umkehrfritte filtriert, der beige Feststoff wird einmal mit 50 ml Methanol gewaschen und dann im Vakuum getrocknet. Rohausbeute: quantitativ. Der so erhaltene Feststoff wird in 1500 ml Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten, am Rotationsverdampfer weitgehend eingeengt, wobei gleichzeitig kontinuierlich MeOH bis zur Kristallisation zugetropft wird. Nach Absaugen, waschen mit wenig MeOH und Trocknen im Vakuum erfolgt die weitere Reinigung des gelben Produkts durch dreimalige kontinuierliche Heißextraktion mit Toluol:Acetonitril (3:1, vv) und fünfmalige Heißextraktion mit Toluol (Vorlagemenge jeweils ca. 150 ml, Extraktionshülse: Standard Soxhletthülsen aus Cellulose der Fa. Whatman) unter sorgfältigem Luft- und Lichtausschluss. Ausbeute: 8.52 g (8.9 mmol), 89 %. Reinheit: > 99.9 % nach HPLC.

### Beispiel Ir(L2):

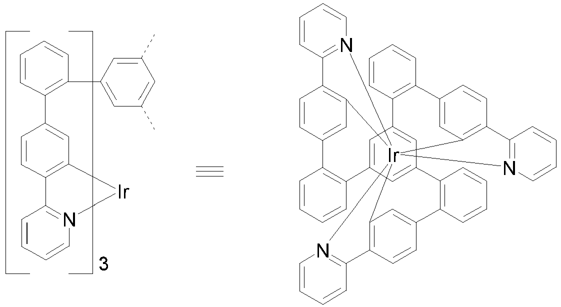

Analog kann Ir(L2) unter Verwendung von L2 statt L1 dargestellt werden. Die Reinigung erfolgt durch dreimalige Umkristallisation aus NMP unter Zusatz von Methanol beim Auskülen der Lösung. Ausbeute: 8.04 g (8.4 mmol), 84 %. Reinheit: > 99.7 % nach HPLC.

### Beispiel Ir(L3)

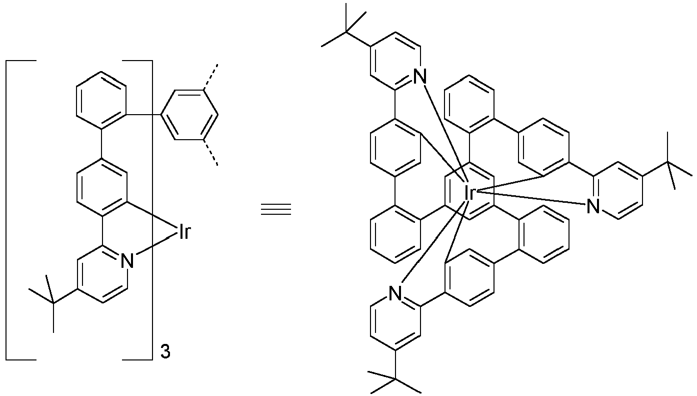

Analog kann Ir(L3) unter Verwendung von L3 statt L1 dargestellt werden. Die Reinigung erfolgt durch fünfmalige Heißextraktion aus Toluol. Ausbeute: 8.09 g (7.2 mmol), 72 %. Reinheit: > 99.7 % nach HPLC.

### 3. Halogenierung der Metallkomplexes Ir(L1):

### Allgemeine Durchführung:

Eine Lösung bzw. Suspension von 10 mmol des Komplexes, in 500 ml bis 2000 ml Dichlormethan, je nach Löslichkeit der Metallkomplexe, wird unter Licht- und Luftausschluss bei -30 bis +30 °C mit 30-40 mmol N-Bromsuccinimid versetzt und 20 h gerührt. In DCM schlecht lösliche Komplexe können auch in anderen Lösungsmitteln (TCE, THF, DMF, Chlorbenzol, etc.) und bei erhöhter Temperatur umgesetzt werden. Anschließend wird das Lösungsmittel im Vakuum weitgehend entfernt. Der Rückstand wird mit 100 ml Methanol unter Zusatz von 5 mL Hydrazinhydrat ausgekocht, der Feststoff wird abgesaugt, dreimal mit ca. 30 ml Methanol gewaschen und dann im Vakuum getrocknet.

Für die Darstellung von mono- und dibromierten Metallkomplexen erfolgt die Durchführung analog zu dem oben beschriebenen Verfahren, jedoch werden statt 30-40 mmol N-Bromsuccinimid 10 mmol N-Bromsuccinimid für die Darstellung der monobromierten bzw. 20 mmol N-Bromsuccinimid für die Darstellung der dibromierten Metallkomplexe eingesetzt. Das Rohprodukt wird chromatographisch aufgereinigt (z. B. auf einem Säulenautomat der Fa. Axel Semrau).

### Beispiel Ir(L1-3Br):

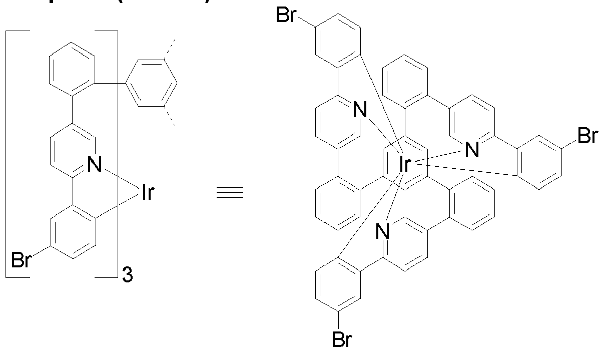

Eine bei 0 °C gerührte Suspension von 9.6 g (10 mmol) Ir(L1) in 2000 ml DCM wird auf einmal mit 7.1 g (40 mmol) N-Bromsuccinimid versetzt und dann weitere 20 h gerührt. Nach Entfernen von ca. 1900 ml des DCMs im Vakuum wird die gelbe Suspension mit 100 ml Methanol und 5 mL Hydrazinhydrat versetzt, unter Rühren ausgekocht, der Feststoff wird abgesaugt, dreimal mit ca. 30 ml Methanol gewaschen und dann im Vakuum getrocknet. Ausbeute: 11.3 g (9.5 mmol) 95 %; Reinheit: > 99.0 %ig nach NMR.

Analog können folgende Komplexe dargestellt werden:

| Bsp. | Edukt > bromierter Komplex | Ausbeute |
|---|---|---|
| Ir(L2-3Br) | 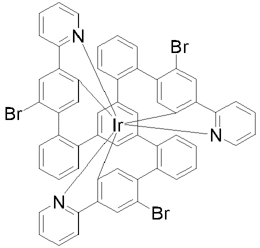 | 93% |
| | Ir(L2) + 40 mmol NBS > Ir(L2-3Br) Lösungsmittel DCM | |
| Ir(L3-3Br) | 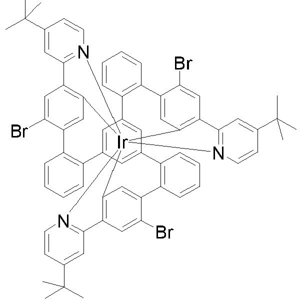 | 95% |
| | Ir(L3) + 40 mmol NBS > Ir(L3-3Br) Lösungsmittel DCM | |
| Ir(L2-Br) | 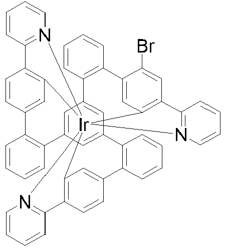 | 24% |
| | Ir(L2) + 10 mmol NBS > Ir(L2-Br) Lösungsmitte DCM | |
| Ir(L3-2Br) | 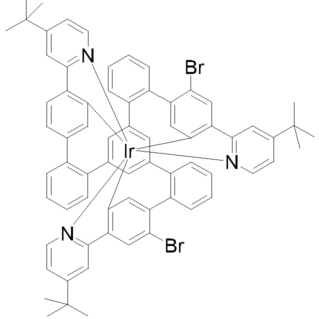 | 26% |
| | Ir(L3) + 20 mmol NBS > Ir(L3-2Br) Lösungsmittel DCM | |

### 4. Borylierung der halogenierten Komplexe mit anschließender chromatographischer Trennung der entstandenen Diastereomere; allgemeine Durchführung

### Variante 1:

In einem 250 mL-Zweihalskolben mit Rückflusskühler, Magnetrührfisch, Heizbad und Argonanschluss werden 5 mmol eines tribromierten Metallkomplexes , 30 mmol Bis[(+)-pinanediolato]diboron [230299-05-5], 45 mmol Kaliumacetat [127-08-2] und 0.45 mmol 1,1-Bis(diphenyl-phosphino)-ferrocen-dichlorpalladium (II) [95464-05-4] eingewogen und mit 100 ml 1,4-Dioxan versetzt. Die Reaktionsmischung wird mit Argon inertisiert und unter Rückfluss für 24-48 Stunden gerührt. Nach Abkühlen wird die Reaktionslösung über Celite filtriert, das Celite wird mit 2 x 50 mL 1,4-Dioxan nachgewaschen. Anschließend wird das Filtrat am Rotations-verdampfer eingeengt und der verbleibende Rückstand extraktiv mit DCM und Wasser aufgearbeitet. Die organische Phase wird abgetrennt und mit gesättigter Natriumchloridlösung gewaschen. Die organische organische Phase wird mit 50 mL Ethanol versetzt und anschließend das Dichlormethan am Rotationsverdampfer abrotiert. Der ausgefallene Feststoff wird abgesaugt, 2 mal mit je 10 mL Ethanol gewaschen und im Vakuum getrocknet. Anschließend wird die 1:1 Mischung der erhaltenen Diastereomere mittels chromatographischer Methoden getrennt. Das jeweilige Produkt wird als Ir(Lx-3Bor-(+)) bzw MSx-3Bor-(+) bezeichnet.

### Variante 2:

In einem 250 mL-Zweihalskolben mit Rückflusskühler, Magnetrührfisch, Heizbad und Argonanschluss werden 5 mmol eines tribromierten Metallkomplexes , 30 mmol Bis(diethyl-D-tartrate glycolato)diboron [312693-46-2], 45 mmol Kaliumacetat [127-08-2] und 0.45 mmol 1,1-Bis(diphenyl-phosphino)-ferrocen-dichlorpalladium (II) [95464-05-4] eingewogen und mit 100 ml 1,4-Dioxan versetzt. Die Reaktionsmischung wird mit Argon inertisiert und unter Rückfluss für 24-48 Stunden gerührt. Nach Abkühlen wird die Reaktionslösung über Celite filtriert, das Celite wird mit 2 x 50 mL 1,4-Dioxan nachgewaschen. Anschließend wird das Filtrat am Rotations-verdampfer eingeengt und der verbleibende Rückstand extraktiv mit DCM und Wasser aufgearbeitet. Die organische Phase wird abgetrennt und mit gesättigter Natriumchloridlösung gewaschen. Anschließend wird die organische Phase mit 50 mL Ethanol versetzt und anschließend das Dichlormethan am Rotationsverdampfer abrotiert. Der ausgefallene Feststoff wird abgesaugt, zweimal mit je 10 mL Ethanol gewaschen und anschließend im Vakuum getrocknet. Anschließend wird die 1:1 Mischung der erhaltenen Diastereomere mittels chromatographischer Methoden getrennt. Das jeweilige Produkt wird als Ir(Lx-3Bor-D) bzw MSx-3-Bor-D bezeichnet.

### Variante 3:

In einem 250 mL-Zweihalskolben mit Rückflusskühler, Magnetrührfisch, Heizbad und Argonanschluss werden 5 mmol eines tribromierten Metallkomplexes , 30 mmol (3a*S*,3'a*S*,4*S*,4'*S*,7*R*,7'*R*,7a*S*,7'a*S*)-Dodecahydro-7,7',8,8,8',8'-hexamethyl-3a,3'a-diphenyl-2,2'-bi-4,7-methanol-1,3,2-benzodioxaborol [916771-67-0], 45 mmol Kaliumacetat [127-08-2] und 0.45 mmol trans-Dichlorobis(tricyclohexylphosphine)palla-dium(II) [29934-17-6] eingewogen und mit 100 ml 1,4-Dioxan versetzt. Die Reaktionsmischung wird mit Argon inertisiert und unter Rückfluss für 24-48 Stunden gerührt. Nach Abkühlen wird die Reaktionslösung über Celite filtriert, das Celite wird mit 2 x 50 mL 1,4-Dioxan nachgewaschen. Anschließend wird das Filtrat am Rotationsverdampfer eingeengt und der verbleibende Rückstand extraktiv mit DCM und Wasser aufgearbeitet. Die organische Phase wird abgetrennt und mit gesättigter Natriumchloridlösung gewaschen. Anschließend wird die organische Phase mit 50 mL Ethanol versetzt und anschließend das Dichlormethan am Rotationsverdampfer abrotiert. Der ausgefallene Feststoff wird abgesaugt, 2 mal mit je 10 mL Ethanol gewaschen und anschließend im Vakuum getrocknet. Anschließend wird die 1:1 Mischung der erhaltenen Diastereomere mittels chromatographischer Methoden getrennt. Das jeweilige Produkt wird als Ir(Lx-3Bor-S) bzw. MSx-3-Bor-S bezeichnet. Als Ausbeute wird zunächst die Ausbeute der Diastereomerenmischung angegeben, die Trennung der Diastereomeren wird unter Punkt 5 näher beschrieben.

Analog dieser Vorschriften können folgende Verbindungen dargestellt werden:

| Edukt | Variante > borylierter Komplex | Ausbeute |
|---|---|---|
| Ir(L2-3Br) | 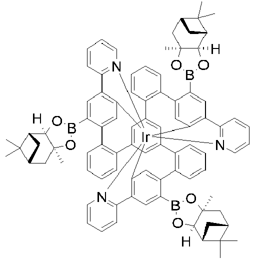 Variante 1 > Ir(L2-3Bor-(+)) | 82% |
| Ir(L3-3Br) | 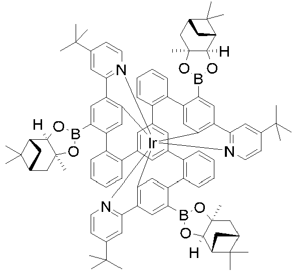 Variante 1 > Ir(L3-3Bor-(+)) | 80% |
| Ir(L1-3Br) | 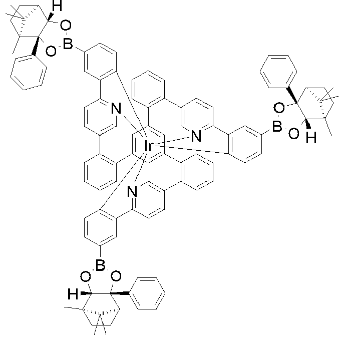 Variante 3 > Ir(L1-3Bor-S) | 76% |
| Ir(L2-Br) | 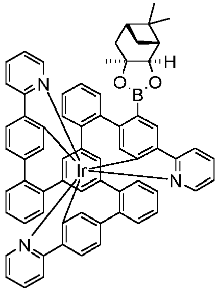 Variante 1 > Ir(L2-Bor-(+)) | 72% |
| Ir(L3-2Br) | 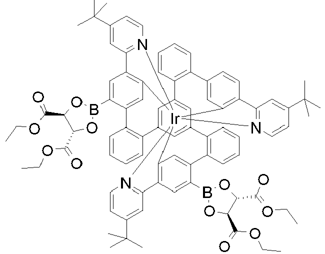 Variante 2 > Ir(L3-2Bor-D) | 80% |
| 454454-92-3 MS1 | 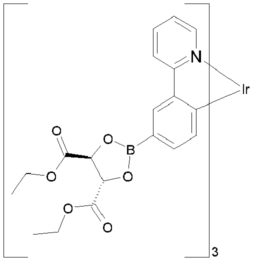 Variante 2 > MS1-3Bor-D | 78% |
| 873434-28-7 MS2 | 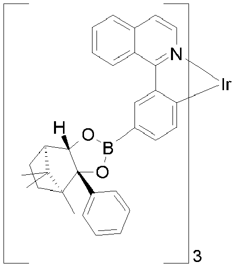 Variante 3 > MS2-3Bor-S | 85% |
| 1651859-63-0 MS3 | 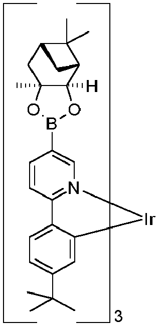 Variante 1 > MS3-3Bor-(+) | 82% |
| 1803319-99-4 MS4 | 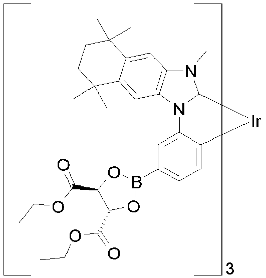 Variante 2 > MS4-3Bor-D | 70% |
| 1989601-72-0 MS5 | 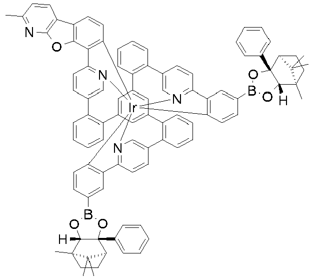 Variante 3 > MS5-2Bor-S | 65% |
| 1989601-78-6 MS6 | 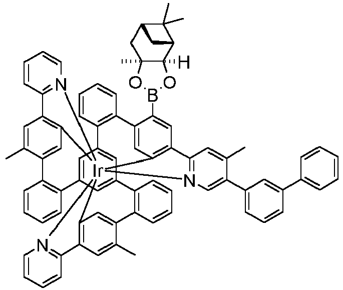 Variante 1 > MS6-Bor-(+) | 67% |
| 2054152-16-6 MS7 | 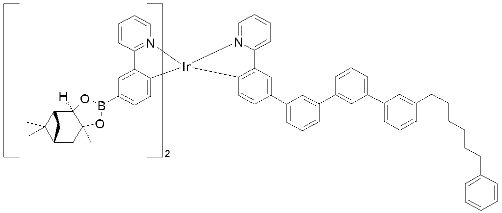 Variante 1 > MS7-2Bor-(+) | 60% |

### Variante 4:

### Borylierung der halogenierten Komplexe über Lithierung und anschließendes Quenchen mit einer elektrophilen Borverbindung.

In einem 250 mL-Zweihalskolben mit Magnetrührfisch und Argonanschluss werden 1 mmol eines tribromierten Metallkomplexes in 100 mL absolutem THF suspensiert und unter Rühren im Aceton/Trockeneisbad auf -65°C Innentemperatur abgekühlt. Dann werden 15 mmol einer 1.7 mol/L Lösung *tert*-Butyllithium in Pentan [594-19-4] so zugetropt, dass die Innentemeratur -55°C nicht übersteigt. Es wird 5 h bei -65 °C gerührt, dann wird zügig das (3aS,4s,6S,7aR)-Hexahydro-3a,5,5-trimethyl-2-(1-methylethoxy)-4,6-methano-1,3,2-benzodioxaborole (15 mmol) [819816-59-6] in 20 mL absolutem THF zugetropft. Man lässt die Reaktionsmischung langsam auf Raumtemperatur erwärmen und rührt über Nacht bei Raumtemperatur. Dann wird 1 mL MeOH zugegeben und der Ansatz am Rotations-verdampfer eingeent. Der Rückstand wir in 100 mL DCM aufgenommen, einmal mit 25 mL Wasser und einmal mit 25 mL gesättigter NaCI-Lösung gewaschen, über Natriumsulfat getrocknet, und über eine Kieselgelbett filtriert. Das Kieselgel wird zweimal mit je 50 mL DCM nachgewaschen, zum Filrat werden 30 mL Ethanol zugegeben, das DCM wird am Rotationsverdampfer bis 500 mbar bei 50°C Badtemperatur abgezogen und der ausgefallene Feststoff wird über eine Umkehrfritte abgesaugt, zweimal mit je 5 mL Ethanol gewaschen und anschließend im Vakuum getrocknet. Das Rohprodukt kann chromatographisch aufgereinigt werden um Verunreinigungen vor der Trennung der Diastereomeren zu entfernen. Anschließend wird die 1:1 Mischung der erhaltenen Diastereomere mittels chromatographischer Methoden getrennt. Das jeweilige Produkt wird als Ir(Lx-3Bor-(+)) bzw MSx-3Bor-(+) bezeichnet.

Es können folgende Verbindungen hergestellt werden:

| Edukt | Variante > borylierter Komplex | Ausbeute |
|---|---|---|
| Ir(L3-3Br) | 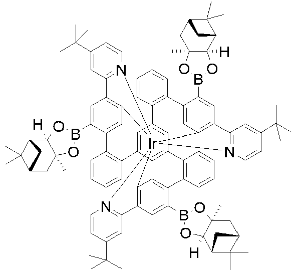 Variante 1 > Ir(L3-3Bor-(+)) | 54% |
| 1651859-63-0 MS3 | 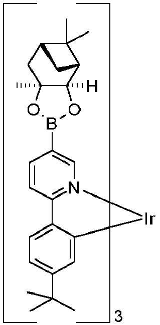 Variante 1 > MS3-3Bor-(+) | 50% |

### 5. Chromatographische Trennung der Diastereomeren via präparativer HPLC am Beispiel von Ir(L3-3Bor-(+)):

### Λ-Ir(L3-3Bor-(+)) und Δ Ir(L3-3Bor-(+))

Zunächst wird eine analytische HPLC-MS Methode gewählt um die beiden Isomere zu trennen und anhand ihrer molaren Masse zu bestätigen. Hierbei findet keine Zuordnung des Λ bzw Δ Isomers statt. Daher werden die Isomere im folgenden als Isomer 1 (abgekürzt I1) bzw Isomer 2 (abgekürzt als I2) I1-Ir(Lx-3-Bor-y) und I2-Ir(Lx-3Bor-y) bzw I1-MSx-3Bor-y und I2-MSx-3Bor-y bezeichnet. Die Zahl der Bor-Atome wird durch die Zahl vor dem Wort "Bor" widergegeben.

Die analytische Trennung wird auf einem DIONEX Ultimate 3000 LC-System durchgeführt, die Detektion der Massen mit einem Massenspektrometer mit APCI (Mode: positiv) lonenquelle. Zur Trennung wird eine Säule 150 mm x 4.6 mm/ 3 µm Purospher Star RP-18e verwendet. Es wird ein Gradientenprogramm mit einem Acetonitril/Tetrahydrofuran Lösungsmittelgemisch gefahren.

Figur 1 zeigt das Chromatogramm der analytischen Trennung der Isomere von Ir(L3-3Bor-(+)).

Figur 2 zeigt die Zuordnung der Massenpeaks zu den Retentionszeiten der Isomere von Ir(L3-3Bor-(+)).

Anschließend wird die analytische Methode als Ausgangspunkt für die präparative Trennung verwendet. Für die präparative Trennung werden 2000 mg des Diastereomeren Gemisches auf 30 HPLC Runs aufgeteilt. So können 840 mg des Isomers I1-Ir(L3-3Bor-(+)) mit einer Reinheit von 99.5% und 864 mg des Isomers I2-Ir(L3-3Bor-(+)) mit einer Reinheit von 99.6% erhalten werden.

Analog dieser Methode können folgende enantiomerenreine Verbindungen erhalten werden:

| Isomer > Menge > Reinheit | Isomer > Menge > Reinheit |
|---|---|
| I1-Ir(L2-3Bor-(+)) > 782 mg > 99.4% | I2-Ir(L2-3Bor-(+)) > 760 mg > 99.7% |
| I1-Ir(L1 -3Bor-S) > 860 mg > 99.5% | I2-Ir(L1-3Bor-S) > 800 mg > 99.3% |
| I1-Ir(L2-Bor-(+)) > 793 mg > 99.7% | I2-Ir(L2-Bor-(+)) > 810 mg > 99.3% |
| I1-Ir(L3-2Bor-D) > 831 mg > 99.1% | I2-Ir(L3-2Bor-D) > 808 mg > 99.5% |
| I1-MS1-3Bor-D > 824 mg > 99.1% | I2-MS1-3Bor-D > 800 mg > 99.2% |
| I1-MS2-3Bor-S > 796 mg > 99.8% | I2-MS2-3Bor-S > 812 mg > 99.6% |
| I1-MS3-3Bor-(+) > 884 mg > 99.0% | I2-MS3-3Bor-(+) > 836 mg > 99.5% |
| I1-MS4-3Bor-D > 910 mg > 98.8% | I2-MS4-3Bor-D > 838 mg > 99.4% |
| I1-MS5-2Bor-S > 852 mg > 99.7% | I2-MS5-2Bor-S > 897 mg > 99.8% |
| I1-MS6-Bor-(+) > 812 mg > 99.7% | I2-MS6-Bor-(+) > 823 mg > 99.2% |
| I1-MS7-2Bor-(+) > 450 mg > 98.1% | I2-MS7-2Bor-(+) > 601 mg > 98.8% |

5 g eines Gemisches aus I1-Ir(L2-Bor-(+)) und I2-Ir(L2-Bor-(+)) wird an einem Säulenautomaten (Companion der Firma Axel Semrau) chromatographisch getrennt. Als Laufmittelgemisch wird ein Gradient aus Dichlormethan und Toluol verwendet.
Ausbeute Säule: I1-Ir(L2-Bor-(+)) 2.1 g, Reinheit 98.2% und I2-Ir(L2-Bor-(+)) 2.2 g, Reinheit 98.0%. Die beiden Diastereomere I1-Ir(L2-Bor-(+)) und I2-Ir(L2-Bor-(+)) werden, getrennt voneinander, noch je dreimal mit Ethylacetat heißextrahiert und anschließend im Hochvakuum getempert. Ausbeute: I1-Ir(L2-Bor-(+)) 1.2 g, Reinheit 99.6% und I2-Ir(L2-Bor-(+)) 1.0 g, Reinheit 99.5%.

### 6. Suzuki-Kupplung der enantiomerenreinen borylierten Komplexe Variante 1: Suzuki-Kupplung im zweiphasigen wässrig-organischen Medium

Ein Gemisch aus 1 mmol des borylierten Metallkomplexes, 6 mmol des Bromids, 12 mmol Trikaliumphosphat [7778-53-2], 30 ml Toluol, 10 ml Dioxan, 10 ml Wasser wird mit 0.12 mmol Tri-o-tolylphosphin [6163-58-2] und 0.02 mmol Palladium(II)acetat [3975-31-3] versetzt und 48 h bei 100 °C gut gerührt. Nach Erkalten trennt man die org. Phase ab, wäscht diese zweimal mit je 30 ml Wasser, einmal mit 30 ml gesättigter Kochsalzlösung, trocknet dann über Magnesiumsulfat, filtriert vom Magnesiumsulfat ab und engt das Filtrat zur Tockene ein. Das so erhaltene Rohprodukt wird chromatographisch oder Flash-chromatographisch (CombiFlash Torrent der Fa. Axel Semrau) gereinigt.

### Variante 2: Suzuki-Kupplung im einphasigen dipolar-aprotischen Medium

Ein Gemisch aus 1 mmol des borylierten Metallkomplexes, 6 mmol des Bromids, 12 mmol Trikaliumphosphat-Trihydrat [22763-03-7] und 30 ml DMSO wird mit 0.1 mmol Tetrakis(triphenyphosphino)palladium(0) [14221-01-3] versetzt und 48 h bei 80 °C gut gerührt versetzt. Nach Erkalten entfernt man das DMSO weitgehend im Vakkum, nimmt den Rückstand in 100 ml Dichlormethan auf, filtriert über ein mit Dichlormethan vorgeschlämmtes Kieselgel-Bett ab, wäscht dieses mit 50 ml Dichlormethan nach und engt dann die organische Phase im Vakuum zur Trockene ein. Die Weitere Reinigung des so erhaltenen Rohprodukts erfolgt wie unter Variante 1 beschrieben.

### Beispiel I1-Ir1:

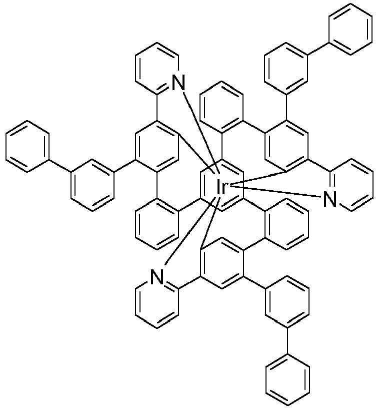

Durchführung nach Variante 2. Einsatz von 1.49 g (1 mmol) I1- Ir(L2-3Bor-(+)), 1.40 g (6 mmol) 1-Bromo-3-phenylbenzene [2113-57-7], 3.20 g (12 mmol) Trikaliumphosphat-Trihydrat, 115 mg (0.1 mmol) Tetrakis-(triphenyphosphino)palladium(0). Ausbeute: 1.10 g (0.78 mmol), 78 %. Reinheit: > 99.8 % n. HPLC.

Analog können folgende Verbindungen dargestellt werden:

| Bsp. | Produkt > Edukt > Variante > Bromid | Ausbeute |
|---|---|---|
| I2-Ir1 | 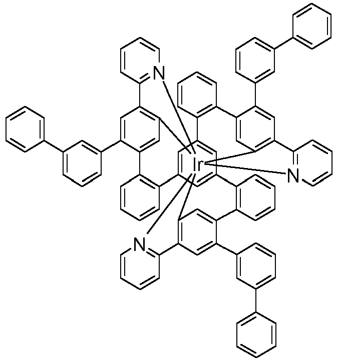 | 72% |
| | I2-Ir(L2-3Bor-(+)) > Variante 2 > 1-Bromo-3-phenylbenzene [2113-57-7] | |
| I1-Ir2 | 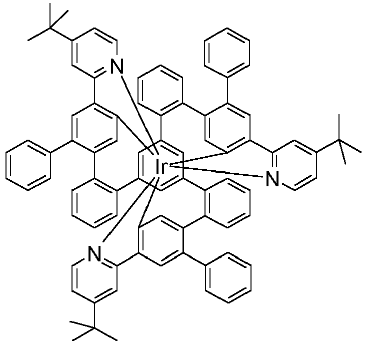 | 80% |
| | Ir(L3-3Bor-(+)) > Variante 1 > Brombenzol [108-86-1] | |
| I2-Ir2 | I1-Ir(L3-3Bor-(+)) > Variante 1 > Brombenzol [108-86-1] | 82% |
| I1-Ir3 | 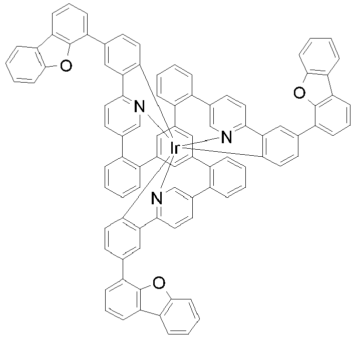 | 58% |
| | I1-Ir(L1 -3Bor-S) > Variante 2 > 4-Bromdibenzofuran [89827-45-2] | |
| I2-Ir3 | I2-Ir(L1-3Bor-S) > Variante 2 > 4-Bromdibenzofuran [89827-45-2] | 54% |
| I1-Ir4 | 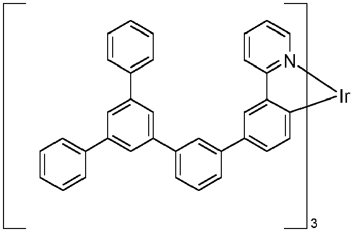 I1-MS1-3Bor-D - Variante 1 > m-Brom-Quatärphenyl [1233200-57-1] | 88% |
| I2-Ir4 | I2-MS1-3Bor-D-Variante 1 > m-Brom-Quatärphenyl [1233200-57-1] | 81% |
| I1-Ir5 | 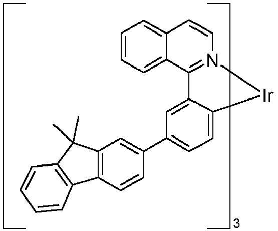 | 74% |
| | I1-MS2-3Bor-S > Variante 2 > 9,9-Dimethyl-2-bromofluorene [28320-31-2] | |
| I2-Ir5 | I2-MS2-3Bor-S > Variante 2 > 9,9-Dimethyl-2-bromofluorene [28320-31-2] | 79% |
| I1-Ir6 | 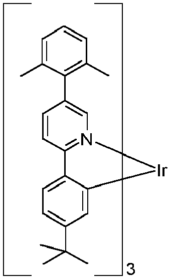 | 48% |
| | I1-MS3-3Bor-(+) > Variante 1 > 2,6-Dimethylphenyl bromide [576-22-7] | |
| I2-Ir6 | I2-MS3-3Bor-(+) > Variante 1 > 2,6-Dimethylphenyl bromide [576-22-7] | 50% |
| I1-Ir7 | 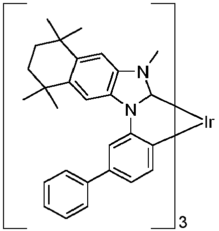 | 39% |
| | I1-MS4-3Bor-D > Variante 2 > Brombenzol [108-86-1] | |
| I2-Ir7 | I2-MS4-3Bor-D > Variante 2 > Brombenzol [108-86-1] | 36% |
| I1-Ir8 | 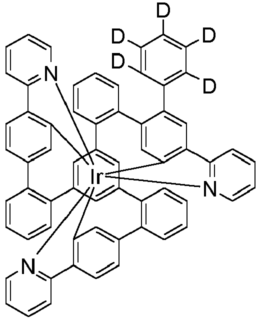 | 65% |
| | I1-Ir(L2-Bor-(+)) > Variante 2 > pentadeutero-Brombenzol [4165-57-5] | |
| I2-Ir8 | I2-Ir(L2-Bor-(+)) > Variante 2 > pentadeutero-Brombenzol [4165-57-5] | 60% |
| I1-Ir9 | 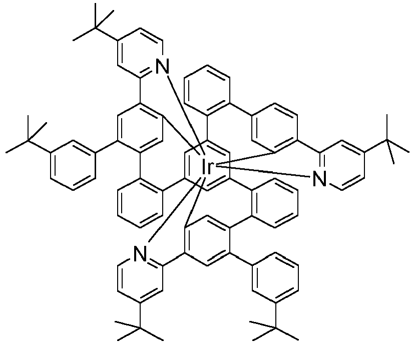 | 37% |
| | I1-Ir(L3-2Bor-D) > Variante 1 > 1-Brom-3-*tert-*Butylbenzol [3972-64-3] | |
| I2-Ir9 | I2-Ir(L3-2Bor-D) > Variante 1 > 1-Brom-3-*tert-*Butylbenzol [3972-64-3] | 42% |
| I1-Ir10 | 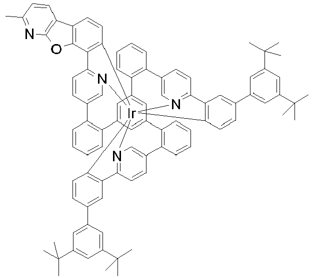 | 55% |
| | I1-MS5-2Bor-S > Variante 2 > 1-Brom-3,5-bis(*tert*-butyl)benzol [3972-64-3] | |
| I2-Ir10 | I2-MS5-2Bor-S > Variante 2 > 1-Brom-3,5-bis(*tert*-butyl)benzol [3972-64-3] | 60% |
| I1-Ir11 | 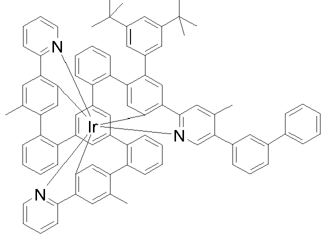 | 68% |
| | I1-MS6-Bor-(+) > Variante 1 > 1-Brom-3,5-bis(*tert*-butyl)benzol [3972-64-3] | |
| I2-Ir11 | I2-MS6-Bor-(+) > Variante 1 > 1-Brom-3,5-bis(*tert*-butyl)benzol [3972-64-3] | 64% |
| I1-Ir12 | 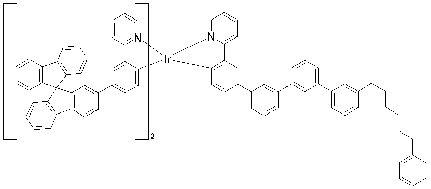 | 41% |
| | I1-MS7-2Bor-(+) > Variante 1 > 9,9'-Spirobi[9*H-*fluorene] [171408-76-7] | |
| I2-Ir12 | I2-MS7-2Bor-(+) > Variante 1 > 9,9'-Spirobi[9*H-*fluorene] [171408-76-7] | 36% |

### 7. Physikalische Eigenschaften der enantiomerenreinen Verbindungen verglichen mit dem Racemat

Die enantiomerenreinen Verbindungen zeichnen sich insbesonders durch verbesserte Löslichkeit und niedrigere Sublimationstemperaturen gegenüber dem Racemat aus. Von besonderer Bedeutung ist hier die Löslichkeit in Toluol (im folgenden abgekürzt als Tol) und 3-Phenoxytoluol (im Folgenden abgekürzt als 3-PT), da diese Lösungsmittel zum Bau von lösungsbasierten OLED-Devices verwendet werden. Für die Verarbeitung der erfindungsgemäßen Komplexe (Spin-Coating, InkJet-Printing, Nozzle-Printing, Rakeln etc.) werden langzeitstabile Lösungen mit Feststoffgehalten von 5-20 mg/mL benötigt.

Ebenso sind niedrige Sublimationstemperaturen der Komplexe (im Hochvakuum) für den Bau von Vakuum prozessierten OLED-Devices von entscheidender Bedeutung.

| Emitter | Löslichkeit in bei 25 °C in mg/mL | Sublimationstemperatur bei 10⁻⁵ mbar in °C |
|---|---|---|
| Ir1 (Racemat) | 12 (Tol) / 22 (3-PT) | 430 |
| I1-Ir1 | 18 (Tol) / 35 (3-PT) | 410 |
| I2-Ir1 | 18 (Tol) / 35 (3-PT) | 410 |
| Ir2 (Racemat) | 6 (Tol) / 14 (3-PT) | 420 |
| I1-Ir2 | 16 (Tol) / 26 (3-PT) | 405 |
| I2-Ir2 | 15 (Tol) / 27 (3-PT) | 405 |
| Ir3 (Racemat) | 3 (Tol) / 5 (3-PT) | 435 |
| I1-Ir3 | 9 (Tol) / 14 (3-PT) | 415 |
| I2-Ir3 | 8 (Tol) / 13 (3-PT) | 420 |
| Ir4 (Racemat) | 8 (Tol) / 21 (3-PT) | --- |
| I1-Ir4 | 16 (Tol) / 34 (3-PT) | --- |
| I2-Ir4 | 16 (Tol) / 32 (3-PT) | --- |
| Ir5 (Racemat) | 4 (Tol) / 6 (3-PT) | --- |
| I1-Ir5 | 10 (Tol) / 14 (3-PT) | --- |
| I2-Ir5 | 9 (Tol) / 14 (3-PT) | --- |
| Ir6 (Racemat) | 3 (Tol) / 4 (3-PT) | 370 |
| I1-Ir6 | 10 (Tol) / 14 (3-PT) | 350 |
| I2-Ir6 | 9 (Tol) / 14 (3-PT) | 355 |
| Ir7 (Racemat) | 14 (Tol) / 28 (3-PT) | 360 |
| I1-Ir7 | 23 (Tol) / 40 (3-PT) | 340 |
| I2-Ir7 | 25 (Tol) / 39 (3-PT) | 340 |
| Ir8 (Racemat) | 5 (Tol) / 10 (3-PT) | 420 |
| I1-Ir8 | 8 (Tol)/ 14 (3-PT) | 400 |
| I2-Ir8 | 9 (Tol) / 15 (3-PT) | 400 |
| Ir9 (Racemat) | 15 (Tol) / 35 (3-PT) | 425 |
| I1-Ir9 | 15 (Tol) / 40 (3-PT) | 410 |
| I2-Ir9 | 18 (Tol) / 44 (3-PT) | 410 |
| Ir10 | 12 (Tol) / 25 (3-PT) | --- |
| I1-Ir10 | 15 (Tol) / 32 (3-PT) | --- |
| I2-Ir10 | 16 (Tol) / 30 (3-PT) | --- |
| Ir11 | 20 (Tol) / 35 (3-PT) | 405 |
| I1-Ir11 | 22 (Tol) / 40 (3-PT) | 395 |
| I1-Ir11 | 20 (Tol) / 39 (3-PT) | 390 |
| Ir12 | 26 (Tol) / 52 (3-PT) | --- |
| I1-Ir12 | 30 (Tol) / 55 (3-PT) | --- |
| I2-Ir12 | 32 (Tol) / 58 (3-PT) | --- |

### Beispiel: Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Es werden gereinigte, beschichtete Glasplättchen verwendet (Reinigung in Miele Laborspülmaschine, Reiniger Merck Extran), die mit strukturiertem ITO (Indium Zinn Oxid) der Dicke 50 nm beschichtet sind und 25 Minuten mit UV-Ozon vorbehandelt (UV-Ozon Generator PR-100, Firma UVP) werden. Anschließend werden sie innerhalb von 30min, zur verbesserten Prozessierung mit 20 nm PEDOT:PSS beschichtet (Poly(3,4-ethylenedioxythiophene) poly(styrenesulfonate), bezogen als CLEVIOS™ P VP AI 4083 von Heraeus Precious Metals GmbH Deutschland, aus wässriger Lösung aufgeschleudert) und anschließend bei 180°C 10min lang ausgeheizt. Diese beschichteten Glasplättchen bilden die Substrate, auf welche die OLEDs aufgebracht werden. Die OLEDs haben prinzipiell folgenden Schichtaufbau: Substrat / Lochtransportschicht 1 (HTL1) bestehend aus HTM dotiert mit 5 % NDP-9 (kommerziell erhältlich von der Fa. Novaled), 20 nm / Lochtransportschicht 2 (HTL2) / optionale Elektronenblockerschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuum-prozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co-Verdampfung in einem bestimmten Volumenanteil beigemischt wird. Eine Angabe wie M3:M2:Ir1 (55%:35%:10%) bedeutet hierbei, dass das Material M3 in einem Volumenanteil von 55%, M2 in einem Anteil von 35% und Ir1 in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 6 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/m² in V) bestimmt aus Strom-Spannungs-Helligkeits-Kennlinien (IUL-Kennlinien).

Des Weiteren werden die Leistungseffizienz (gemessen in lm/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik bestimmt. Die Elektrolumineszenzspektren werden bei einer Leuchtdichte von 1000 cd/m² bestimmt und daraus die CIE 1931 x und y Farbkoordinaten berechnet. Die Angabe U1000 in Tabelle 2 bezeichnet die Spannung, die für eine Leuchtdichte von 1000 cd/m² benötigt wird. EQE1000 bezeichnet die externe Quanteneffizienz bei einer Betriebsleuchtdichte von 1000 cd/m².

Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50% der Startleuchtdichte abgefallen ist, also von z.B. 1000 cd/m² auf 500 cd/m². Je nach Emissionsfarbe wurden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe. Als Lebensdauer LD80 wird die Zeit definiert, nach der die Leuchtdichte bei Betrieb mit einem konstantem Strom von 40 mA/cm² auf 80% der Startleuchtdichte absinkt.

### 2) Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Iridium-Verbindungen gemäß Tabelle 6 verwendet. Die Ergebnisse der OLEDs sind in Tabelle 2 zusammengefasst.

**Tabelle 1: Aufbau der vakuum-prozessierten OLEDs**

| **Bsp.** | **HTL2 Dicke** | **EBL Dicke** | **EML Dicke** | **HBL Dicke** | **ETL Dicke** |
|---|---|---|---|---|---|
| Ref-D1 | HTM 40nm | | M1:IrPPy (85%:15%) 35nm | ETM1 10nm | ETM1:ETM2 (50%:50%) 30nm |
| Ref-D2 | HTM 40nm | | M1:IrPPy2 (85%:15%) 35nm | ETM1 10nm | ETM1:ETM2 (50%:50%) 30nm |
| Ref-D3 | HTM 40nm | | M1:M3:IrPPy (45%:45%:10%) 35nm | ETM1 10nm | ETM1:ETM2 (50%:50%) 30nm |
| Ref-D4 | HTM 40nm | | M1:M3:IrPPy2 (45%:45%:10%) 35nm | ETM1 10nm | ETM1:ETM2 (50%:50%) 30nm |
| D1 | HTM 40nm | | M1:Ir2(Racemat) (80%:20%) 35nm | ETM1 10nm | ETM1:ETM2 (50%:50%) 30nm |
| D1a | HTM 50nm | | M1:I1-Ir2 (80%:20%) 35nm | ETM1 10nm | ETM1:ETM2 (50%:50%) 30nm |
| D1b | HTM 40nm | | M1:I2-Ir2 (80%:20%) 30nm | ETM1 10nm | ETM1:ETM2 (50%:50%) 30nm |
| D2 | HTM 40nm | | M1:M3:Ir2 (Racemat) (45%:45%:10%) 30nm | ETM1 10nm | ETM1:ETM2 (50%:50%) 30nm |
| D2a | HTM 40nm | | M1:M3:I1-Ir2 (45%:45%:10%) 30nm | ETM1 10nm | ETM1:ETM2 (50%:50%) 30nm |
| D2b | HTM 40nm | | M1:M3:I2-Ir2 (45%:45%:10%) 30nm | ETM1 10nm | ETM1:ETM2 (50%:50%) 30nm |
| D3 | HTM 40nm | | M1:M3:Ir2 (Racemat) (60%:30%:10%) 30nm | ETM1 10nm | ETM1:ETM2 (50%:50%) 30nm |
| D3a | HTM 40nm | | M1:M3:I1-Ir2 (60%:30%:10%) 30nm | ETM1 10nm | ETM1:ETM2 (50%:50%) 30nm |
| D3b | HTM 40nm | | M1:M3:I2-Ir2 (60%:30%:10%) 30nm | ETM1 10nm | ETM1:ETM2 (50%:50%) 30nm |
| D4 | HTM 40nm | | M6:Ir2 (Racemat) (85%:15%) 30nm | ETM1 10nm | ETM1:ETM2 (50%:50%) 30nm |
| D4a | HTM 40nm | | M6:I1-Ir2 (85%:15%) 30nm | ETM1 10nm | ETM1:ETM2 (50%:50%) 30nm |
| D4b | HTM 40nm | | M6:I2-Ir2 (85%:15%) 30nm | ETM1 10nm | ETM1:ETM2 (50%:50%) 30nm |
| D5 | HTM 40nm | | M6:Ir2 (Racemat) (85%:15%) 30nm | ETM1 10nm | ETM1:ETM2 (50%:50%) 30nm |
| D5a | HTM 40nm | | M6:I1-Ir2 (85%:15%) 30nm | ETM1 10nm | ETM1:ETM2 (50%:50%) 30nm |
| D5b | HTM 40nm | | M6:I2-Ir2 (85%:15%) 30nm | ETM1 10nm | ETM1:ETM2 (50%:50%) 30nm |
| D6 | HTM 40nm | | M6:Ir2 (Racemat) (85%:15%) 30nm | ETM1 10nm | ETM1:ETM2 (50%:50%) 30nm |
| D6a | HTM 40nm | | M6:I1-Ir2 (85%:15%) 30nm | ETM1 10nm | ETM1:ETM2 (50%:50%) 30nm |
| D6b | HTM 40nm | | M6:I2-Ir2 (85%:15%) 30nm | ETM1 10nm | ETM1:ETM2 (50%:50%) 30nm |
| D7 | HTM 40nm | | M1:M3:Ir1 (Racemat) (60%:30%:10%) 30nm | ETM1 10nm | ETM1:ETM2 (50%:50%) 30nm |
| D7a | HTM 40nm | | M1:M3:I1-Ir1 (60%:30%:10%) 30nm | ETM1 10nm | ETM1:ETM2 (50%:50%) 30nm |
| D7b | HTM 40nm | | M1:M3:I2-Ir1 (60%:30%:10%) 30nm | ETM1 10nm | ETM1:ETM2 (50%:50%) 30nm |
| D8 | HTM 40nm | | M1:Ir6 (Racemat) (85%:15%) 30nm | ETM1 10nm | ETM1:ETM2 (50%:50%) 30nm |
| D8a | HTM 40nm | | M1:I1-Ir6 (85%:15%) 30nm | ETM1 10nm | ETM1:ETM2 (50%:50%) 30nm |
| D8b | HTM 40nm | | M1:I2-Ir6 (85%:15%) 30nm | ETM1 10nm | ETM1:ETM2 (50%:50%) 30nm |
| D9 | HTM 40nm | | M1:M2:Ir6 (Racemat) (45%:45%:10%) 30nm | ETM1 10nm | ETM1:ETM2 (50%:50%) 30nm |
| D9a | HTM 40nm | | M1:M2:I1-Ir6 (45%:45%:10%) 30nm | ETM1 10nm | ETM1:ETM2 (50%:50%) 30nm |
| D9b | HTM 40nm | | M1:M2:12-1r6 (45%:45%:10%) 30nm | ETM1 10nm | ETM1:ETM2 (50%:50%) 30nm |
| D10 | HTM 30nm | | M8:Ir2 (Racemat) (85%:15%) 30nm | ETM1 10nm | ETM1:ETM2 (50%:50%) 30nm |
| D10a | HTM 30nm | | M8:I1-Ir2 (85%:15%) 30nm | ETM1 10nm | ETM1:ETM2 (50%:50%) 30nm |
| D10b | HTM 30nm | | M8:I2-Ir2 (85%:15%) 30nm | ETM1 10nm | ETM1:ETM2 (50%:50%) 30nm |
| D11 | HTM 40nm | | M7:M10:Ir2 (Racemat) (50%:30%:20%) 30nm | ETM1 10nm | ETM1:ETM2 (50%:50%) 30nm |
| D11a | HTM 40nm | | M7:M10:I1-Ir2 (50%:30%:20%) 30nm | ETM1 10nm | ETM1:ETM2 (50%:50%) 30nm |
| D11b | HTM 40nm | | M7:M10:I2-Ir2 (50%:30%:20%) 30nm | ETM1 10nm | ETM1:ETM2 (50%:50%) 30nm |
| D13 | HTM 40nm | | M1:Ir8(Racemat) (80%:20%) 35nm | ETM1 10nm | ETM1:ETM2 (50%:50%) 30nm |
| D13a | HTM 50nm | | M1:I1-Ir8 (80%:20%) 35nm | ETM1 10nm | ETM1:ETM2 (50%:50%) 30nm |
| D13b | HTM 40nm | | M1:I2-Ir8 (80%:20%) 30nm | ETM1 10nm | ETM1:ETM2 (50%:50%) 30nm |
| D14 | HTM 40nm | | M1:Ir9(Racemat) (80%:20%) 35nm | ETM1 10nm | ETM1:ETM2 (50%:50%) 30nm |
| D14a | HTM 50nm | | M1:I1-Ir9 (80%:20%) 35nm | ETM1 10nm | ETM1:ETM2 (50%:50%) 30nm |
| D14b | HTM 40nm | | M1:I2-Ir9 (80%:20%) 30nm | ETM1 10nm | ETM1:ETM2 (50%:50%) 30nm |
| D15 | HTM 40nm | | M1:M3:Ir11 (Racemat) (60%:30%:10%) 30nm | ETM1 10nm | ETM1:ETM2 (50%:50%) 30nm |
| D15a | HTM 40nm | | M1:M3:I1-Ir11 (60%:30%:10%) 30nm | ETM1 10nm | ETM1:ETM2 (50%:50%) 30nm |
| D15b | HTM 40nm | | M1:M3:I2-Ir11 (60%:30%:10%) 30nm | ETM1 10nm | ETM1:ETM2 (50%:50%) 30nm |

**Tabelle 2: Daten der Vakuum-rozessierten OLEDs**

| **Bsp.** | **EQE1000 (%)** | **U1000 (V)** | **CIE x/y** | **LD80 (h)** |
|---|---|---|---|---|
| Ref-D1 | 18.3 | 3.2 | 0.33/0.62 | 65 |
| Ref-D2 | 17.4 | 3.1 | 0.34/0.62 | 180 |
| Ref-D3 | 17.2 | 3.2 | 0.31/0.63 | 90 |
| Ref-D4 | 17.8 | 3.0 | 0.32/0.63 | 260 |
| D1 | 19.2 | 3.0 | 0.33/0.63 | 260 |
| D1a | 19.1 | 3.1 | 0.33/0.63 | 270 |
| D1b | 19.2 | 3.1 | 0.33/0.63 | 275 |
| D2 | 20.4 | 3.0 | 0.32/0.64 | 250 |
| D2a | 20.3 | 3.1 | 0.32/0.63 | 245 |
| D2b | 20.2 | 3.0 | 0.32/0.64 | 250 |
| D3 | 21.8 | 2.9 | 0.32/0.64 | 270 |
| D3a | 22.0 | 3.0 | 0.32/0.64 | 275 |
| D3b | 22.1 | 2.9 | 0.32/0.64 | 265 |
| D4 | 21.6 | 3.0 | 0.33/0.64 | 160 |
| D4a | 21.8 | 3.1 | 0.33/0.64 | 165 |
| D4b | 21.7 | 3.0 | 0.33/0.64 | 160 |
| D5 | 19.7 | 3.5 | 0.33/0.64 | 220 |
| D5a | 19.9 | 3.6 | 0.33/0.63 | 230 |
| D5b | 19.8 | 3.5 | 0.33/0.64 | 235 |
| D6 | 20.2 | 3.4 | 0.33/0.63 | 280 |
| D6a | 20.3 | 3.3 | 0.33/0.63 | 290 |
| D6b | 20.5 | 3.3 | 0.33/0.64 | 265 |
| D7 | 21.7 | 3.1 | 0.34/0.63 | 240 |
| D7a | 21.5 | 2.9 | 0.34/0.63 | 230 |
| D7b | 21.7 | 3.0 | 0.34/0.63 | 235 |
| D8 | 17.8 | 3.0 | 0.34/0.64 | 140 |
| D8a | 17.9 | 3.0 | 0.34/0.64 | 150 |
| D8b | 19.2 | 3.1 | 0.32/0.64 | 135 |
| D9 | 19.3 | 3.0 | 0.32/0.64 | 170 |
| D9a | 19.0 | 3.0 | 0.32/0.64 | 170 |
| D9b | 18.0 | 3.0 | 0.34/0.64 | 175 |
| D10 | 20.3 | 3.5 | 0.33/0.63 | 240 |
| D10a | 20.2 | 3.6 | 0.33/0.63 | 245 |
| D10b | 20.0 | 3.5 | 0.33/0.63 | 230 |
| D11 | 20.7 | 3.4 | 0.33/0.64 | 250 |
| D11a | 20.9 | 3.3 | 0.33/0.64 | 255 |
| D11b | 20.7 | 3.3 | 0.33/0.64 | 265 |
| D13 | 18.7 | 3.1 | 0.33/0.63 | 290 |
| D13a | 19.0 | 3.1 | 0.33/0.63 | 300 |
| D13b | 19.1 | 3.0 | 0.33/0.63 | 305 |
| D14 | 20.6 | 3.3 | 0.32/0.64 | 170 |
| D14a | 20.7 | 3.4 | 0.32/0.64 | 180 |
| D14b | 20.4 | 3.3 | 0.32/0.64 | 185 |
| D15 | 21.5 | 3.2 | 0.36/0.61 | 150 |
| D15a | 21.8 | 3.2 | 0.37/0.61 | 160 |
| D15b | 21.8 | 3.4 | 0.37/0.61 | 155 |

### 3) Vakuum-prozessierte blau emittierende Bauteile

Im folgenden Beispiel werden Daten blau emittierenden OLEDs vorgestellt. Die Prozessierung und Charakterisierung erfolgt wie in 2) beschrieben. Die Elektrolumineszenzspektren werden bei einer Leuchtdichte von 1000 cd/m² bestimmt und daraus die CIE 1931 x und y Farbkoordinaten berechnet. Die Angabe U1000 in Tabelle 8 bezeichnet die Spannung, die für eine Leuchtdichte von 1000 cd/m² benötigt wird. EQE1000 bezeichnet die externe Quanteneffizienz bei einer Betriebsleuchtdichte von 1000 cd/m². Als Lebensdauer LD50 wird die Zeit definiert, nach der die Leuchtdichte bei einer Starthelligkeit von 1000 cd/m² auf 50% der Startleuchtdichte absinkt.

**Tabelle 3: Aufbau der blauen vakuum-prozessierten OLEDs**

| **Bsp.** | **HTL2 Dicke** | **EBL Dicke** | **EML Dicke** | **HBL Dicke** | **ETL Dicke** |
|---|---|---|---|---|---|
| D12 | HTM 30nm | EBM1 10 nm | M9:Ir7 (Racemat) (85%:15%) 30nm | ETM3 10nm | ETM1:ETM2 (50%:50%) 30nm |
| D12a | HTM 30nm | EBM1 10 nm | M9:I1-Ir7 (85%:15%) 30nm | ETM3 10nm | ETM1:ETM2 (50%:50%) 30nm |
| D12b | HTM 30nm | EBM1 10 nm | M9:I2-Ir7 (85%:15%) 30nm | ETM3 10nm | ETM1:ETM2 (50%:50%) 30nm |

**Tabelle 4: Daten der blauen vakuum-prozessierten OLEDs**

| **Bsp.** | **EQE1000 (%)** | **U1000 (V)** | **CIE x/y** | **LD50 (h)** |
|---|---|---|---|---|
| D12 | 7.2 | 5.6 | 0.16/0.11 | 100 |
| D12a | 7.1 | 5.5 | 0.16/0.11 | 110 |
| D12b | 7.4 | 5.5 | 0.16/0.11 | 100 |

### 4) Lösungs-prozessierte Devices:

### A: Aus niedermolekularen löslichen Funktionsmaterialien

Die erfindungsgemäßen Iridium-Komplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich aus Substrat / ITO / Lochinjektionsschicht (60 nm) / Interlayer (20 nm) / Emissionsschicht (60 nm) / Lochblockierschicht (10 nm) / Elektronentransportschicht (40 nm) / Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, in diesem Fall wird HL-X092 von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices vom Typ1a enthalten eine Emissionsschicht aus M4:M5:IrL (40%:45%:15%), die vom Typ 1b enthalten eine Emissionsschicht aus M4:M5:IrL (20%:60%:20%), die vom Typ 2 enthalten eine Emissionsschicht aus M4:M5:IrLa:IrLb (30%:34%:30%:6%), d.h. sie enthalten zwei verschiedene Ir-Komplexe. Die Emissionsschicht wird in einer Inertgasatmosphäre, im vorliegenden Fall Argon, aufgeschleudert und 10 min bei 160 °C ausgeheizt. Darüber wird die Lochblockierschicht (10nm ETM1) und die Elektronentransportschicht (40nm ETM1 (50%) / ETM2 (50%)) aufgedampft (Aufdampfanlagen von Lesker o.a., typischer Aufdampfdruck 5 x 10⁻⁶ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 5 fasst die erhaltenen Daten zusammen.

**Tabelle 5: Ergebnisse mit aus Lösung prozessierten Materialien**

| **Bsp.** | **Emitter Device** | **EQE (%) 1000 cd/m²** | **Spannung (V) 1000 cd/m²** | **CIE x/y** | **LD50 (h) 1000 cd/m²** |
|---|---|---|---|---|---|
| **Grüne und Rote OLEDs** | | | | | |
| Sol-Green1 | Ir4 (Racemat) Typ1a | 19.8 | 5.2 | 0.36/0.61 | 200000 |
| Sol-Green1 a | I1-Ir4 Typ1a | 19.6 | 5.1 | 0.36/0.62 | 230000 |
| Sol-Green1 b | I2-Ir4 Typ1a | 19.9 | 5.0 | 0.36/0.61 | 210000 |
| Sol-Green2 | Ir4 (Racemat) Typ1b | 19.6 | 4.8 | 0.36/0.61 | 210000 |
| Sol-Green2a | I1-Ir4 Typ1b | 19.4 | 4.9 | 0.36/0.61 | 215000 |
| Sol-Green2b | I2-Ir4 Typ1b | 19.5 | 4.9 | 0.36/0.61 | 230000 |
| Sol-Green 3 | Ir2 (Racemat) Typ1b | 23.0 | 4.5 | 0.34/0.62 | 350000 |
| Sol-Green 3a | I1-Ir2 Typ1b | 23.3 | 4.4 | 0.34/0.62 | 350000 |
| Sol-Green 3b | I2-Ir2 Typ1b | 22.9 | 4.5 | 0.34/0.62 | 360000 |
| Sol-Green 4 | Ir1 (Racemat) Typ1b | 21.8 | 4.6 | 0.34/0.63 | 230000 |
| Sol-Green 4a | I1-Ir1 Typ1b | 21.9 | 4.6 | 0.34/0.63 | 240000 |
| Sol-Green 4b | I2-Ir1 Typ1b | 21.9 | 4.5 | 0.34/0.63 | 240000 |
| Sol-Red 5 | Ir-5 (Racemat) Typ 2 | 13.9 | 4.6 | 0.67/0.33 | 200000 |
| Sol-Red 5a | I1-Ir-5 Typ 2 | 14.0 | 4.5 | 0.67/0.33 | 210000 |
| Sol-Red 5b | I2-Ir-5 Typ 2 | 14.1 | 4.5 | 0.67/0.33 | 190000 |
| Sol-Yellow 6 | Ir10 (Racemat) Typ1b | 18.8 | 5.1 | 0.45/0.54 | 180000 |
| Sol-Yellow 6a | I1-Ir10 Typ1b | 19.2 | 5.2 | 0.45/0.54 | 185000 |
| Sol-Yellow 6b | I2-Ir10 Typ1b | 19.2 | 5.1 | 0.45/0.54 | 180000 |

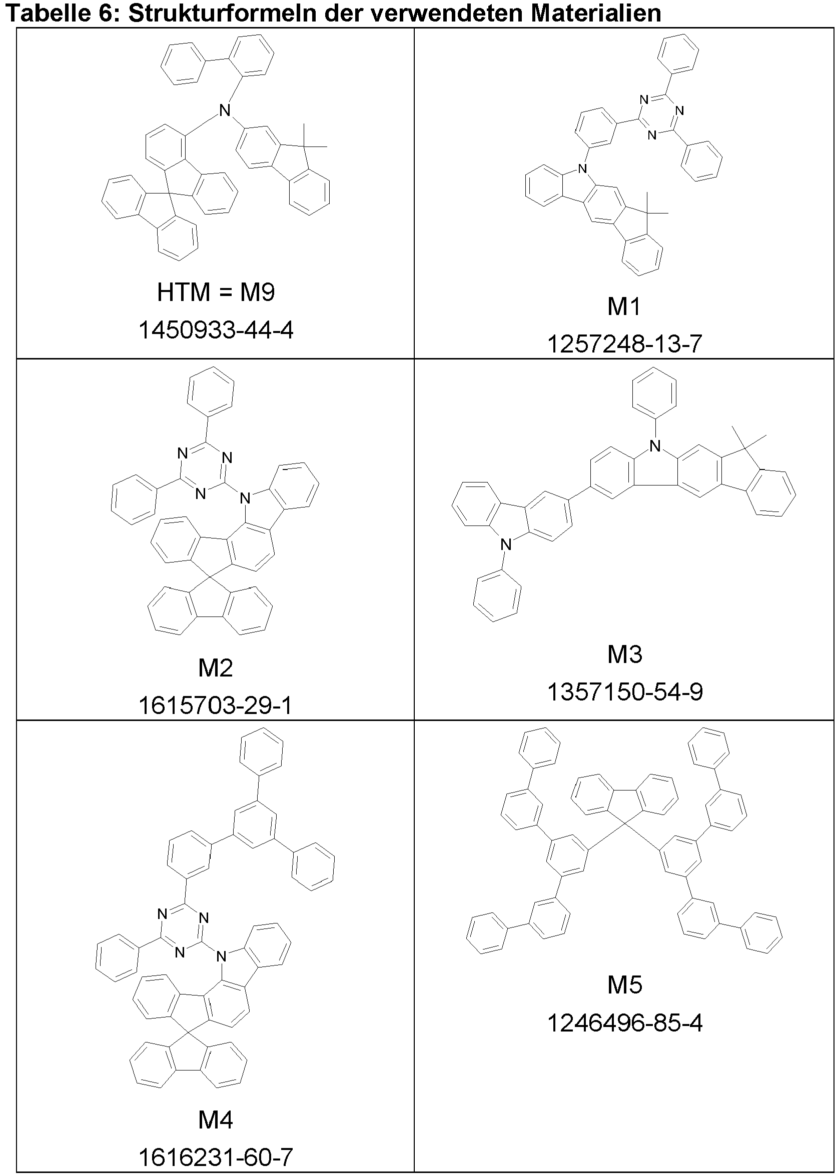

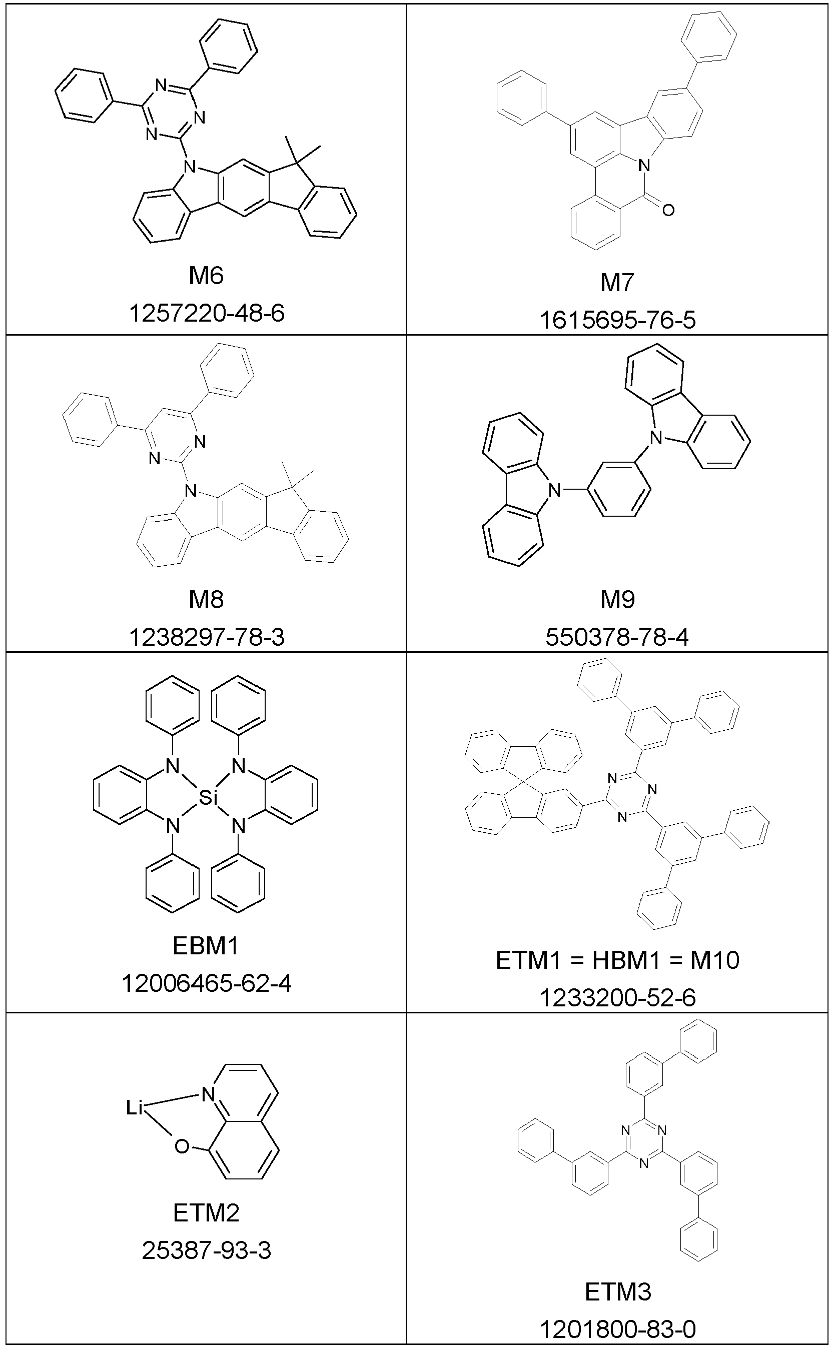

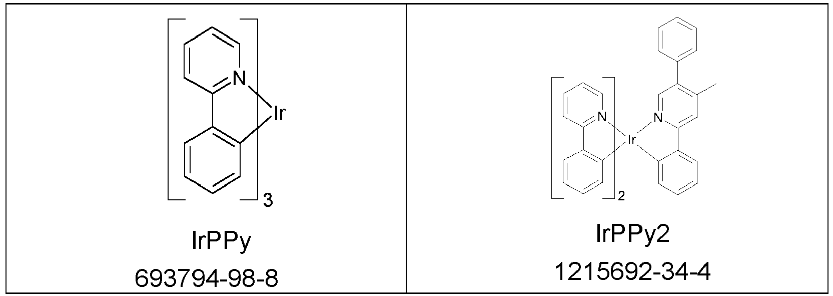

### Beschreibung der Figuren

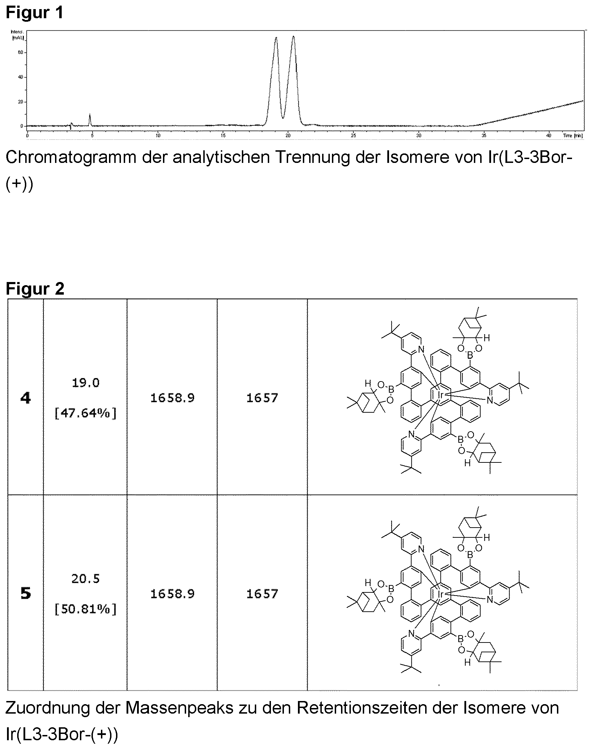

**Figur 1** zeigt das Chromatogramm der analytischen Trennung der Isomere von Ir(L3-3Bor-(+)).
**Figur 2** zeigt die Zuordnung der Massenpeaks zu den Retentionszeiten der Isomere von Ir(L3-3Bor-(+)).

## Patentansprüche

1. Verfahren zur Auftrennung von Mischungen, die Enantiomere von Metallkomplexen mit aromatischen und/oder heteroaromatischen Liganden enthalten, umfassend die Schritte:
A) Bereitstellen einer Mischung von reaktiven Metallkomplexen, wobei die Mischung mindestens zwei Enantiomere der reaktiven Metallkomplexe umfasst;
B) Umsetzung der gemäß Schritt A) bereitgestellten Mischung mit einer optisch aktiven Borverbindung unter Erhalt einer DiastereomerenMischung, wobei die optisch aktive Borverbindung eine Borverbindung gemäß Formel (BE-1) ist, 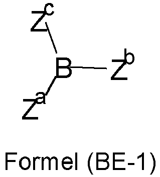 wobei die Symbole die folgende Bedeutung aufweisen:
Z^{a} ist ausgewählt aus H, D, OR, Halogen, B(R)₂;
Z^{b}, Z^{c} ist bei jedem Auftreten gleich oder verschieden OR, N(R)₂, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy-oder Thioalkoxygruppe mit 3 bis 40 C-Atomen, wobei die Alkyl-, Alkoxy-, Thioalkoxy-, Alkenyl- oder Alkinylgruppe jeweils mit einem oder mehreren Resten R substituiert sein kann und wobei Cyclopropyl, Cyclobutyl, Cyclopentyl, Cyclohexyl, Cycloheptyl, Cyclooctyl, 1-Bicyclo[2,2,2]octyl, 2-Bicyclo[2,2,2]octyl, Ada-mantyl, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- als Alkylgruppen gelten und Cyclopentenyl, Cyclohexenyl, Cycloheptenyl, Cyclooctenyl und Cyclooctadienyl als Alkenylgruppen gelten und wobei eine oder mehrere nicht benachbarte CH₂-Gruppen durch RC=CR, C≡C, Si(R)₂, C=O, NR, O, S oder CONR ersetzt sein können, dabei können die Reste R auch miteinander ein Ringsystem bilden;
wobei mindestens einer der Reste Z^{b}, Z^{c} ein Chiralitätszentrum umfasst;
R ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, C(=O)OR¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy-oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können, oder ein aromatisches oder heteroaromatisches Ringsystem mit 5 bis 40 aromatischen Ringatomen, wobei ein aromatisches Ringsystem 6 bis 40 C-Atome im Ringsystem enthält und ein heteroaromatisches Ringsystem 1 bis 40 C-Atome und mindestens ein Heteroatom im Ringsystem enthält, mit der Maßgabe, dass die Summe aus C-Atomen und Hetero-atomen mindestens 5 ergibt und wobei das aromatische bzw. heteroaromatische Ringsystem jeweils durch einen oder mehrere Reste R¹ substituiert sein kann, oder eine Aryloxy- oder Hetero-aryloxygruppe mit 5 bis 40 aromatischen Ringatomen, die durch einen oder mehrere Reste R¹ substituiert sein kann; dabei können zwei Reste R auch miteinander ein Ringsystem bilden;
R¹ ist bei jedem Auftreten gleich oder verschieden H, D, F, Cl, Br, I, N(R²)₂, CN, NO₂, Si(R²)₃, B(OR²)₂, C(=O)R², C(=O)OR², P(=O)(R²)₂, S(=O)R², S(=O)₂R², OSO₂R², eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thio-alkoxygruppe mit 3 bis 20 C-Atomen, wobei die Alkyl-, Alkoxy-, Thioalkoxy-, Alkenyl- oder Alkinylgruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann, oder eine Aryloxy- oder Heteroaryloxygruppe mit 5 bis 40 aromatischen Ringatomen, die durch einen oder mehrere Reste R² substituiert sein kann, oder eine Aralkyl- oder Heteroaralkylgruppe mit 5 bis 40 aromatischen Ringatomen, die durch einen oder mehrere Reste R² substituiert sein kann, oder eine Diarylaminogruppe, Diheteroaryl-aminogruppe oder Arylheteroarylaminogruppe mit 10 bis 40 aromatischen Ringatomen, welche durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer und/oder heteroaromatischer orga-nischer Rest, insbesondere ein Kohlenwasserstoffrest, mit 1 bis 20 C-Atomen, in dem auch ein oder mehrere H-Atome durch F ersetzt sein können, dabei können zwei oder mehrere Substitu-enten R² auch miteinander ein mono- oder polycyclisches Ring-system bilden;
und
C) Auftrennung der gemäß Schritt B) erhaltenen DiastereomerenMischung;
wobei eine Mischung von Metallkomplexen eingesetzt wird, deren reaktive Metallkomplexe der allgemeinen Formel (1) entsprechen, und wobei die Metallkomplexe eine funktionelle Gruppe enthalten, welche ausgewählt ist aus der Gruppe bestehend aus Halogenen, Triflat, Mesylat und Tosylat:
Ir(L)ₙ(L')ₘ Formel (1)
wobei für die verwendeten Symbole und Indizes gilt:
L ist gleich oder verschieden bei jedem Auftreten ein bidentaler Ligand
L' ist gleich oder verschieden bei jedem Auftreten ein Ligand;
n ist 1, 2 oder 3, vorzugsweise 2 oder 3, besonders bevorzugt 3;
m ist 0, 1, 2, 3 oder 4, vorzugsweise 0, 1 oder 2, besonders bevorzugt 0;
dabei können auch mehrere Liganden L miteinander oder L mit L' über eine Einfachbindung oder eine bivalente oder trivalente Brücke verknüpft sein und so ein tridentates, tetradentates, pentadentates oder hexadentates Ligandensystem aufspannen.

2. Verfahren nach Anspruch 1, **dadurch gekennzeichnet, dass** die reaktiven Metallkomplexe der allgemeinen Formel (1) eine Teilstruktur M(L)ₙ der Formel (2) enthalten: 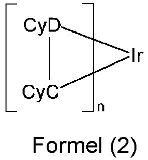 wobei R die in Anspruch 1 genannten Bedeutngen aufweist und für die verwendeten Symbole und Indizes gilt:
CyC ist gleich oder verschieden bei jedem Auftreten eine Aryl- oder Heteroarylgruppe mit 5 bis 18 aromatischen Ringatomen oder eine Fluoren- bzw. Azafluorengruppe, welche jeweils über ein Kohlenstoff-atom an Ir koordiniert und welche jeweils mit einem oder mehreren Resten R substituiert sein kann und welche jeweils über eine kovalente Bindung mit CyD verbunden ist;
CyD ist gleich oder verschieden bei jedem Auftreten eine Heteroaryl-gruppe mit 5 bis 18 aromatischen Ringatomen, welche über ein neutrales Stickstoffatom oder über ein Carben-Kohlenstoffatom an Ir koordiniert und welche mit einem oder mehreren Resten R substituiert sein kann und welche über eine kovalente Bindung mit CyC verbunden ist;
n ist 1, 2 oder 3, vorzugsweise 2 oder 3, besonders bevorzugt 3;
dabei können auch mehrere Liganden L miteinander über eine Einfachbindung oder eine bivalente oder trivalente Brücke verknüpft sein und so ein tridentates, tetradentates, pentadentates oder hexadentates Ligandensystem aufspannen;
dabei kann auch ein Substituent zusätzlich an Ir koordinieren.

3. Verfahren nach Anspruch 1 oder 2, **dadurch gekennzeichnet, dass** der Metallkomplex einen, zwei oder drei bidentate Liganden aufweist, wobei die bidentaten Liganden gleich oder verschieden bei jedem Auftreten ein Kohlenstoffatom und ein Stickstoffatom oder zwei Kohlenstoffatome oder zwei Stickstoffatome oder zwei Sauerstoffatome oder ein Sauerstoffatom und ein Stickstoffatom als koordinierende Atome aufweisen.

4. Verfahren nach einem oder mehreren der Ansprüche 1 bis 3, **dadurch gekennzeichnet, dass** mindestens einer der bidentaten Liganden ausgewählt ist aus den Strukturen der Formeln (L-1-1), (L-1-2) und (L-2-1) bis (L-2-4), 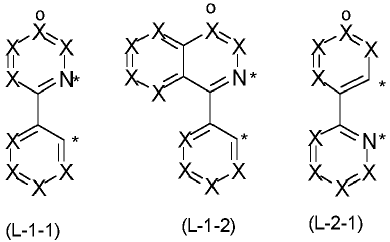 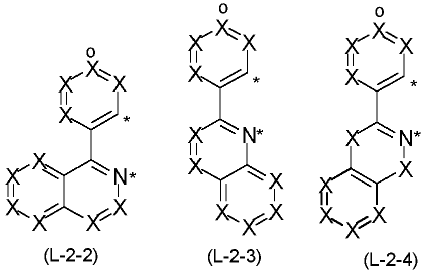 wobei * die Position der Koordination an das Metall darstellt und für die weiteren verwendeten Symbole gilt:
X ist bei jedem Auftreten gleich oder verschieden CR oder N mit der Maßgabe, dass maximal ein Symbol X pro Cyclus für N steht, wobei X C ist, falls an dieser Position der Ligand mit einer Brücke verbunden ist;
R die in Anspruch 1 genannten Bedeutungen aufweist;
wobei die Liganden optional durch eine Brücke verbunden sein können, wobei die Bindung an die Brücke bevorzugt über die mit "o" markierte Position erfolgen kann;
und/oder dass mindestens einer der bidentaten Liganden ausgewählt ist aus den Strukturen der Formeln (L-3) bis (L-30), 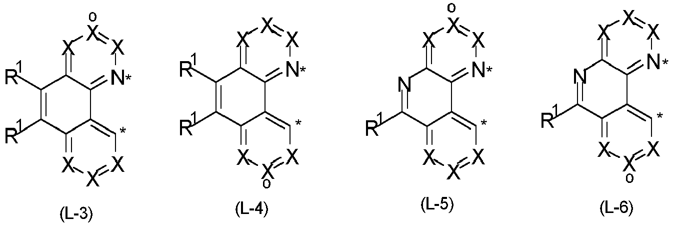 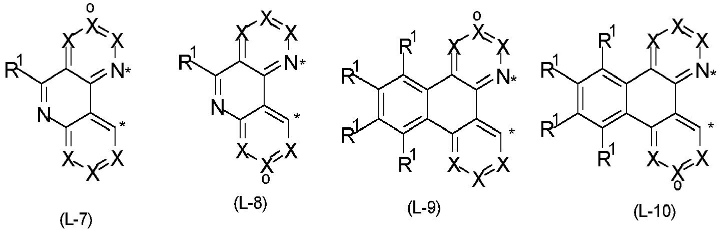 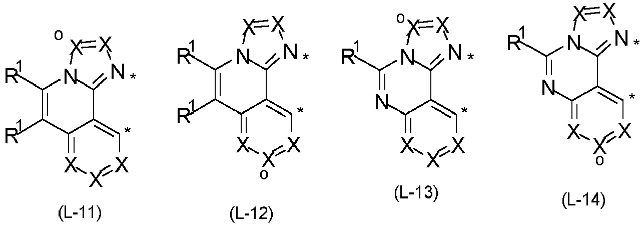 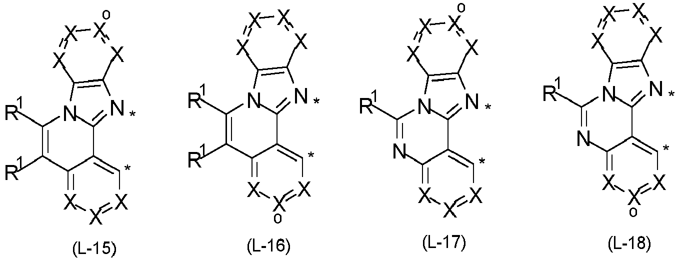 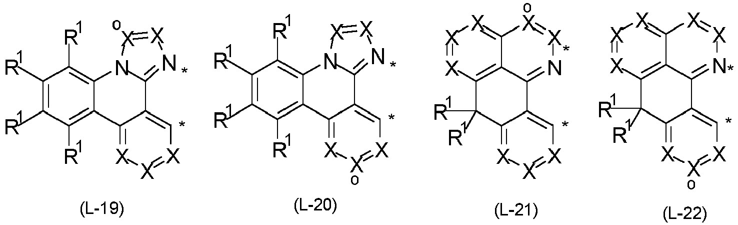 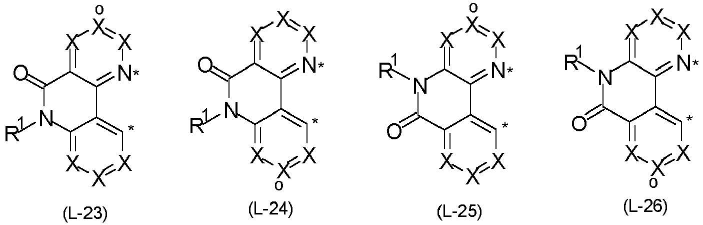 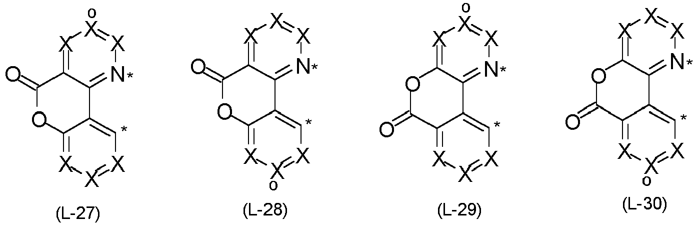 wobei * die Position der Koordination an das Metall darstellt und für die weiteren verwendeten Symbole gilt:
X ist bei jedem Auftreten gleich oder verschieden CR oder N mit der Maßgabe, dass maximal ein Symbol X pro Cyclus für N steht, wobei X C ist, falls an dieser Position der Ligand mit einer Brücke verbunden ist;
R, R¹ die in Anspruch 1 genannten Bedeutungen aufweist;
wobei die Liganden optional durch eine Brücke verbunden sein können, wobei die Bindung an die Brücke bevorzugt über die mit "o" markierte Position erfolgen kann;
und/oder dass mindestens einer der bidentaten Liganden ausgewählt ist aus den Strukturen der folgenden Formeln (L-31) und (L-32), 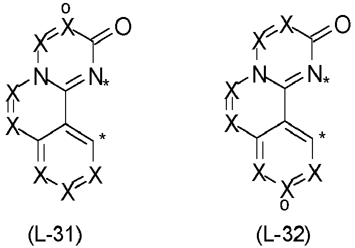 wobei * die Position der Koordination an das Metall darstellt und für die weiteren verwendeten Symbole gilt:
X ist bei jedem Auftreten gleich oder verschieden CR oder N mit der Maßgabe, dass maximal ein Symbol X pro Cyclus für N steht, wobei X C ist, falls an dieser Position der Ligand mit einer Brücke verbunden ist;
R die in Anspruch 1 genannten Bedeutungen aufweist;
wobei die Liganden optional durch eine Brücke verbunden sein können, wobei die Bindung an die Brücke bevorzugt über die mit "o" markierte Position erfolgen kann;
und/oder dass mindestens einer der bidentaten Liganden ausgewählt ist aus den Strukturen der folgenden Formeln (L-39) bis (L-42), 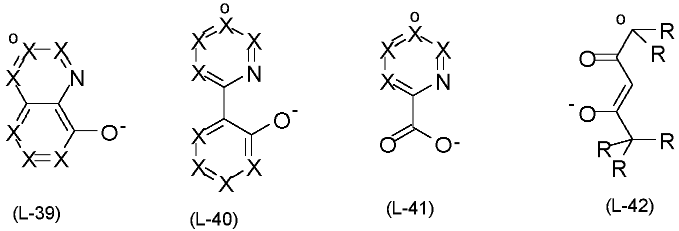 wobei die Liganden (L-39) bis (L-41) jeweils über das explizit eingezeichnete Stickstoffatom und das negativ geladene Sauerstoffatom und der Teilligand (L-42) über die beiden Sauerstoffatome an das Metall koordinieren, X bei jedem Auftreten gleich oder verschieden CR oder N mit der Maßgabe ist, dass maximal ein Symbol X pro Cyclus für N steht, wobei X C ist, falls an dieser Position der Ligand mit einer Brücke verbunden ist und R die in Anspruch 1 genannten Bedeutungen aufweist, wobei die Liganden optional durch eine Brücke verbunden sein können, wobei die Bindung an die Brücke bevorzugt über die mit "o" markierte Position erfolgen kann, wobei X C ist, falls an dieser Position der Ligand mit einer Brücke verbunden ist oder in Formel (L-42) das Kohlenstoffatom einen Substituenten R aufweisen kann, falls der Ligand an dieser Position nicht mit einer Brücke verbunden ist.

5. Verfahren nach einem oder mehreren der Ansprüche 1 bis 4, **dadurch gekennzeichnet, dass** der Metallkomplex mindestens einen Liganden mit zwei Substituenten R und/oder zwei Substituenten R¹ aufweist, die an benachbarte Kohlenstoffatome gebunden sind und die miteinander einen Ring gemäß einer Formeln (RI-1) bis (RI-8) bilden, 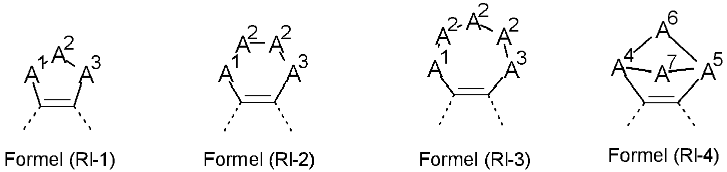 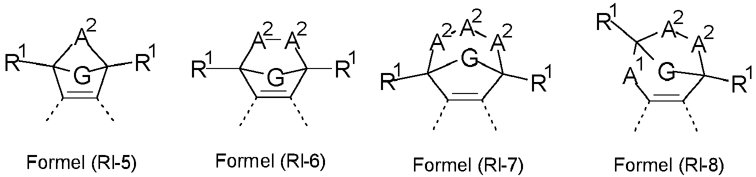 wobei R und R¹ die in Anspruch 1 genannten Bedeutungen aufweisen, die gestrichelten Bindungen die Verknüpfung der beiden Kohlenstoffatome im Liganden andeuten und weiterhin gilt:
A¹, A³ ist gleich oder verschieden bei jedem Auftreten C(R³)₂, O, S, NR³ oder C(=O);
A² ist C(R¹)₂, O, S, NR³ oder C(=O);
A⁴, A⁵ ist gleich oder verschieden bei jedem Auftreten CR¹ oder N;
A⁶, A⁷ ist gleich oder verschieden bei jedem Auftreten eine Alkylen-gruppe mit 2 oder 3 C-Atomen, in welcher ein Kohlenstoffatom durch Sauerstoff ersetzt sein kann und welche mit einem oder mehreren Resten R¹ substituiert sein kann; mit der Maßgabe, dass in A⁴-A⁶-A⁵ bzw. A⁴-A⁷-A⁵ nicht zwei Hetero-atome direkt aneinander gebunden sind
G ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
R³ ist gleich oder verschieden bei jedem Auftreten H, F, eine gerad-kettige Alkyl- oder Alkoxygruppe mit 1 bis 10 C-Atomen, eine ver-zweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substi-tuiert sein kann, oder eine Aryloxy- oder Heteroaryloxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein alipha-tisches oder aromatisches Ringsystem bilden und so ein Spirosystem aufspannen; weiterhin kann R³ mit einem benachbarten Rest R oder R¹ ein aliphatisches Ringsystem bilden;
wobei R² die in Anspruch 1 genannte Bedeutung aufweist;
mit der Maßgabe, dass in diesen Gruppen nicht zwei Heteroatome direkt aneinander gebunden sind und nicht zwei Gruppen C=O direkt aneinander gebunden sind.

6. Verfahren nach einem oder mehreren der Ansprüche 1 bis 5, **dadurch gekennzeichnet, dass** eine Mischung von reaktiven Metallkomplexen eingesetzt wird, deren reaktive Metallkomplexe der allgemeinen Formel entsprechen
Ir(L)ₙ(L')ₘ Formel (1a)
wobei die Symbole L, L', m und n die in Anspruch 1 genannten Bedeutungen aufweisen und die Liganden L und/oder L' über eine Brücke verknüpft sind, wobei gegebenenfalls eine Teilstruktur der Formel (2) gemäß Anspruch 2 gebildet wird, so dass vorzugsweise ein Metallkomplex enthaltend einen hexadentaten tripodalen Liganden gebildet wird und die Liganden L und L' als drei bidentate Teilliganden angesehen werden können, die an das Iridium koordinieren.

7. Verfahren nach Anspruch 6, **dadurch gekennzeichnet, dass** die Brücke, über die die Liganden verknüpft sind, der Formel (3) entspricht, 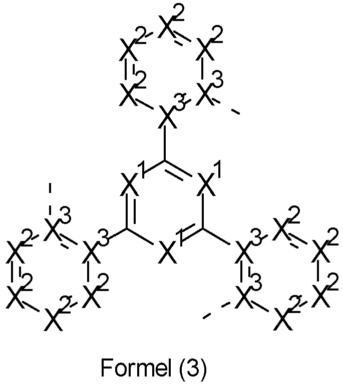 wobei die gestrichelte Bindung die Bindung der Liganden, vorzugsweise der bidentaten Liganden an diese Struktur darstellt und für die verwendeten Symbole gilt:
X¹ ist bei jedem Auftreten gleich oder verschieden C, welches auch sub-stituiert sein kann, oder N;
X² ist bei jedem Auftreten gleich oder verschieden C, welches auch sub-stituiert sein kann, oder N oder zwei benachbarte Gruppen X² stehen zusammen für N, welches auch substituiert sein kann, O oder S, so dass ein Fünfring entsteht; oder zwei benachbarte Gruppen X² stehen zusammen für C, welches auch substituiert sein kann, oder N, wenn in dem Cyclus eine der Gruppen X³ für N steht, so dass ein Fünfring entsteht; mit der Maßgabe, dass maximal zwei benachbarte Gruppen X² in jedem Ring für N stehen; dabei können gegebenenfalls vorhandene Substituenten auch miteinander oder mit Substituenten, die an X¹ gebunden sind, ein Ringsystem bilden;
X³ ist bei jedem Auftreten in einem Cyclus C oder eine Gruppe X³ steht für N und die andere Gruppe X³ in demselben Cyclus steht für C, wobei die Gruppen X³ in den drei Cyclen unabhängig voneinander gewählt werden können; mit der Maßgabe, dass zwei benachbarte Gruppen X² zusammen für C, welches auch substituiert sein kann, oder N stehen, wenn in dem Cyclus eine der Gruppen X³ für N steht;
oder dass die Brücke, über die die Liganden verknüpft sind, der Formel (4) entspricht, 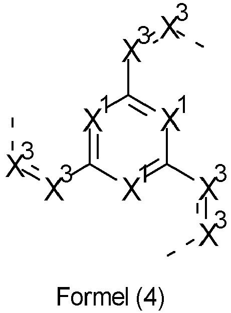 wobei die gestrichelte Bindung die Bindung der Liganden, vorzugsweise der bidentaten Liganden an diese Struktur darstellt und für die verwendeten Symbole gilt:
X¹ ist bei jedem Auftreten gleich oder verschieden C, welches auch sub-stituiert sein kann, oder N;
X³ ist bei jedem Auftreten gleich oder verschieden CR oder N mit der Maßgabe, dass nicht zwei Stickstoffatome direkt aneinander gebun-den sind, wobei R die oben genannten Bedeutungen aufweist;
oder dass die Brücke, über die die Liganden verknüpft sind, der Formel (5) entspricht, 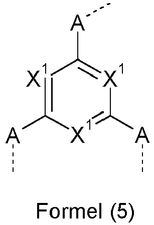 wobei die gestrichelte Bindung die Bindung der Liganden an diese Struktur darstellt und für die verwendeten Symbole gilt:
X¹ ist bei jedem Auftreten gleich oder verschieden C, welches auch sub-stituiert sein kann, oder N;
A ist bei jedem Auftreten gleich oder verschieden gewählt aus der Gruppe bestehend aus -O-C(=O)-, -NR-C(=O)- oder -CR₂-CR₂-, wobei R die oben genannten Bedeutungen aufweist und der Rest R, der an das Stickstoffatom gebunden ist, nicht H oder D ist;
oder dass die Brücke, über die die Liganden verknüpft sind, der Formel (6), (7) oder (8) entspricht, 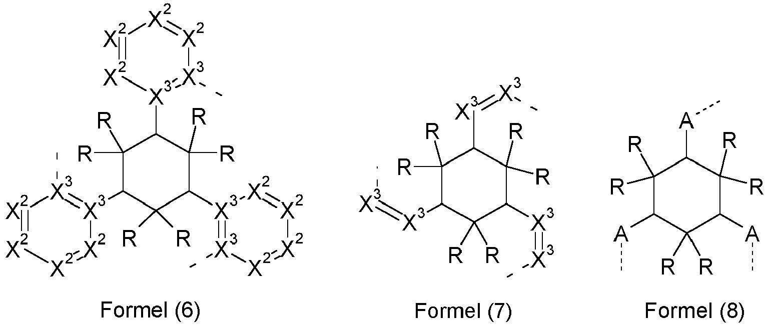 wobei die gestrichelte Bindung die Bindung der Liganden an diese Struktur darstellt und die verwendeten Symbole in Formel (6) die für Formel (3) angegebenen Bedeutungen haben und die Symbole in Formel (7) die für Formel (4) angegebenen Bedeutungen haben und die Symbole in Formel (8) die für Formel (5) angegebenen Bedeutungen haben;
dabei können die drei bidentaten Liganden außer durch die Brücke der Formel (3) bis (8) auch durch eine weitere Brücke zu einem Kryptat geschlossen sein.

8. Verfahren nach einem oder mehreren der Ansprüche 1 bis 7, **dadurch gekennzeichnet, dass** die optisch aktive Borverbindung eine Verbindung gemäß Formel (BE-2) oder (BE-3) ist, 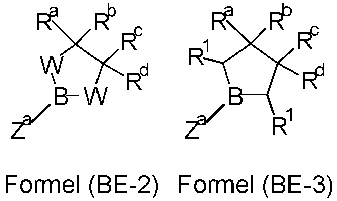 wobei Z^{a} die in Anspruch 1 genannte Bedeutung aufweist und die weiteren Symbole die folgende Bedeutung aufweisen:
W ist bei jedem Auftreten gleich oder verschieden NR, O oder S, vorzugsweise NR oder O und besonders bevorzugt O;
R^{a}, R^{b}, R^{c}, R^{d} ist bei jedem Auftreten gleich oder verschieden H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 20 C-Atomen oder eine Alkenyl- oder Alkinylgruppe mit 2 bis 20 C-Atomen oder eine verzweigte oder cyclische Alkyl-, Alkoxy- oder Thioalkoxygruppe mit 3 bis 20 C-Atomen, wobei die Alkyl-, Alkoxy-, Thioalkoxy-, Alkenyl- oder Alkinylgruppe jeweils mit einem oder mehreren Resten R¹ substituiert sein kann, wobei eine oder mehrere nicht benachbarte CH₂-Gruppen durch R¹C=CR¹, C≡C, Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann, oder eine Aryloxy- oder Heteroaryloxygruppe mit 5 bis 40 aromatischen Ringatomen, die durch einen oder mehrere Reste R¹ substituiert sein kann; dabei können zwei Reste R^{a}, R^{b}, R^{c} und/oder R^{d} auch miteinander ein Ringsystem bilden;
R, R¹ die in Anspruch 1 genannte Bedeutung aufweisen.

9. Metallkomplex gemäß der allgemeinen Formel (1b),
Ir(L)ₙ(L')ₘ Formel (1b)
worin die Symbole L und L' die in Anspruch 1 genannte Bedeutung haben und mindestens einer der Liganden L und/oder L' einen Bor-haltigen Substituenten mit einem Chiralitätszentrum umfasst.

10. Metallkomplex gemäß Anspruch 9, **dadurch gekennzeichnet, dass** der Bor-haltigen Substituent mit einem Chiralitätszentrum der Formel (BS-1) entspricht, 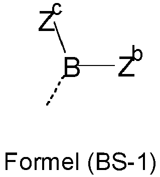 wobei die Symbole Z^{b} und Z^{C} die in Anspruch 1 genannte Bedeutung aufweisen und die gestrichelte Linie die Bindung an den Liganden darstellt.

11. Oligomer, Polymer oder Dendrimer enthaltend einen oder mehrere Metallkomplexe nach Anspruch 9 oder 10, wobei statt eines Wasserstoffatoms ein oder mehrere Bindungen des Metallkomplexes zum Polymer, Oligomer oder Dendrimer vorhanden sind.

12. Formulierung, enthaltend mindestens einen Metallkomplex nach Anspruch 9 oder 10 oder mindestens ein Oligomer, Polymer oder Dendrimer nach Anspruch 11 und mindestens ein Lösemittel.

13. Verwendung eines Metallkomplexes nach Anspruch 9 oder 10 oder eines Oligomers, Polymers oder Dendrimers nach Anspruch 11 zur Herstellung eines optisch aktiven Metallkomplexes, der mindestens ein Boratom weniger aufweist als der eingesetzte Metallkomplex.

14. Verfahren zur Herstellung von optisch aktiven Übergangskomplexen, **dadurch gekennzeichnet, dass** eine nach Schritt C) eines Verfahren gemäß den Ansprüchen 1 bis 8 erhaltene Zusammensetzung in einer Kupplungsreaktion unter Abspaltung von Borverbindungen umgesetzt wird.

15. Elektronische Vorrichtung enthaltend mindestens einen Metallkomplex nach Anspruch 9 oder 10 oder ein Oligomer, Polymer oder Dendrimer nach Anspruch 11, wobei die elektronische Vorrichtung bevorzugt ausgewählt ist aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen, Sauerstoff-Sensoren, Sauerstoff-Sensibilisatoren oder organischen Laserdioden.

## Claims

1. Process for separating mixtures containing enantiomers of metal complexes with aromatic and/or heteroaromatic ligands, comprising the steps of:
A) providing a mixture of reactive metal complexes, where the mixture comprises at least two enantiomers of the reactive metal complexes;
B) reacting the mixture provided in step A) with an optically active boron compound to obtain a diastereomer mixture, wherein the optically active boron compound is a boron compound of formula (BE-1) 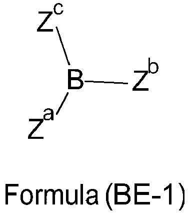 where the symbols are defined as follows:
Z^{a} is selected from H, D, OR, halogen, B(R)₂;
Z^{b}, Z^{c} is the same or different at each instance and is OR, N(R)₂, a straight-chain alkyl, alkoxy or thioalkoxy group having 1 to 40 carbon atoms or an alkenyl or alkynyl group having 2 to 40 carbon atoms or a branched or cyclic alkyl, alkoxy or thioalkoxy group having 3 to 40 carbon atoms, where the alkyl, alkoxy, thioalkoxy, alkenyl or alkynyl group may in each case be substituted by one or more R radicals, and where cyclopropyl, cyclobutyl, cyclopentyl, cyclohexyl, cycloheptyl, cyclooctyl, 1-bicyclo[2.2.2]octyl, 2-bicyclo[2.2.2]octyl, adamantyl, 1-(n-propyl)cyclohex-1-yl, 1-(n-butyl)cyclohex-1-yl, 1-(n-hexyl)cyclohex-1-yl, 1-(n-octyl)cyclohex-1-yl and 1-(n-decyl)cyclohex-1-yl considered to be alkyl groups, and cyclopentenyl, cyclohexenyl, cycloheptenyl, cyclooctenyl and cyclooctadienyl are considered to be alkenyl groups, and where one or more nonadjacent CH₂ groups may be replaced by RC=CR, C≡C, Si(R)₂, C=O, NR, O, S, or CONR; at the same time, the R radicals may also together form a ring system;
where at least one of the Z^{b}, Z^{c} radicals comprises a chiral centre;
R is the same or different at each instance and is H, D, F, Cl, Br, I, N(R¹)₂, CN, NO₂, OH, COOH, C(=O)N(R¹)₂, Si(R¹)₃, B(OR¹)₂, C(=O)R¹, C(=O)OR¹, P(=O)(R¹)₂, S(=O)R¹, S(=O)₂R¹, OSO₂R¹, a straight-chain alkyl, alkoxy or thioalkoxy group having 1 to 20 carbon atoms or an alkenyl or alkynyl group having 2 to 20 carbon atoms or a branched or cyclic alkyl, alkoxy or thioalkoxy group having 3 to 20 carbon atoms, where the alkyl, alkoxy, thioalkoxy, alkenyl or alkynyl group may each be substituted by one or more R¹ radicals, where one or more nonadjacent CH₂ groups may be replaced by R¹C=CR¹, C≡C, Si(R¹)₂, C=O, NR¹, O, S or CONR¹, or an aromatic or heteroaromatic ring system having 5 to 40 aromatic ring atoms, where an aromatic ring system contains 6 to 40 carbon atoms in the ring system and a heteroaromatic ring system contains 1 to 40 carbon atoms and at least one heteroatom in the ring system, with the proviso that the sum total of carbon atoms and heteroatoms is at least 5, and where the aromatic or heteroaromatic ring system may be substituted in each case by one or more R¹ radicals, or an aryloxy or heteroaryloxy group which has 5 to 40 aromatic ring atoms and may be substituted by one or more R¹ radicals; at the same time, two R radicals together may also form a ring system;
R¹ is the same or different at each instance and is H, D, F, Cl, Br, I, N(R²)₂, CN, NO₂, Si(R²)₃, B(OR²)₂, C(=O)R², C(=O)OR², P(=O)(R²)₂, S(=O)R², S(=O)₂R², OSO₂R², a straight-chain alkyl, alkoxy or thioalkoxy group having 1 to 20 carbon atoms or an alkenyl or alkynyl group having 2 to 20 carbon atoms or a branched or cyclic alkyl, alkoxy or thioalkoxy group having 3 to 20 carbon atoms, where each alkyl, alkoxy, thioalkoxy, alkenyl or alkynyl group may be substituted by one or more R² radicals, where one or more nonadjacent CH₂ groups may be replaced by R²C=CR², C≡C, Si(R²)₂, C=O, NR², O, S or CONR², or an aromatic or heteroaromatic ring system which has 5 to 40 aromatic ring atoms and may be substituted in each case by one or more R² radicals, or an aryloxy or heteroaryloxy group which has 5 to 40 aromatic ring atoms and may be substituted by one or more R² radicals, or an aralkyl or heteroaralkyl group which has 5 to 40 aromatic ring atoms and may be substituted by one or more R² radicals, or a diarylamino group, diheteroarylamino group or arylheteroarylamino group which has 10 to 40 aromatic ring atoms and may be substituted by one or more R² radicals; at the same time, two or more R¹ radicals together may form a ring system;
R² is the same or different at each instance and is H, D, F or an aliphatic, aromatic and/or heteroaromatic organic radical, especially a hydrocarbyl radical, having 1 to 20 carbon atoms, in which one or more hydrogen atoms may also be replaced by F, at the same time, two or more R² substituents together may also form a mono- or polycyclic ring system;
and
C) separating the diastereomer mixture obtained in step B);
wherein a mixture of metal complexes is used, the reactive metal complexes of which conform to the general formula (1), and wherein the metal complexes contain a functional group selected from the group consisting of halogens, triflate, mesylate and tosylate:
Ir(L)ₙ(L')ₘ Formula (1)
where the symbols and indices used are as follows:
L is the same or different at each instance and is a bidentate ligand;
L' is the same or different at each instance and is a ligand;
n is 1, 2 or 3, preferably 2 or 3, more preferably 3;
m is 0, 1, 2, 3 or 4, preferably 0, 1 or 2, more preferably 0;
at the same time, it is also possible for two or more ligands L to be joined together or for L to be joined to L' by a single bond or a bivalent or trivalent bridge, thus forming a tridentate, tetradentate, pentadentate or hexadentate ligand system.

2. Process according to Claim 1, **characterized in that** the reactive metal complexes of the general formula (1) contain a substructure M(L)ₙ of the formula (2): 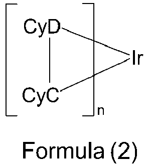 where R has the definitions given in Claim 1 and the symbols and indices used are as follows:
CyC is the same or different at each instance and is an aryl or heteroaryl group which has 5 to 18 aromatic ring atoms or a fluorene or azafluorene group, each of which coordinates to Ir via a carbon atom and each of which may be substituted by one or more R radicals and which is bonded in each case to CyD via a covalent bond;
CyD is the same or different at each instance and is a heteroaryl group which has 5 to 18 aromatic ring atoms and coordinates to Ir via an uncharged nitrogen atom or via a carbene carbon atom and which may be substituted by one or more R radicals and which is bonded to CyC via a covalent bond;
n is 1, 2 or 3, preferably 2 or 3, more preferably 3;
at the same time, it is also possible for two or more ligands L to be joined to one another via a single bond or a bivalent or trivalent bridge, thus forming a tridentate, tetradentate, pentadentate or hexadentate ligand system;
at the same time, a substituent may also additionally coordinate to Ir.

3. Process according to Claim 1 or 2, **characterized in that** the metal complex has one, two or three bidentate ligands, where the bidentate ligands are the same or different at each instance and have one carbon atom and one nitrogen atom or two carbon atoms or two nitrogen atoms or two oxygen atoms or one oxygen atom and one nitrogen atom as coordinating atoms.

4. Process according to one or more of Claims 1 to 3, **characterized in that** at least one of the bidentate ligands is selected from the structures of the formulae (L-1-1), (L-1-2) and (L-2-1) to (L-2-4): 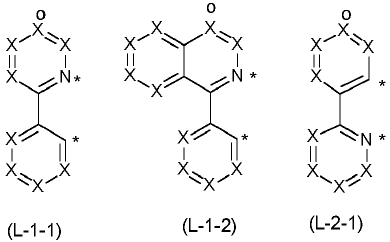 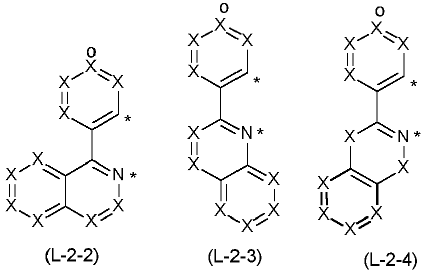 where * represents the position of coordination to the metal and the further symbols used are:
X is the same or different at each instance and is CR or N, with the proviso that not more than one X symbol per cycle is N, where X is C if the ligand at this position is bonded to a bridge;
R has the definitions given in Claim 1;
where the ligands may optionally be bonded by a bridge, where the bond to the bridge may preferably be via the position marked "o";
and/or **in that** at least one of the bidentate ligands is selected from the structures of the formulae (L-3) to (L-30): 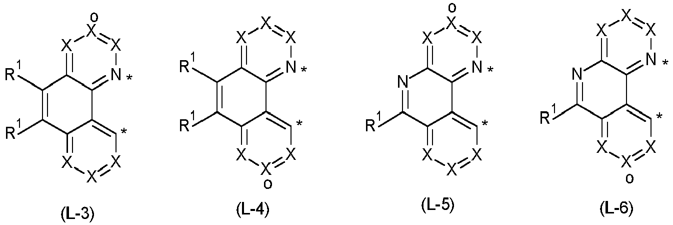 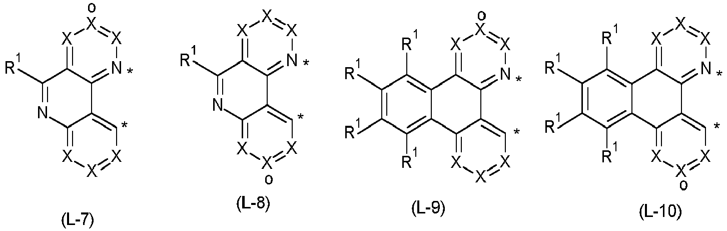 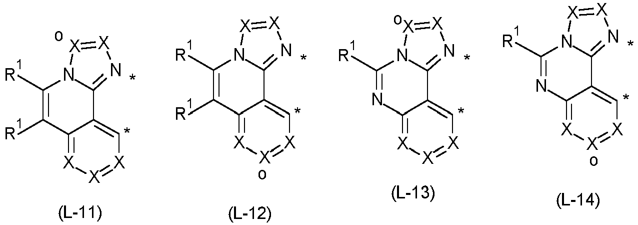 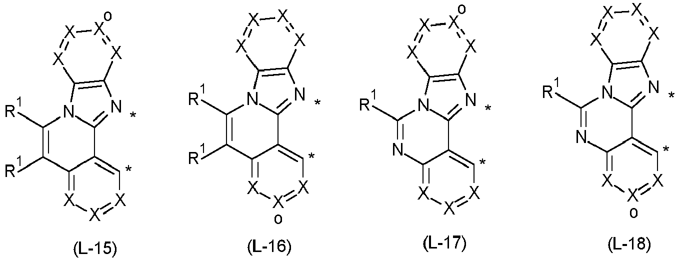 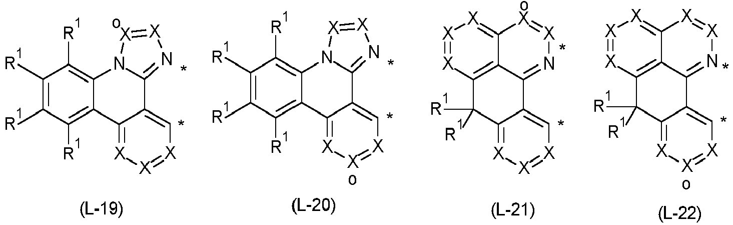 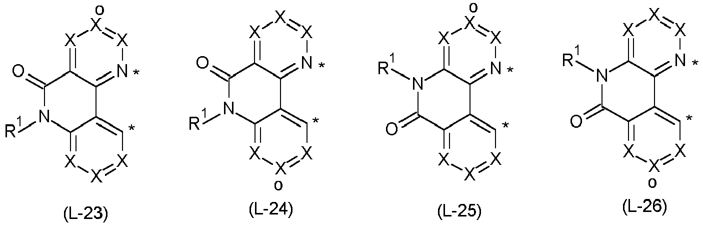 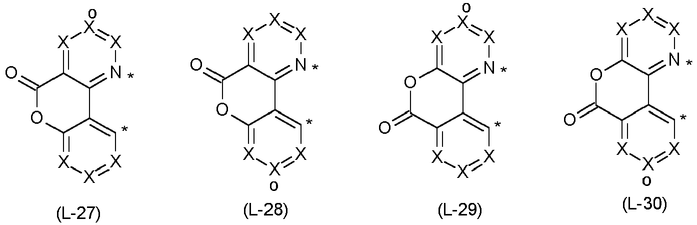 where * represents the position of coordination to the metal and the further symbols used are:
X is the same or different at each instance and is CR or N, with the proviso that not more than one X symbol per cycle is N, where X is C if the ligand at this position is bonded to a bridge;
R, R¹ has the definitions given in Claim 1;
where the ligands may optionally be bonded by a bridge, where the bond to the bridge may preferably be via the position marked "o";
and/or **in that** at least one of the bidentate ligands is selected from the structures of the following formulae (L-31) and (L-32): 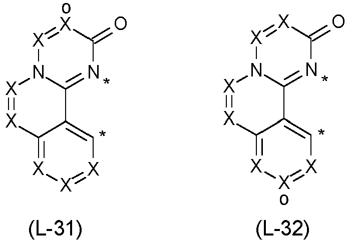 where * represents the position of coordination to the metal and the further symbols used are:
X is the same or different at each instance and is CR or N, with the proviso that not more than one X symbol per cycle is N, where X is C if the ligand at this position is bonded to a bridge;
R has the definitions given in Claim 1;
where the ligands may optionally be bonded by a bridge, where the bond to the bridge may preferably be via the position marked "o";
and/or **in that** at least one of the bidentate ligands is selected from the structures of the following formulae (L-39) to (L-42): 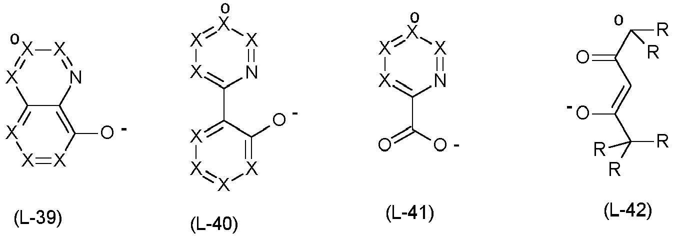 where the ligands (L-39) to (L-41) each coordinate to the metal via the nitrogen atom shown explicitly and the negatively charged oxygen atom and the sub-ligand (L-42) via the two oxygen atoms, X is the same or different at each instance and is CR or N, with the proviso that not more than one symbol X per cycle is N, where X is C if the ligand is bonded to a bridge at this position, and R has the definitions given in Claim 1, where the ligands may optionally be bonded by a bridge, where the bond to the bridge may preferably be via the position marked "o", where X is C if the ligand is bonded to a bridge at this position, or, in formula (L-42), the carbon atom may have a substituent R if the ligand is not bonded to a bridge at this position.

5. Process according to one or more of Claims 1 to 4, **characterized in that** the metal complex has at least one ligand having two substituents R and/or two substituents R¹ which are bonded to adjacent carbon atoms and together form a ring according to one of formulae (RI-1) to (RI-8): 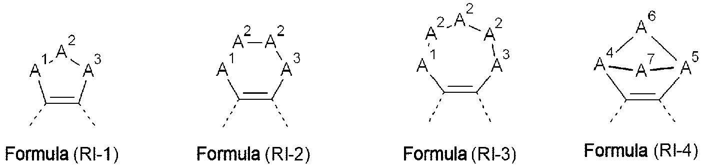 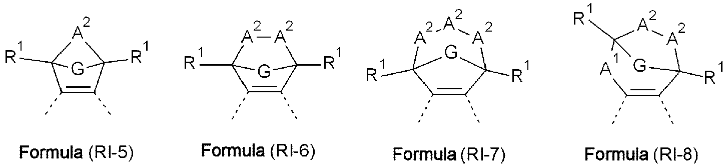 where R and R¹ have the definitions given in Claim 1, the dotted bonds indicate the linkage of the two carbon atoms in the ligand and in addition:
A¹, A³ is the same or different at each instance and is C(R³)₂, O, S, NR³ or C(=O);
A² is C(R¹)₂, O, S, NR³ or C(=O);
A⁴, A⁵ is the same or different at each instance and is CR¹ or N;
A⁶, A⁷ is the same or different at each instance and is an alkylene group having 2 or 3 carbon atoms, in which one carbon atom may be replaced by oxygen and which may be substituted by one or more R¹ radicals;
with the proviso that, in A⁴-A⁶-A⁵ or A⁴-A⁷-A⁵, no two heteroatoms are bonded directly to one another,
G is an alkylene group which has 1, 2 or 3 carbon atoms and may be substituted by one or more R² radicals, -CR²=CR²- or an ortho-bonded arylene or heteroarylene group which has 5 to 14 aromatic ring atoms and may be substituted by one or more R² radicals;
R³ is the same or different at each instance and is H, F, a straight-chain alkyl or alkoxy group having 1 to 10 carbon atoms, a branched or cyclic alkyl or alkoxy group having 3 to 10 carbon atoms, where the alkyl or alkoxy group may be substituted in each case by one or more R² radicals, where one or more nonadjacent CH₂ groups may be replaced by R²C=CR², C≡C, Si(R²)₂, C=O, NR², O, S or CONR², or an aromatic or heteroaromatic ring system which has 5 to 24 aromatic ring atoms and may be substituted in each case by one or more R² radicals, or an aryloxy or heteroaryloxy group which has 5 to 24 aromatic ring atoms and may be substituted by one or more R² radicals; at the same time, two R³ radicals bonded to the same carbon atom together may form an aliphatic or aromatic ring system and thus form a spiro system; in addition, R³ with an adjacent R or R¹ radical may form an aliphatic ring system;
where R² has the definition given in Claim 1;
with the proviso that no two heteroatoms in these groups are bonded directly to one another and no two C=O groups are bonded directly to one another.

6. Process according to one or more of Claims 1 to 5, **characterized in that** a mixture of reactive metal complexes is used whose reactive metal complexes conform to the general formula:
Ir(L)ₙ(L')ₘ Formula (1a)
where the symbols L, L', m and n have the definitions given in Claim 1 and the ligands L and/or L' are bonded via a bridge, optionally forming a substructure of the formula (2) according to Claim 2, such that a metal complex containing a hexadentate tripodal ligand is preferably formed and the ligands L and L' can be regarded as three bidentate sub-ligands that coordinate to the iridium.

7. Process according to Claim 6, **characterized in that** the bridge via which the ligands are bonded conforms to the formula (3) 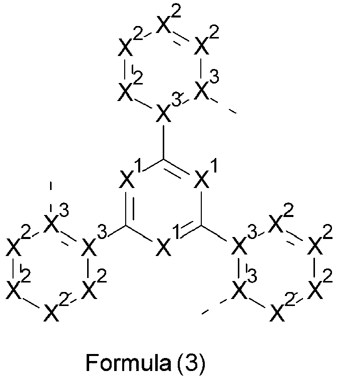 where the dotted bond represents the bond of the ligands, preferably of the bidentate ligands, to this structure and the symbols used are as follows:
X¹ is the same or different at each instance and is C which may also be substituted or N;
X² is the same or different at each instance and is C which may also be substituted or N, or two adjacent X² groups together are N which may also be substituted, O or S, so as to form a five-membered ring; or two adjacent X² groups together are C which may also be substituted or N when one of the X³ groups in the cycle is N, so as to form a five-membered ring; with the proviso that not more than two adjacent X² groups in each ring are N; at the same time, any substituents present may also form a ring system with one another or with substituents bonded to X¹;
X³ is C at each instance in one cycle or one X³ group is N and the other X³ group in the same cycle is C, where the X³ groups in the three cycles may be selected independently; with the proviso that two adjacent X² groups together are C which may also be substituted or N when one of the X³ groups in the cycle is N;
or **in that** the bridge via which the ligands are bonded conforms to the formula (4) 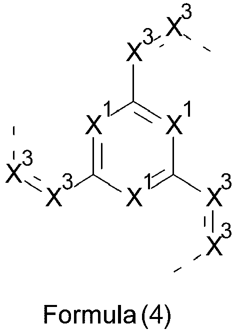 where the dotted bond represents the bond of the ligands, preferably of the bidentate ligands, to this structure and the symbols used are as follows:
X¹ is the same or different at each instance and is C which may also be substituted or N;
X³ is the same or different at each instance and is CR or N, with the proviso that no two nitrogen atoms are bonded directly to one another, where R has the definitions given above;
or **in that** the bridge via which the ligands are bonded conforms to the formula (5) 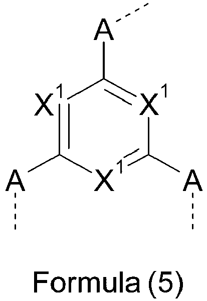 where the dotted bond represents the bond of the ligands to this structure and the symbols used are as follows:
X¹ is the same or different at each instance and is C which may also be substituted or N;
A is the same or different at each instance and is selected from the group consisting of -O-C(=O)-, -NR-C(=O)- or -CR₂-CR₂-, where R has the definitions given above and the R radical bonded to the nitrogen atom is not H or D;
or **in that** the bridge via which the ligands are bonded conforms to the formula (6), (7) or (8): 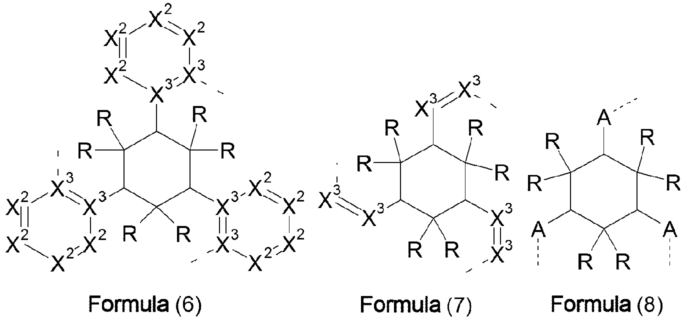 where the dotted bond represents the bond of the ligands to this structure and the symbols used in formula (6) have the definitions specified for formula (3) and the symbols in formula (7) have the definitions specified for formula (4) and the symbols in formula (8) have the definitions specified for formula (5);
at the same time, the three bidentate ligands, apart from by the bridge of the formula (3) to (8), may also be ring-closed by a further bridge to form a cryptate.

8. Process according to one or more of Claims 1 to 7, **characterized in that** the optically active boron compound is a compound of formula (BE-2) or (BE-3) 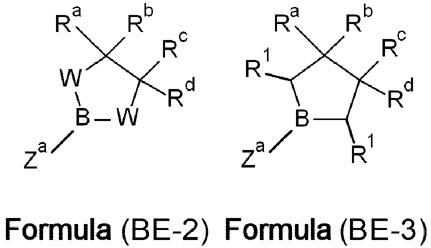 where Z^{a} has the definition given in Claim 1 and the further symbols are defined as follows:
W is the same or different at each instance and is NR, O or S, preferably NR or O and more preferably O;
R^{a}, R^{b}, R^{c}, R^{d} is the same or different at each instance and is H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, a straight-chain alkyl, alkoxy or thioalkoxy group having 1 to 20 carbon atoms or an alkenyl or alkynyl group having 2 to 20 carbon atoms or a branched or cyclic alkyl, alkoxy or thioalkoxy group having 3 to 20 carbon atoms, where each alkyl, alkoxy, thioalkoxy, alkenyl or alkynyl group may be substituted by one or more R¹ radicals, where one or more nonadjacent CH₂ groups may be replaced by R¹C=CR¹, C≡C, Si(R¹)2, C=O, NR¹, O, S or CONR¹, or an aromatic or heteroaromatic ring system which has 5 to 40 aromatic ring atoms and may be substituted in each case by one or more R¹ radicals, or an aryloxy or heteroaryloxy group which has 5 to 40 aromatic ring atoms and may be substituted by one or more R¹ radicals; at the same time, two R^{a}, R^{b}, R^{c} and/or R^{d} radicals together may also form a ring system;
R, R¹ have the definition given in Claim 1.

9. Metal complex of the general formula (1b)
Ir(L)ₙ(L')ₘ Formula (1b)
in which the symbols L and L' have the definition given in Claim 1 and at least one of the ligands L and/or L' comprises a boron-containing substituent having a chiral centre.

10. Metal complex according to Claim 9, **characterized in that** the boron-containing substituent having a chiral centre conforms to the formula (BS-1) 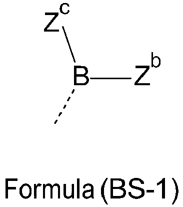 where the symbols Z^{b} and Z^{C} have the definition given in Claim 1 and the dotted line represents the bond to the ligand.

11. Oligomer, polymer or dendrimer containing one or more metal complexes according to one or more of Claims 9 and 10, wherein, rather than a hydrogen atom, one or more bonds of the metal complex to the polymer, oligomer or dendrimer are present.

12. Formulation comprising at least one metal complex according to one or more of Claims 9 and 10, or at least one oligomer, polymer or dendrimer according to Claim 11, and at least one solvent.

13. Use of a metal complex according to one or more of Claims 9 and 10 or of an oligomer, polymer or dendrimer according to Claim 11 for preparation of an optically active metal complex that preferably has at least one boron atom fewer than the metal complex used.

14. Process for preparing optically active transition metal complexes, **characterized in that** a composition obtained after step C) of a process according to Claims 1 to 8 is converted in a coupling reaction with elimination of boron compounds.

15. Electronic device comprising at least one metal complex according to one or more of Claims 9 and 10 or an oligomer, polymer or dendrimer according to Claim 11, wherein the electronic device is preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field quench devices, light-emitting electrochemical cells, oxygen sensors, oxygen sensitizers and organic laser diodes.

## Revendications

1. Procédé pour la séparation de mélanges qui contiennent des énantiomères de complexes métalliques pourvus de ligands aromatiques et/ou hétéroaromatiques, comprenant les étapes de :
A) mise à disposition d'un mélange de complexes métalliques réactifs, le mélange comprenant au moins deux énantiomères des complexes métalliques réactifs ;
B) transformation du mélange mis à disposition selon l'étape A) avec un composé boré optiquement actif avec obtention d'un mélange de diastéréoisomères, le composé boré optiquement actif étant un composé boré selon la formule (BE-1), 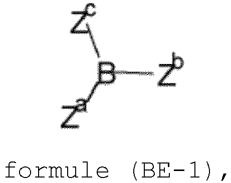 les symboles présentant la signification suivante
Z^{a} étant choisi parmi H, D, OR, halogène, B(R)₂ ;
Z^{b}, Z^{c}, identiques ou différents en chaque occurrence, étant un groupe alkyle, alcoxy ou thioalcoxy linéaire comportant 1 à 40 atomes de C ou un groupe alcényle ou alcynyle comportant 2 à 40 atomes de C ou un groupe alkyle, alcoxy ou thioalcoxy ramifié ou cyclique comportant 3 à 40 atomes de C, le groupe alkyle, alcoxy, thioalcoxy, alcényle ou alcynyle pouvant être à chaque fois substitué par un ou plusieurs radicaux R et cyclopropyle, cyclobutyle, cyclopentyle, cyclohexyle, cycloheptyle, cyclooctyle, 1-bicyclo[2.2.2]octyle, 2-bicyclo[2.2.2]octyle, adamantyle, 1-(n-propyl)-cyclohex-1-yle-, 1-(n-butyl)-cyclohex-1-yle-, 1-(n-hexyl)-cyclohex-1-yle-, 1-(n-octyl)-cyclohex-1-yle-et 1-(n-décyl)-cyclohex-1-yle- étant considérés comme groupes alkyle et cyclopentényle, cyclohexényle, cycloheptényle, cyclooctényle et cyclooctadiényle étant considérés comme groupes alcényle et un ou plusieurs groupes CH₂ non voisins pouvant être remplacés par RC=CR, C=C, Si(R)₂, C=O, NR, O, S ou CONR, à cet égard, les radicaux R pouvant également former un système cyclique l'un avec l'autre ;
au moins l'un des radicaux Z^{b}, Z^{c} comprenant un centre de chiralité ;
R, identique ou différent en chaque occurrence, étant H, D, F, Cl, Br, I, N(R¹)₂, CN, NO₂, OH, COOH, C(=O)N(R¹)₂, Si(R¹)₃, B(OR¹)₂, C(=O)R¹, C(=O)OR¹, P(=O)(R¹)₂, S(=O)R¹, S(=O)₂R¹, OSO₂R¹, un groupe alkyle, alcoxy ou thioalcoxy linéaire comportant 1 à 20 atomes de C ou un groupe alcényle ou alcynyle comportant 2 à 20 atomes de C ou un groupe alkyle, alcoxy ou thioalcoxy ramifié ou cyclique comportant 3 à 20 atomes de C, le groupe alkyle, alcoxy, thioalcoxy, alcényle ou alcynyle pouvant à chaque fois être substitué par un ou plusieurs radicaux R¹, un ou plusieurs groupes CH₂ non voisins pouvant être remplacés par R¹C=CR¹, C≡C, Si(R¹)₂, C=O, NR¹, O, S ou CONR¹, ou un système cyclique aromatique ou hétéroaromatique comportant 5 à 40 atomes de cycle aromatique, un système cyclique aromatique contenant 6 à 40 atomes de C dans le système cyclique et un système cyclique hétéroaromatique contenant 1 à 40 atomes de C et au moins un hétéroatome dans le système cyclique, étant entendu que la somme des atomes de C et des hétéroatomes donne au moins 5 et le système cyclique aromatique ou hétéroaromatique pouvant à chaque fois être substitué par un ou plusieurs radicaux R¹, ou un groupe aryloxy ou hétéroaryloxy comportant 5 à 40 atomes de cycle aromatique, qui peut être substitué par un ou plusieurs radicaux R¹ ; à cet égard, deux radicaux R pouvant également former un système cyclique l'un avec l'autre ;
R¹, identique ou différent en chaque occurrence, étant H, D, F, Cl, Br, I, N(R²)₂, CN, NO₂, Si(R²)₃, B(OR²)₂, C(=O)R², C(=O)OR², P(=O)(R²)₂, S(=O)R², S(=O)₂R², OSO₂R², un groupe alkyle, alcoxy ou thioalcoxy linéaire comportant 1 à 20 atomes de C ou un groupe alcényle ou alcynyle comportant 2 à 20 atomes de C ou un groupe alkyle, alcoxy ou thioalcoxy ramifié ou cyclique comportant 3 à 20 atomes de C, le groupe alkyle, alcoxy, thioalcoxy, alcényle ou alcynyle pouvant à chaque fois être substitué par un ou plusieurs radicaux R², un ou plusieurs groupes CH₂ non voisins pouvant être remplacés par R²C=CR², C=C, Si(R²)₂, C=O, NR², O, S ou CONR², ou un système cyclique aromatique ou hétéroaromatique comportant 5 à 40 atomes de cycle aromatique, qui peut être substitué à chaque fois par un ou plusieurs radicaux R², ou un groupe aryloxy ou hétéroaryloxy comportant 5 à 40 atomes de cycle aromatique, qui peut être substitué par un ou plusieurs radicaux R², ou un groupe aralkyle ou hétéroaralkyle comportant 5 à 40 atomes de cycle aromatique, qui peut être substitué par un plusieurs radicaux R², ou un groupe diarylamino, un groupe dihétéroarylamino ou un groupe arylhétéroarylamino comportant 10 à 40 atomes de cycle aromatique, qui peut être substitué par un ou plusieurs radicaux R² ; à cet égard, deux radicaux R¹ ou plus pouvant former un système cyclique l'un avec l'autre ;
R², identique ou différent en chaque occurrence, étant H, D, F ou un radical organique aliphatique, aromatique et/ou hétéroaromatique, en particulier un radical hydrocarboné, comportant 1 à 20 atomes de C, dans lequel également un ou plusieurs atomes de H peuvent être remplacés par F, à cet égard deux substituants R² ou plus pouvant également former l'un avec l'autre un système cyclique monocyclique ou polycyclique ;
et
C) séparation du mélange de diastéréoisomères obtenu selon l'étape B) ;
un mélange de complexes métalliques étant utilisé, dont les complexes métalliques réactifs correspondent à la formule générale (1), et les complexes métalliques contenant un groupe fonctionnel qui est choisi dans le groupe constitué par les halogènes, le triflate, le mésylate et le tosylate :
Ir(L)ₙ(L')ₘ formule (1),
ce qui suit s'appliquant pour les symboles et indices utilisés :
L, identique ou différent en chaque occurrence, étant un ligand bidentate
L', identique ou différent en chaque occurrence, étant un ligand ;
n étant 1, 2 ou 3, de préférence 2 ou 3, particulièrement préférablement 3 ;
m étant 0, 1, 2, 3 ou 4, de préférence 0, 1 ou 2, particulièrement préférablement 0 ;
à cet égard, plusieurs ligands L ensemble, ou L et L', pouvant être également reliés par l'intermédiaire d'une simple liaison ou d'un pont divalent ou trivalent et ainsi définir un système de ligands tridentate, tétradentate, pentadentate ou hexadentate.

2. Procédé selon la revendication 1, **caractérisé en ce que** les complexes métalliques réactifs de formule générale (1) contiennent une structure partielle M(L)ₙ de formule (2) : 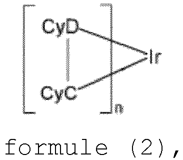 R présentant les significations mentionnées dans la revendication 1 et ce qui suit s'appliquant aux symboles et indices utilisés :
CyC, identique ou différent en chaque occurrence, étant un groupe aryle ou hétéroaryle comportant 5 à 18 atomes de cycle aromatique ou un groupe fluorène ou azafluorène, qui coordine à chaque fois à Ir par l'intermédiaire d'un atome de carbone et qui peut être substitué à chaque fois par un ou plusieurs radicaux R et qui est relié à CyD à chaque fois par l'intermédiaire d'une liaison covalente ;
CyD, identique ou différent en chaque occurrence, étant un groupe hétéroaryle comportant 5 à 18 atomes de cycle aromatique, qui coordine à Ir par l'intermédiaire d'un atome d'azote neutre ou par l'intermédiaire d'un atome de carbone de carbène et qui peut être substitué par un ou plusieurs radicaux R et qui est relié à CyC par l'intermédiaire d'une liaison covalente ;
n étant 1, 2 ou 3, de préférence 2 ou 3, particulièrement préférablement 3 ;
à cet égard, plusieurs ligands L pouvant être également reliés ensemble par l'intermédiaire d'une simple liaison ou d'un pont divalent ou trivalent et ainsi définir un système de ligands tridentate, tétradentate, pentadentate ou hexadentate ;
à cet égard, un substituant pouvant également coordiner en plus à Ir.

3. Procédé selon la revendication 1 ou 2, **caractérisé en ce que** le complexe métallique présente un, deux ou trois ligands bidentates, les ligands bidentates, identiques ou différents en chaque occurrence, présentant un atome de carbone et un atome d'azote ou deux atomes de carbone ou deux atomes d'azote ou deux atomes d'oxygène ou un atome d'oxygène et un atome d'azote, en tant qu'atomes coordinants.

4. Procédé selon l'une ou plusieurs des revendications 1 à 3, **caractérisé en ce qu'**au moins l'un des ligands bidentates est choisi parmi les structures des formules (L-1-1), (L-1-2) et (L-2-1) à (L-2-4), 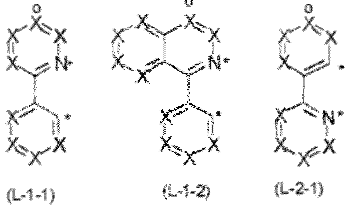 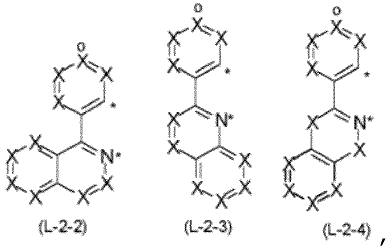 la position * indiquant la coordination au métal et ce qui suit s'appliquant aux symboles utilisés :
X, identique ou différent en chaque occurrence, étant CR ou N, étant entendu qu'au maximum un symbole X par cycle représente N, X étant C si le ligand est relié à un pont au niveau de cette position ;
R présentant les significations mentionnées dans la revendication 1 ;
les ligands pouvant éventuellement être reliés par un pont, la liaison au pont pouvant être réalisée préférablement par la position marquée par « o » ; et/ou **en ce qu'**au moins l'un des ligands bidentates est choisi parmi les structures des formules (L-3) à (L-30), 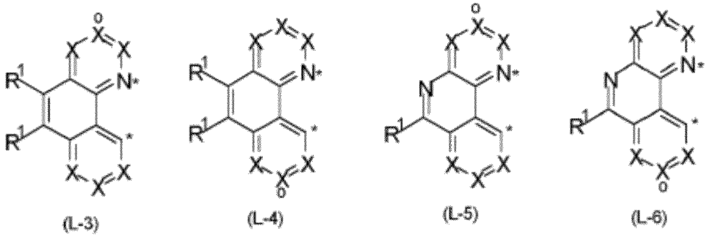 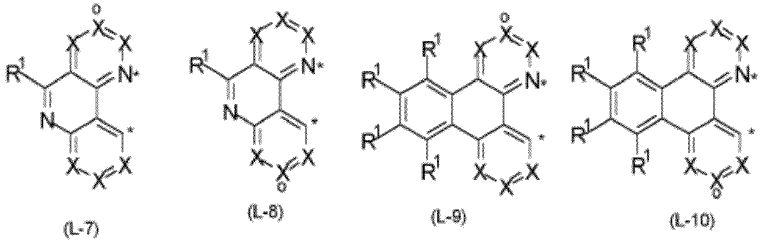 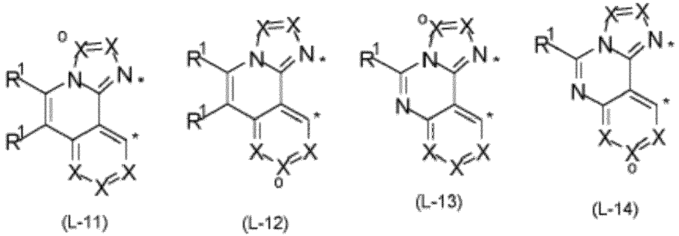 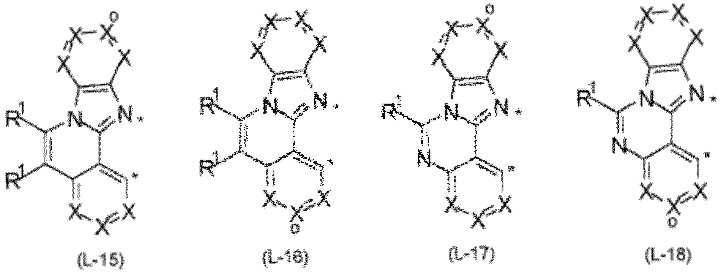 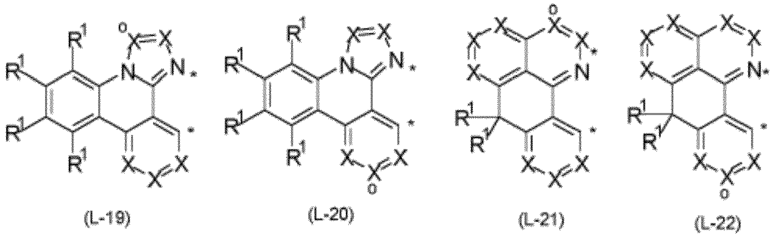 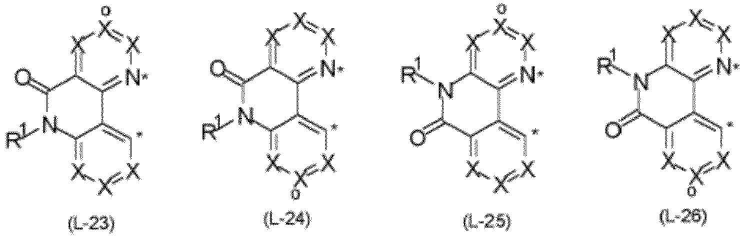 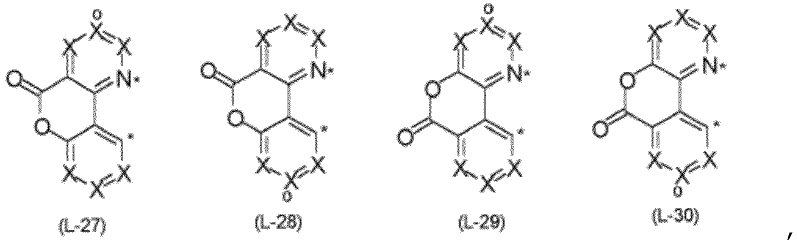 la position * indiquant la coordination au métal et ce qui suit s'appliquant aux symboles utilisés :
X, identique ou différent en chaque occurrence, étant CR ou N, étant entendu qu'au maximum un symbole X par cycle représente N, X étant C si le ligand est relié à un pont au niveau de cette position ;
R, R¹ présentant les significations mentionnées dans la revendication 1 ;
les ligands pouvant éventuellement être reliés par un pont, la liaison au pont pouvant être réalisée préférablement par la position marquée par « o » ; et/ou **en ce qu'**au moins l'un des ligands bidentates est choisi parmi les structures des formules (L-31) et (L-32), 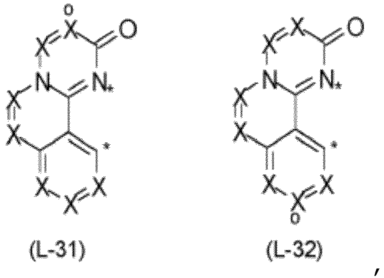 la position * indiquant la coordination au métal et ce qui suit s'appliquant aux symboles utilisés :
X, identique ou différent en chaque occurrence, étant CR ou N, étant entendu qu'au maximum un symbole X par cycle représente N, X étant C si le ligand est relié à un pont au niveau de cette position ;
R présentant les significations mentionnées dans la revendication 1 ;
les ligands pouvant éventuellement être reliés par un pont, la liaison au pont pouvant être réalisée préférablement par la position marquée par « o » ; et/ou **en ce qu'**au moins l'un des ligands bidentates est choisi parmi les structures des formules (L-39) à (L-42), 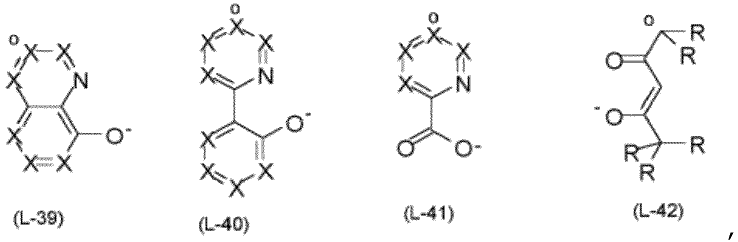 les ligands (L-39) à (L-41) coordinant au métal à chaque fois par l'intermédiaire de l'atome d'azote explicitement dessiné et de l'atome d'oxygène chargé négativement et le ligand partiel (L-42) coordinant au métal par l'intermédiaire des deux atomes d'oxygène, X, identique ou différent en chaque occurrence, étant CR ou N, étant entendu qu'au maximum un symbole X par cycle représente N, X étant C si le ligand est relié à un pont au niveau de cette position et R présentant les significations mentionnées dans la revendication 1, les ligands pouvant éventuellement être reliés par un pont, la liaison au pont pouvant être réalisée préférablement par la position marquée par « o », X étant C si le ligand est relié à un pont au niveau de cette position ou, dans la formule (L-42), l'atome de carbone pouvant présenter un substituant R si le ligand n'est pas relié à un pont au niveau de cette position.

5. Procédé selon l'une ou plusieurs des revendications 1 à 4, **caractérisé en ce que** le complexe métallique présente au moins un ligand pourvu de deux substituants R et/ou deux substituants R¹, qui sont liés à des atomes de carbone adjacents et qui forment l'un avec l'autre un cycle selon l'une des formules (RI-1) à (RI-8), 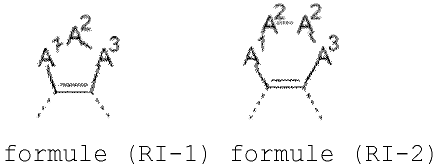 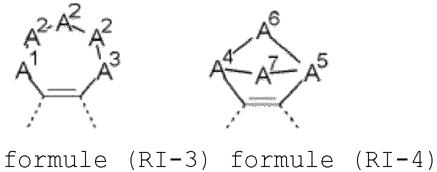 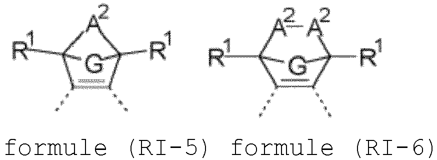 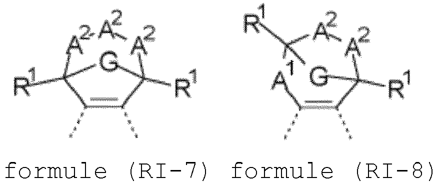 R et R¹ présentant les significations mentionnées dans la revendication 1, les liaisons en pointillés indiquant la liaison des deux atomes de carbone dans le ligand et en outre :
A¹, A³, identiques ou différents en chaque occurrence, étant C(R³)₂, O, S, NR³ ou C(=O);
A² étant C(R¹)₂, O, S, NR³ ou C(=O) ;
A⁴, A⁵, identiques ou différents en chaque occurrence, étant CR¹ ou N ;
A⁶, A⁷, identiques ou différents en chaque occurrence, étant un groupe alkylène comportant 2 ou 3 atomes de C, dans lequel un atome de carbone peut-être remplacé par oxygène et qui peut être substitué par un ou plusieurs radicaux R¹ ;
étant entendu que dans A⁴-A⁶-A⁵, respectivement A⁴-A⁷-A⁵, deux hétéroatomes ne sont pas liés directement l'un à l'autre
G étant un groupe alkylène comportant 1, 2 ou 3 atomes de C, qui peut être substitué par un ou plusieurs radicaux R², -CR²=CR²- ou un groupe arylène ou hétéroarylène, relié en ortho, comportant 5 à 14 atomes de cycle aromatique, qui peut être substitué par un ou plusieurs radicaux R² ;
R³, identique ou différent en chaque occurrence, étant H, F, un groupe alkyle ou alcoxy linéaire comportant 1 à 10 atomes de C, un groupe alkyle ou alcoxy ramifié ou cyclique comportant 3 à 10 atomes de C, le groupe alkyle ou alcoxy pouvant à chaque fois être substitué par un ou plusieurs radicaux R², un ou plusieurs groupes CH₂ non voisins pouvant être remplacés par R²C=CR², C≡C, Si(R²)₂, C=O, NR², O, S ou CONR², ou un système cyclique aromatique ou hétéroaromatique comportant 5 à 24 atomes de cycle aromatique, qui peut être substitué par un ou plusieurs radicaux R², ou un groupe aryloxy ou hétéroaryloxy comportant 5 à 24 atomes de cycle aromatique, qui peut être substitué par un ou plusieurs radicaux R² ; à cet égard, deux radicaux R³, qui sont liés au même atome de carbone, pouvant former l'un avec l'autre un système cyclique aliphatique ou aromatique et ainsi définir un système spiro ; R³ pouvant en outre former un système cyclique aliphatique avec un radical adjacent R ou R¹ ;
R² présentant la signification mentionnée dans la revendication 1 ;
étant entendu que dans ces groupes, deux hétéroatomes ne sont pas liés directement l'un à l'autre et deux groupes C=O ne sont pas directement liés l'un à l'autre.

6. Procédé selon l'une ou plusieurs des revendications 1 à 5, **caractérisé en ce qu'**un mélange de complexes métalliques réactifs est utilisé, dont les complexes métalliques réactifs correspondent à la formule générale
Ir(L)ₙ(L')ₘ formule (1a),
les symboles L, L', m et n présentant les significations mentionnées dans la revendication 1 et les ligands L et/ou L' étant reliés par l'intermédiaire d'un pont, une structure partielle de formule (2) selon la revendication 2 étant éventuellement formée, de sorte que de préférence un complexe métallique contenant un ligand tripode hexadentate est formé et les ligands L et L' peuvent être vus comme trois ligands partiels bidentates, qui coordinent à l'iridium.

7. Procédé selon la revendication 6, **caractérisé en ce que** le pont par l'intermédiaire duquel les ligands sont reliés correspond à la formule (3), 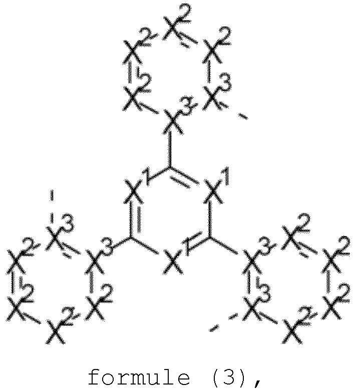 la liaison en pointillés indiquant la liaison des ligands, de préférence des ligands bidentates à cette structure et ce qui suit s'appliquant aux symboles utilisés :
X¹, identique ou différent en chaque occurrence, étant C, qui peut également être substitué, ou N ;
X², identique ou différent en chaque occurrence, étant C, qui peut également être substitué, ou N ou deux groupes X² adjacents représentant ensemble N, qui peut également être substitué, O ou S, de sorte qu'un cycle à cinq chaînons est formé ; ou deux groupes X² adjacents représentant ensemble C, qui peut également être substitué, ou N, lorsqu'un des groupes X³ dans le cycle représente N, de sorte qu'un cycle à cinq chaînons est formé ; étant entendu qu'au maximum deux groupes X² adjacents dans chaque cycle représentent N ; à cet égard, des substituants éventuellement présents pouvant également former l'un avec l'autre, ou avec des substituants qui sont liés à X¹, un système cyclique ;
X³ étant, en chaque occurrence dans un cycle, C ou un groupe X³ représentant N et l'autre groupe X³ dans le même cycle représentant C, les groupes X³ dans les trois cycles pouvant être choisis indépendamment les uns des autres ; étant entendu que deux groupes X² représentent ensemble C, qui peut également être substitué, ou N, lorsque dans le cycle l'un des groupes X³ représente N ;
ou **en ce que** le pont par l'intermédiaire duquel les ligands sont reliés correspond à la formule (4), 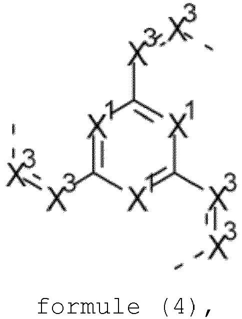 la liaison en pointillés indiquant la liaison des ligands, de préférence des ligands bidentates à cette structure et ce qui suit s'appliquant aux symboles utilisés :
X¹, identique ou différent en chaque occurrence, étant C, qui peut également être substitué, ou N ;
X³, identique ou différent en chaque occurrence, étant CR ou N, étant entendu que deux atomes d'azote ne sont pas directement liés l'un à l'autre, R présentant les significations mentionnées ci-dessus ;
ou **en ce que** le pont par l'intermédiaire duquel les ligands sont reliés correspond à la formule (5), 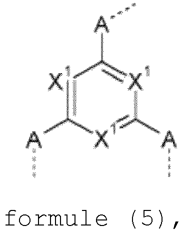 la liaison en pointillés indiquant la liaison des ligands à cette structure et ce qui suit s'appliquant aux symboles utilisés :
X¹, identique ou différent en chaque occurrence, étant C, qui peut également être substitué, ou N ;
A, identique ou différent en chaque occurrence, étant choisi dans le groupe constitué par -O-C(=O)-, -NR-C(=O)- et -CR₂-CR₂-, R présentant les significations mentionnées ci-dessus et le radical R qui est lié à l'atome d'azote n'étant ni H ni D;
ou **en ce que** le pont par l'intermédiaire duquel les ligands sont reliés correspond à la formule (6), (7) ou (8), 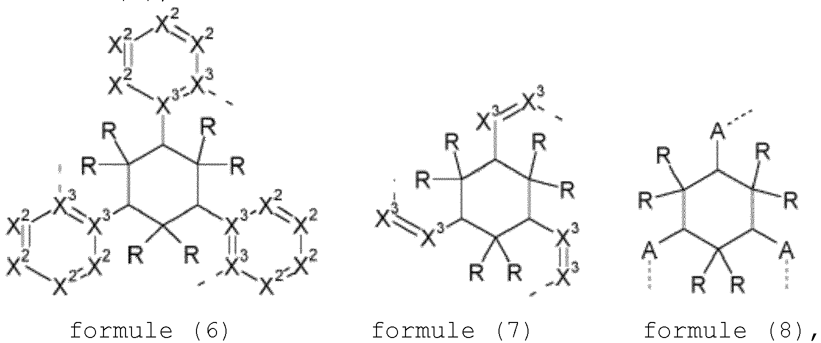 la liaison en pointillés indiquant la liaison des ligands à cette structure et les symboles utilisés dans la formule (6) possédant les significations mentionnées pour la formule (3) et les symboles dans la formule (7) possédant les significations mentionnées pour la formule (4) et les symboles dans la formule (8) possédant les significations mentionnées pour la formule (5) ;
à cet égard, les trois ligands bidentates pouvant également être fermés, outre que par les ponts des formules (3) à (8), par un pont supplémentaire pour donner un cryptate.

8. Procédé selon l'une ou plusieurs des revendications 1 à 7, **caractérisé en ce que** le composé boré optiquement actif est un composé selon la formule (BE-2) ou (BE-3), 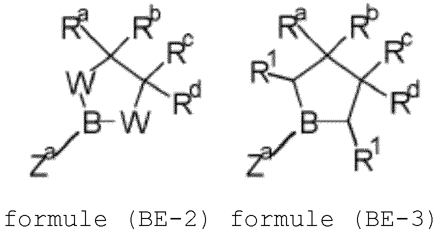 Z^{a} présentant la signification mentionnée dans la revendication 1 et les autres symboles présentant la signification suivante :
W, identique ou différent en chaque occurrence, étant NR, O ou S, de préférence NR ou O et particulièrement préférablement O ;
R^{a}, R^{b}, R^{c}, R^{d}, identiques ou différents en chaque occurrence, étant H, D, F, Cl, Br, I, N(R¹)₂, CN, NO₂, OH, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, un groupe alkyle, alcoxy ou thioalcoxy linéaire comportant 1 à 20 atomes de C ou un groupe alcényle ou alcynyle comportant 2 à 20 atomes de C ou un groupe alkyle, alcoxy ou thioalcoxy ramifié ou cyclique comportant 3 à 20 atomes de C, le groupe alkyle, alcoxy, thioalcoxy, alcényle ou alcynyle pouvant à chaque fois être substitué par un ou plusieurs radicaux R¹, un ou plusieurs groupes CH₂ non voisins pouvant être remplacés par R¹C=CR¹, C≡C, Si(R¹)₂, C=O, NR¹, O, S ou CONR¹, ou un système cyclique aromatique ou hétéroaromatique comportant 5 à 40 atomes de cycle aromatique, qui peut à chaque fois être substitué par un ou plusieurs radicaux R¹, ou un groupe aryloxy ou hétéroaryloxy comportant 5 à 40 atomes de cycle aromatique, qui peut être substitué par un ou plusieurs radicaux R¹ ; à cet égard, deux radicaux R^{a}, R^{b}, R^{c} et/ou R^{d} pouvant également former un système cyclique l'un avec l'autre ;
R, R' présentant la signification mentionnée dans la revendication 1.

9. Complexe métallique selon la formule générale (1b),
Ir(L)ₙ(L')ₘ formule (1b)
dans laquelle les symboles L et L' possèdent la signification mentionnée dans la revendication 1 et au moins l'un des ligands L et/ou L' comprend un substituant contenant du bore comportant un centre de chiralité.

10. Complexe métallique selon la revendication 9, **caractérisé en ce que** le substituant contenant du bore comportant un centre de chiralité correspond à la formule (BS-1), 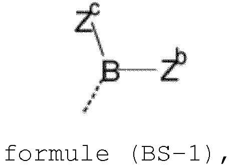 les symboles Z^{b} et Z^{C} présentant la signification mentionnée dans la revendication 1 et la ligne en pointillés indiquant la liaison au ligand.

11. Oligomère, polymère ou dendrimère contenant un ou plusieurs complexes métalliques selon la revendication 9 ou 10, dans lequel à la place d'un atome d'hydrogène, une ou plusieurs liaisons du complexe métallique au polymère, à l'oligomère ou au dendrimère sont présentes.

12. Formulation, contenant au moins un complexe métallique selon la revendication 9 ou 10 ou au moins un oligomère, un polymère ou un dendrimère selon la revendication 11 et au moins un solvant.

13. Utilisation d'un complexe métallique selon la revendication 9 ou 10 ou d'un oligomère, d'un polymère ou d'un dendrimère selon la revendication 11 pour la préparation d'un complexe métallique optiquement actif, qui présente au moins un atome de bore en moins que le complexe métallique utilisé.

14. Procédé pour la préparation de complexes de transition optiquement actifs, **caractérisé en ce qu'**une composition obtenue selon l'étape C) d'un procédé selon les revendications 1 à 8 est transformée dans une réaction de couplage avec scission de composés borés.

15. Dispositif électronique contenant au moins un complexe métallique selon la revendication 9 ou 10 ou un oligomère, un polymère ou un dendrimère selon la revendication 11, le dispositif électronique étant préférablement choisi dans le groupe constitué par des dispositifs organiques électroluminescents, des circuits intégrés organiques, des transistors organiques à effet de champ, des transistors organiques en film mince, des transistors luminescents organiques, des cellules solaires organiques, des détecteurs optiques organiques, des photorécepteurs organiques, des dispositifs organiques d'extinction de champ, des cellules électrochimiques luminescentes, des capteurs d'oxygène, des sensibilisateurs d'oxygène et des diodes laser organiques.
